# EUROPEAN PATENT APPLICATION

(11) **EP 2 426 730 A1**
(43) Date of publication of application: **07.03.2012**
(21) Application number: 10769786.4
(22) Date of filing: 28.04.2010
(51) Int. Cl.: H01L 31/042, B32B 27/00, C08L 71/12

(54) **SHEET FOR SOLAR CELL, AND SOLAR CELL MODULE**

(30) Priority: 30.04.2009 JP 2009111501; 24.07.2009 JP 2009173594; 24.07.2009 JP 2009173596; 15.12.2009 JP 2009284372
(71) Applicant: Mitsubishi Plastics, Inc., Tokyo 103-0021 (JP)
(72) Inventor: MIYASHITA, Yo, Nagahama-shi Shiga 526-8660 (JP); NISHIOKA, Jun, Nagahama-shi Shiga 526-8660 (JP); TANIGUCHI, Kouichirou, Nagahama-shi Shiga 526-8660 (JP); OKAWARA, Chiharu, Ushiku-shi Ibaraki 300-1201 (JP); YOSHIDA, Shigenobu, Ushiku-shi Ibaraki 300-1201 (JP); OTSUKA, Michiko, Nagahama-shi Shiga 526-8660 (JP); KITAYAMA, Kazuhiko, Nagahama-shi Shiga 526-8660 (JP)
(74) Representative: Gille Hrabal
(86) International application number: PCT/JP2010/057587
(87) International publication number: WO 2010/126088

(57) **Abstract**

Provided are a sheet f or a solar cell of a monolayer construction or a multilayer construction based on a polyphenylene ether-based resin layer formed of a resin composition using a polyphenylene ether as a main component, which has excellent durability, excellent flame retardancy, excellent dimensional stability and high adhesiveness with a encapsulating resin layer or the like, and a solar cell module obtained by providing the sheet for a solar cell.

## Description

### Technical Field

The present invention relates to a sheet for a solar cell (a laminated sheet for a solar cell is included in the category of the sheet) used for protecting a solar cell module and a solar cell module including the sheet.

### Background Art

While awareness has been raised about environmental problems such as global warming in recent years, high expectations have been placed particularly on photovoltaic power generation because of its cleanness and pollution-free property. A solar cell constructs the central portion of a photovoltaic power generating system that directly converts the energy of sunlight into electricity. The structure of the system is generally as described below. A plurality of solar cell elements (cells) are wired in series or tandem, and packaging for protecting the cells is performed in various ways so that the cells may be turned into a unit. The unit built in the package is called a solar cell module, and its construction isgenerallyasdescribedbelow. A surface on which sunlight impinges is covered with a transparent base material (glass/translucent solar cell sheet; front sheet), a gap is filled with a filler (encapsulating resin layer) formed of a thermoplastic resin (such as an ethylene-vinyl acetate copolymer), and the back surface is protected with a back surface-sealing sheet (back sheet).

Various characteristics are needed for the construction of such solar cell module, the structure of a material for the module, and the like because the module is mainly used outdoors. In addition, sufficient durability, sufficient flame retardancy, sufficient dimensional stability, a high mechanical strength, and the like are requested of the above-mentioned back sheet in consideration of the outdoor use. A reduction in environmental load has also been requested in terms of cleanness and pollution-free property. Another important requested characteristic is, for example, adhesiveness with the encapsulating resin layer or a junction box. In particular, the adhesiveness with the encapsulating resin layer is extremely important in order that a power-generating element in the encapsulating resin layer may be effectively protected.

Patent Literature 1 proposes, as the above-mentioned back sheet, a back sheet formed of a biaxially oriented polyester film having a specific IV value. Patent Literature 2 proposes a back sheet formed of a polyester film having a 2,6-naphthalene dicarboxylic acid component (which may hereinafter be referred to as "PEN film"). However, those films are not sufficient in terms of durability such as heat resistance or hydrolysis resistance, and flame retardancy for practical use. In addition, the adhesiveness of any such film with a encapsulating material resin is not necessarily sufficient.

In contrast to the foregoing, a back sheet formed of a cyclic olefin copolymer film (which may hereinafter be referred to as "COC film") has been proposed (see, for example, Patent Literatures 3 and 4). Patent Literature 5 proposes a back sheet formed of a laminate of a film formed of a polymethyl methacrylate and the COC film. In addition, Patent Literature 6 proposes a back sheet obtained by laminating polypropylene-based resin films. The hydrolysis resistance of any such back sheet has been improved, and an improvement in its adhesiveness with a encapsulating material can also be expected. However, the sheet involves such a problem that the sheet is poor in flame retardancy and durability (especially heat resistance).

In addition, the use of a fluorine-based resin excellent in weatherability and flame retardancy has been proposed (see, for example, Patent Literatures 7 and 8). However, the fluorine-based resin involves the following problem owing to poor sliding property of its surface. The resin is poor in sheet handleability (processability). Further, the fluorine-based resin involves the following problem owing to its low surface energy. The resin is poor in adhesiveness with an adjacent layer and in adhesiveness with the above-mentioned junction box or encapsulating material resin. Patent Literature 8 proposes a back sheet obtained by interposing a polyester film of a polyethylene terephthalate or the like between films each formed of the fluorine-based resin. However, the polyester film involves such a problem that the film is poor in hydrolysis resistance. Further, the films each formed of the fluorine-based resin are provided as outer layers. Accordingly, the above-mentioned problems peculiar to the fluorine-based resin cannot be solved.

Meanwhile, an ethylene-vinyl acetate copolymer compounded with an organic peroxide has been widely used as the above-mentioned encapsulating resin layer (see, for example, Patent Literature 9). It is absolutely necessary for the encapsulating resin layer to have flexibility in its service temperature range in order that a power-generating element may be protected from an impact or the like. As a result, when one carries the layer at normal temperature or attempts to subject the layer to a processing such as trimming, such a trouble as described below occurs. The layer elongates or sags. Accordingly, the layer involves such a drawback that the layer is poor in handleability. In view of the foregoing, the layer has been supplied in, for example, such a form as to have an increased thickness or to be integrated with a process film.

In contrast to the foregoing, such a construction that the encapsulating resin layer and an outer layer sheet (the back sheet or the front sheet) are laminated and integrated has been proposed (see, for example, Patent Literatures 10 to 12). The following can be expected from the construction. Handleability when the encapsulating resin layer is used alone is improved, and a step is shortened as compared with that in the case where each of the encapsulating resin layer and the outer layer sheet (the back sheet or the front sheet) is separately handled.

None of Patent Literatures 10 to 12 has any special description or suggestion for improving an adhesive strength between the encapsulating resin layer and the outer layer sheet. In addition, the adhesive strength is not sufficient, and hence a problem such as the occurrence of peeling arises.
Further, the outer layer sheet also involves the following problem. As in the foregoing, the sheet does not necessarily satisfy all of various characteristics such as durability such as heat resistance (dimensional stability) or hydrolysis resistance, flame retardancy, weatherability, sheet handleability (processability), and adhesiveness with the encapsulating resin layer or the junction box.

That is, the prior art has not provided a sheet for a solar cell excellent in durability, flame retardancy, dimensional stability, and gas barrier property against water vapor or the like, and having high adhesiveness with a encapsulating resin layer or the like, and a solar cell module including the sheet.
In addition, the prior art has not provided a laminated sheet for a solar cell excellent in handleability as a result of the lamination and integration of a encapsulating resin layer and an outer layer sheet excellent in durability, flame retardancy, and dimensional stability, and having high adhesiveness with the encapsulating resin layer, and a solar cell module including the laminated sheet.

### Citation List

### Patent Literature

[PTL 1] JP 2007-70430 A
[PTL 2] JP 2007-7885 A
[PTL 3] JP 2006-294780 A
[PTL 4] JP 2006-198922 A
[PTL 5] JP 08-306947 A
[PTL 6] JP 2003-243679 A
[PTL 7] JP 4177590 B
[PTL 8] US 5593532
[PTL 9] JP 58-60579 A
[PTL 10] JP 04-76230 A
[PTL 11] JP 2000-91611 A
[PTL 12] JP 2000-174298 A

### Summary of Invention

### Technical Problem

In view of the foregoing, a first object of the present invention is to provide a sheet for a solar cell excellent in durability, flame retardancy, and dimensional stability, and having high adhesiveness with a encapsulating resin layer or the like, and a solar cell module including the sheet.
In addition, a second object is to provide a sheet for a solar cell excellent in durability, flame retardancy, dimensional stability, and gas barrier property against water vapor or the like, and having high adhesiveness with a encapsulating resin layer or the like, and a solar cell module including the sheet.
Further, a third object is to provide a laminated sheet for a solar cell excellent in handleability as a result of the lamination and integration of a encapsulating resin layer and an outer layer sheet excellent in durability, flame retardancy, and dimensional stability, and having high adhesiveness with the encapsulating resin layer, and a solar cell module including the laminated sheet.

### Solution to Problem

The inventors of the present invention have made extensive studies in view of the above-mentioned problems. As a result, the inventors have completed the present invention described below, and solved the problems. That is, the present invention is as follows.
[1] A sheet for a solar cell of a monolayer construction, including a polyphenylene ether-based resin layer formed of a resin composition using a polyphenylene ether as a main component. (hereinafter referred to as the present invention 1)
[2] A sheet for a solar cell of a multilayer construction, including, as both outer layers, polyphenylene ether-based resin layers each formed of a resin composition using a polyphenylene ether as a main component. (hereinafter referred to as the present invention 2)
[3] A sheet for a solar cell, including at least one layer of each of the following layer (I) and the following layer (II):
   layer (I): a layer formed of a resin composition using a polyphenylene ether as a main component; and
   layer (II) : a gas barrier property layer having a water vapor permeability (measurement method: JIS K7129) of less than 10 g/m²·24 hr. (hereinafter referred to as the present invention 3)
[4] A sheet for a solar cell, including at least one layer of each of the following layer (I), the following layer (II), and the following layer (III):
   layer (I): a layer formed of a resin composition using a polyphenylene ether as a main component;
   layer (II) : a gas barrier property layer having a water vapor permeability (measurement method: JIS K7129) of less than 10 g/m²·24 hr; and
   layer (III): a light-blocking colored layer. (hereinafter referred to as the present invention 4)
[5] A laminated sheet for a solar cell obtained by laminating and integrating the following layer (IV) and the following layer (V), the following layer (V) showing a dimensional change ratio of 3% or less when heat-treated in a dry air stream at 150°C for 30 minutes:
   (IV) a encapsulating resin layer; and
   (V) a base material layer having, on a surface contacting the layer (IV), a polyphenylene ether-based resin layer formed of a resin composition using a polyphenylene ether as a main component. (hereinafter referred to as the present invention 5)
[6] The sheet for a solar cell according to the item [2], in which a thickness ratio of the polyphenylene ether-based resin layers with respect to an entire thickness exceeds 50%.
[7] The sheet for a solar cell according to the item [1] or [2], including a phosphorus-based flame retardant.
[8] A solar cell module obtained by providing the sheet for a solar cell according to the item [1] or [2].
[9] The solar cell module according to the item [8], in which the module is obtained by bonding one surface of the sheet for a solar cell to a encapsulating resin layer.
[10] The solar cell module according to the item [9], in which the encapsulating resin layer contains one of a polyolefin-based resin and an ethylene-vinyl acetate-based resin.
[11] The solar cell module according to the item [9], in which the encapsulating resin layer contains a radical generator.
[12] The solar cell module according to the item [8], in which the module is obtained by bonding a junction box to one surface of the sheet for a solar cell.
[13] The sheet for a solar cell according to the item [3], in which the layer (II) is selected from the following layers (a) to (e):
   (a) a metal thin-film layer;
   (b) an inorganic thin-film layer;
   (c) a resin layer using a resin selected from a cyclic olefin, a high-density polyethylene, a polypropylene, a polyvinylidene chloride, a polytetrafluoroethylene, and a polychlorotrifluoroethylene as a main component;
   (d) a resin layer containing flat inorganic particles; and
   (e) a coating layer using a resin selected from a polyvinylidene chloride, a polyvinyl alcohol, an acrylic resin, and an epoxy-based resin as a main component.
[14] A solar cell module obtained by providing the sheet for a solar cell according to the item [3].
[15] The solar cell module according to the item [3], in which the module is obtained by bonding the layer (I) to a encapsulating resin layer that constructs the solar cell module.
[16] The solar cell module according to the item [15], in which the encapsulating resin layer contains one of a polyolefin-based resin and an ethylene-vinyl acetate-based resin.
[17] The solar cell module according to the item [15], in which the encapsulating resin layer contains a radical generator.
[18] The solar cell module according to the item [14], in which the module is obtained by bonding a junction box to one surface of the sheet for a solar cell.
[19] The sheet for a solar cell according to the item [4], in which the layer (II) is selected from the following layers (a) to (e):
   (a) a metal thin-film layer;
   (b) an inorganic thin-film layer;
   (c) a resin layer using a resin selected from a cyclic olefin, a high-density polyethylene, a polypropylene, a polyvinylidene chloride, a polytetrafluoroethylene, and a polychlorotrifluoroethylene as a main component;
   (d) a resin layer containing flat inorganic particles; and
   (e) a coating layer using a resin selected fromapolyvinylidene chloride, a polyvinyl alcohol, an acrylic resin, and an epoxy-based resin as a main component.
[20] The sheet for a solar cell according to the item [4], in which the layer (III) is formed of a light-blocking white film or a light-blocking black film.
[21] The sheet for a solar cell according to the item [4], in which:
   the layer (II) includes a weatherproof coat layer and an inorganic thin-film layer; and
   the weatherproof coat layer is formed of at least one kind selected from (A) a crosslinked product of a polycaprolactone polyol and/or a polycarbonate polyol, (B) a crosslinked product of a denatured polyvinyl alcohol, and (C) an acrylic copolymer having at least one kind of group selected from the group consisting of a UV-stable group, a UV-absorbing group, and a cycloalkyl group.
[22] A solar cell module obtained by providing the sheet for a solar cell according to the item [4].
[23] The solar cell module according to the item [22], in which the module is obtained by bonding a junction box to one surface of the sheet for a solar cell.
[24] The laminated sheet for a solar cell according to the item [5], in which the layer (IV) includes a layer formed of a resin composition using a polyolefin-based resin or a denatured polyolefin-based resin as a main component.
[25] The laminated sheet for a solar cell according to the item [5], in which the laminated sheet is obtained by incorporating a radical generator or a silane coupling agent into the layer (IV).
[26] The laminated sheet for a solar cell according to the item [5], in which an interlayer peel strength between the layer (IV) and the layer (V) is 10 N/15 mm or more.
[27] The laminated sheet for a solar cell according to the item [5], in which the layer (V) shows a storage modulus (E') at a temperature of 20°C of 1,000 MPa or more when subjected to dynamic viscoelasticity measurement under conditions of an oscillation frequency of 10 Hz, a strain of 0.1%, and a rate of temperature increase of 3°C/min.
[28] The laminated sheet for a solar cell according to the item [5], in which the layer (V) includes a base material layer having the polyphenylene ether-based resin layer also on a surface opposite to the surface contacting the layer (IV).
[29] The laminated sheet for a solar cell according to the item [5], in which a ratio of a thickness of the polyphenylene ether-based resin layer in the layer (V) to an entire thickness of the layer (V) exceeds 50%.
[30] A solar cell module obtained by using the laminated sheet for a solar cell according to the item [5].
[31] The solar cell module according to the item [30], in which the module is obtained by bonding a junction box to a surface opposite to the surface in the layer (V) contacting the layer (IV) in the laminated sheet for a solar cell.

### Advantageous Effects of Invention

According to the present invention, there canbe provided a sheet for a solar cell excellent in durability, flame retardancy, and dimensional stability, and having high adhesiveness with a encapsulating resin layer or the like, and a solar cell module including the sheet.
In addition, there can be provided a sheet for a solar cell excellent in durability, flame retardancy, dimensional stability, and gas barrier property against water vapor or the like, and having high adhesiveness with a encapsulating resin layer or the like, and a solar cell module including the sheet.
Further, there can be provided a laminated sheet for a solar cell excellent in handleability as a result of the lamination and integration of a encapsulating resin layer and an outer layer sheet excellent in durability, flame retardancy, and dimensional stability, and having high adhesiveness with the encapsulating resin layer, and a solar cell module including the laminated sheet.

### Brief Description of Drawings

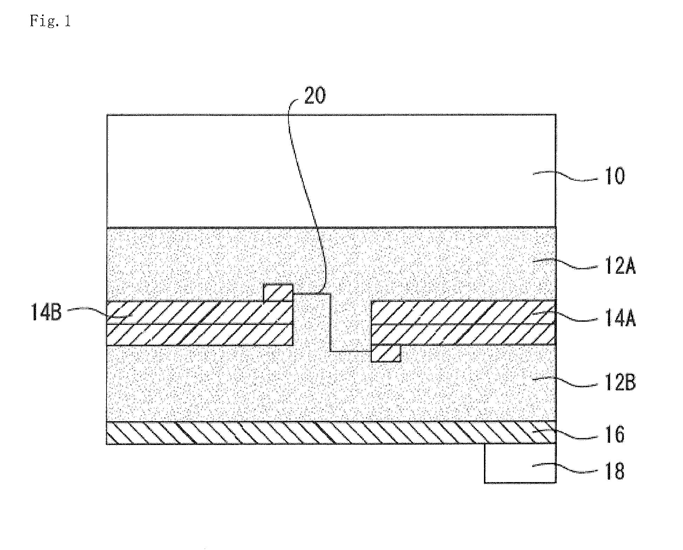

[FIG. 1] FIG. 1 is a schematic sectional view illustrating an example of a solar cell module of the present invention.

### Description of Embodiments

First, a sheet for a solar cell according to each of the present inventions 1 to 5 is described in detail.
It should be noted that the term "film" as used herein generally refers to a thin, flat product whose thickness is extremely small as compared with its length and width, and whose maximum thickness is arbitrarily limited, the product being typically supplied in a roll shape (JIS K6900), and the term "sheet" as used herein generally refers to, by definition in JIS, a thin, flat product whose thickness is small for its length and width. However, a boundary between the sheet and the film is uncertain, and there is no need to discriminate between both the terms in the present invention. Accordingly, in the present invention, a product referred to as "film" comprehends a "sheet, " and a product referred to as "sheet" comprehends a "film. "

### (Sheets for solar cells of the present inventions 1 and 2)

A sheet for a solar cell of the present invention 1 is a sheet for a solar cell of a monolayer construction based on a polyphenylene ether-based resin layer formed of a resin composition using a polyphenylene ether as a main component. In addition, a sheet for a solar cell of the present invention 2 is a sheet for a solar cell of a multilayer construction having, as both outer layers, polyphenylene ether-based resin layers each formed of a resin composition using a polyphenylene ether as a main component.
The sheets for solar cells of the present inventions 1 and 2 are each a sheet to be used for constructing a solar cell module, and particular examples of the sheet include a front surface- or back surface-sealing sheet (front sheet or back sheet) anda substrate sheet. In particular, the sheets are each a sheet for a solar cell that can be suitably used as a back sheet.

As described in the foregoing, the sheets for solar cells of the present inventions 1 and 2 each have polyphenylene ether-based resin layer formed of a resin composition using a polyphenylene ether (which may hereinafter be abbreviated as "PPE") as a main component.
Here, the term "main component" refers to a state in which the polyphenylene ether accounts for the maximum ratio of the resin composition in the polyphenylene ether-based resin layer. A lower limit for the ratio of the polyphenylene ether, which is not particularly determined, is preferably 50 mass% or more, more preferably 65 mass% or more, still more preferably 80 mass% or more. As long as the ratio falls within the range, durability, flame retardancy, dimensional stability, a high mechanical strength, and high adhesiveness with a encapsulating resin layer or the like can be achieved.

Specific examples of the polyphenylene ether include poly(2,6-dimethyl-1,4-phenylene) ether, poly(2,6-diethyl-1,4-phenylene) ether, poly(2-methyl-6-ethyl-1,4-phenylene) ether, poly(2-methyl-6-propyl-1,4-phenylene) ether, poly(2,6-dipropyl-1,4-phenylene) ether, poly(2-ethyl-6-propyl-1,4-phenylene) ether, poly(2,6-dimethoxy-1,4-phenylene) ether, poly(2,6-dichloromethyl-1,4-phenylene) ether, poly(2,6-dibromomethyl-1,4-phenylene) ether, poly(2,6-diphenyl-1,4-phenylene) ether, poly(2,6-ditolyl-1,4-phenylene) ether, poly(2,6-dichloro-1,4-phenylene) ether, poly(2,6-dibenzyl-1,4-phenylene) ether, and poly(2,5-dimethyl-1,4-phenylene) ether. Of those, poly(2,6-dimethyl-1,4-phenylene) ether is suitably used.

Alternatively, a copolymer in which the polyphenylene ether has grafted thereto a styrene-based compound may also be used. Examples of the polyphenylene ether having grafted thereto a styrene-based compound include copolymers each obtained through graft polymerization of a styrene-based compound such as styrene, α-methylstyrene, vinyltoluene, or chlorostyrene to the above-mentioned polyphenylene ether.

Further, the polyphenylene ether may be modified with a modifier having a polar group. Examples thereof include an acid halide, a carbonyl group, an acid anhydride, an acid amide, a carboxylic acid ester, an acid azide, a sulfone group, a nitrile group, a cyano group, an isocyanic acid ester, an amino group, an imide group, a hydroxyl group, an epoxy group, an oxazoline group, and a thiol group.

A lower limit for the limiting viscosity of the polyphenylene ether to be used in each of the present inventions 1 and 2 determined from its viscosity measured in chloroform at 30°C is preferably 0.2 dl/g or more, more preferably 0.3 dl/g or more, still more preferably 0.4 dl/g or more. As long as a value for the limiting viscosity falls within the range, troubles such as poor heat resistance, poor flame retardancy, and a poor mechanical strength hardly occur. In addition, an upper limit for the limiting viscosity is preferably 0.8 dl/g or less, more preferably 0.7 dl/g or less, still more preferably 0.6 dl/g or less. As long as the value for the limiting viscosity falls within the range, troubles such as poor productivity due to an excessively high shearing viscosity hardly occur.
In addition, polyphenylene ethers having different limiting viscosities maybe used in combination for the purpose of , for example, improving moldability.

Commercially available polyphenylene ethers are sold and available under the trade names "PPO646, " "PPO640, " and "PPO630" from SABIC INNOVATION PLASTICS, and the trade names "S201A" and "S202" from Asahi Kasei Chemicals Corporation, respectively.

For the purpose of improving physical properties such as extrusion moldability, impact resistance, heat resistance, flame retardancy, and adhesiveness, there are preferably blended, in the above-mentioned polyphenylene ether, appropriate amounts of styrene-based resins such as general-purpose polystyrene (GPPS), high impact polystyrene (HIPS), acrylonitrile-butadiene-styrene (ABS), a hydrogenated styrene-butadiene-styrene block copolymer (SEBS), a styrene-butadiene-styrene block copolymer (SBS), and a hydrogenated styrene-isoprene-styrene block copolymer (SEPS), ethylene-based resins such as an ethylene/propylene copolymer, an ethylene/1-butene copolymer, an ethylene/propylene/non-conjugated diene copolymer, an ethylene/ethyl acrylate copolymer, an ethylene/glycidyl methacrylate copolymer, an ethylene/vinyl acetate/glycidyl methacrylate copolymer, and an ethylene/propylene-g-maleic anhydride copolymer, polyester-based resins such as a polyester-polyether elastomer and a polyester-polyester elastomer, polyamide-based resins, and polyphenylene sulfide-based resins. With regard to the addition amount of any such product, the product is preferably compounded in an appropriate amount within such a range as not to exceed the content (mass%) of the polyphenylene ether described in the foregoing. For example, the content of each of a polystyrene-based resin and a polyethylene-based resin is 1 mass% or more, preferably 3 mass% or more, still more preferably 5 mass% or more. Compounding any such resin at a content within the range can improve melt processability and impact resistance. In addition, any such resin is preferably added at a content of 40 mass% or less, more preferably 30 mass% or less, more preferably 25 mass% or less, still more preferably 20 mass% or less because problems such as an excessive reduction in heat resistance and the inhibition of flame retardancy do not occur.

The polyphenylene ether is easily formed into a char layer at the time of its combustion because the polyphenylene ether has an aromatic ring and an oxygen atom in its unit skeleton. In addition, the polyphenylene ether is a resin that does not cause the drip of a molten resin and is excellent in flame retardancy because of the following features. By virtue of the presence of active hydrogen, the polyphenylene ether has a radical-capturing ability and easily suppresses the breaking of a molecular chain.
Further, an improvement in flame retardancy can be achieved by adding, for example, a halogen-based flame retardant such as brominated biphenyl ether, a metal hydroxide flame retardants such as magnesium hydroxide, or an inorganic flame retardant such as a nitrogen-based compound or an antimony-based compound. Of those, any such phosphorus-based flame retardant as described below is preferred from the viewpoints of, for example, an environmental load, the impartment of flame retardancy, and the securement of a mechanical strength.

As the phosphorus-based flame retardant, preferably used are, for example, phosphoric acid ester-based flame retardants such as triphenyl phosphate, trixylenyl phosphate, triethyl phosphate, cresyldiphenylphosphate, xylenylphosphate, resorcinol bis(diphenyl) phosphate, 2-ethylhexyl diphenyl phosphate, dimethyl methyl phosphate, and triallyl phosphate, condensed phosphoric acid ester-based flame retardants such as an aromatic condensed phosphoric acid ester, phosphazene compounds such as phosphonitric acid phenyl ester, and red phosphorus. Any such flame retardant is added at a content of preferably 30 mass% or less, more preferably 20 mass% or less, still more preferably 15 mass% or less. It is suitable that the content should fall within the range because neither an excessive reduction in heat resistance due to the addition of the flame retardant nor the contamination of an environment by the flame retardant to serve as a volatile gas during a melt processing occurs. In addition, a lower limit for the addition content is 0.1 mass% or more, preferably 1.0 mass% or more, more preferably 3.0 mass% or more. It is suitable that the content should fall within the range because a flame retardancy-improving effect is obtained.

As described later, when a polyphenylene ether-based composition is subjected to extrusion molding, heat resistance may be requested of a component to be added as well because the extrusion molding is performed at a relatively high temperature (260°C to 320°C). An indicator for the heat resistance is, for example, a weight loss temperature based on thermogravimetry. The 5% weight loss temperature of the above-mentioned phosphorus-based flame retardant when the flame retardant is heated from normal temperature to 400°C under an inert gas atmosphere at a rate of temperature increase of 10°C/min is preferably 150°C or more, more preferably 200°C or more, still more preferably 250°C or more, particularly preferably 275°C or more. As long as the temperature falls within the range, troubles such as the deterioration of a working environment due to the volatilization of the phosphorus-based flame retardant during the molding processing, a reduction in the flame retardancy of a sheet after the molding, and the deterioration of the external appearance of the sheet due to the acceleration of a reaction with a base material during the extrusion molding hardly occur. In addition, an upper limit for the temperature, which is not particularly limited, is preferably equal to ormore than an extrusion molding temperature.

In addition to the above-mentioned components, other additional components such as inorganic fillers including a carbon filler, a glass filler, talc, and mica for improving heat resistance and a mechanical strength, heat stabilizers, antioxidants, and plasticizers (e.g., oils, low-molecular weight polyethylenes, epoxidized soybean oils, polyethylene glycols, and aliphatic esters) for improving extrusion moldability, flame retardant aids for improving flame retardancy, weatherability (light fastness) improvers for improving durability, nucleating agents, and various colorants may each be added as required to such an extent that the features and effects of each of the sheets for solar cells of the present inventions 1 and 2 are not impaired.

Although the above-mentionedpolyphenylene ether-based resin composition is formed by adding the above-mentioned components to the polyphenylene ether, a commercial product in which the components have been mixed in advance may be purchased and used.
Commercially available polyphenylene ether-based resin compositions are sold and available under the trade names "Noryl PX9406," "Noryl LTA1350," and "Noryl N300" from SABIC INNOVATION PLASTICS, the trade names "Xyron 540Z," "Xyron 640Z," and "Xyron 740Z" from Asahi Kasei Chemicals Corporation, and "Iupiace LN91, "Iupiace AN70," "Iupiace AH90," "Iupiace TX903B," and "LEMALLOY BX528-A3" from Mitsubishi Engineering-Plastics Corporation, respectively.

The sheets for solar cells of the present inventions 1 and 2 may each be of a construction formed only of a polyphenylene ether-based resin layer, or may each be of a construction obtained by laminating the layer together with any other layer. Examples of the other layer in the case of the lamination include an intermediate layer for expressing a mechanical strength, an insulation characteristic, or heat resistance, and a gas barrier property layer.

The intermediate layer is preferably formed because the formation thereof can increase the total thickness of the sheet for a solar cell, and additionally improve the mechanical strength, insulation characteristic, and heat resistance of the sheet. A resin for forming the intermediate layer is exemplified by a polyethylene-based resin, a polypropylene-based resin, a cyclic polyolefin-based resin, a polystyrene-based resin, an acrylonitrile-styrene copolymer (AS resin), an acrylonitrile-butadiene-styrene copolymer (ABS resin), a polyvinyl chloride-based resin, a poly(meth)acrylic resin, a polycarbonate-based resin, a polyester-based resin, a fluorine-based resin, a polyamide-based resin, a polyimide-based resin, a polyamideimide-based resin, a polyarylphthalate-based resin, a silicone-based resin, a polysulfone-based resin, a polyphenylene sulfide-based resin, a polyether sulfone-based resin, a polyurethane-based resin, an acetal-based resin, and a cellulose-based resin.
Of the above-mentioned resins, each of the olefin-based resins such as the polyethylene-based resin, the polypropylene-based resin, and the cyclic polyolefin-based resin is preferred because of the following reasons. Each of the resins is excellent in durability by virtue of its excellent hydrolysis resistance, and has a light specific gravity, which leads to a reduction in the weight of the entire sheet. A resin out of the polyester-based resin and the polyphenylene sulfide-based resin which is obtained by biaxial orientation is particularly preferred because the resin has an extremely high mechanical strength (elastic modulus). The fluorine-based resin is preferred for the purpose of improving physical properties because the resin brings together flame retardancy and durability.

A layer of a construction including an inorganic thin-film layer can be suitably used as the gas barrier property layer. A metal thin film such as an aluminum foil or a thermoplastic polymer can also be used as the gas barrier property layer, and any material can be used without any particular limitation as long as the material can be used as an ordinary packaging material.
Specific examples thereof include polyolefins such as homopolymers or copolymers of ethylene, propylene, butene, and the like, amorphous polyolefins such as a cyclic polyolefin, polyesters such as polyethylene terephthalate and polyethylene-2,6-naphthalate, polyamides such as nylon 6, nylon 66, nylon 12, and copolymer nylon, a partially hydrolyzed product of an ethylene -vinylacetate copolymer (partially saponified product, EVOH), polyimide, polyetherimide, polysulfone, polyethersulfone, polyether ether ketone, polycarbonate, polyvinylbutyral, polyarylate, and an acrylate resin. Of those, polyesters, polyamides, and polyolefins are preferred in view of film physical properties. Of those, polyethylene terephthalate and polyethylene naphthalate are more preferred in view of film strength. Further, polyethylene naphthalate is still more preferred in view of weatherability and hydrolysis resistance.

An inorganic substance for constructing the inorganic thin-film layer is exemplified by silicon, aluminum, magnesium, zinc, tin, nickel, titanium, or hydrogenated carbon, or an oxide, carbide, or nitride thereof , or a mixture thereof. Of those, silicon oxide, aluminum oxide, and diamond-like carbon mainly formed of hydrogenated carbon are preferred. In particular, silicon oxide, silicon nitride, silicon oxynitride, and aluminum oxide are preferred because they can stably maintain high gas barrier property.

A material gas that may be used for chemical vapor deposition is preferably formed of at least one kind of gas. For example, in the formation of a silicon compound thin film, a second raw material gas such as ammonia, nitrogen, oxygen, hydrogen, or a noble gas, e.g., argon is preferably used with a first raw material gas containing silicon.

Examples of the first rawmaterial gas containing silicon include monosilane, tetramethoxysilane, methyltrimethoxysilane, dimethyldimethoxysilane, phenyltrimethoxysilane, diphenyldimethoxysilane, tetraethoxysilane, methyltriethoxysilane, dimethyldiethoxysilane, phenyltriethoxysilane, diphenyldiethoxysilane, hexyltrimethoxysilane, hexyltriethoxysilane, decyltrimethoxysilane, decyltrimethoxysilane, trifluoropropyltrimethoxysilane, hexamethyldisiloxane, and hexamethyldisilazane, which may be used alone or in combination of two or more kinds thereof.
In addition, each raw material gas may be a liquid or a gas at room temperature, and a liquid raw material can be supplied to the inside of an apparatus by being vaporized with a raw material vaporizer. In a catalytic chemical vapor deposition method, a monosilane gas is preferred in terms of the deterioration of a heating catalyst body, reactivity, and a reaction rate.

Any one of the methods such as a vapor deposition method and a coating method can be employed as a method of forming the inorganic thin-film layer of the gas barrier property film. Of those, the vapor deposition method is preferred because a uniform thin film having high gas barrier property is obtained. The vapor deposition method comprehends methods such as physical vapor deposition (PVD) and chemical vapor deposition (CVD). Examples of the physical vapor deposition method include vacuum deposition, ion plating, and sputtering. Examples of the chemical vapor deposition method include plasma CVD involving utilizing plasma and a catalytic chemical vapor deposition method (Cat-CVD) involving subjecting a material gas to catalytic pyrolysis with a heating catalyst body.

Apolyphenylene ether-based resin may be used as a single layer (the present invention 1), or may be used in such a multilayer construction (the present invention 2) that both outer layers are formed as polyphenylene ether-based resin layers and a plurality of intermediate layers or gas barrier property layers as described above are further formed. The formation of a surface from a polyphenylene ether-based resin layer can facilitate the expression of long-term adhesiveness with a encapsulating material or a junction box, durability, and flame retardancy.
The thicknesses of the polyphenylene ether-based resin layers when used in the multilayer construction account for preferably more than 50%, more preferably 65% or more, still more preferably 80% or more of the entire thickness. In the present invention, that a thickness ratio of the polyphenylene ether-based resin layers with respect to the entire thickness exceeds 50% means that the total thickness of the respective polyphenylene ether-based resin layers including at least both the outer layers accounts for more than 50% of the entire thickness of the sheet.
When the polyphenylene ether-based resin layers are formed so that their total thickness may account for more than 50% of the entire thickness, characteristics influenced by the thickness such as flame retardancy, heat resistance, and a mechanical strength can be favorably exerted.

In the case of such a construction that each of the above-mentioned layers is provided as a plurality of layers, or the case of a single polyphenylene ether-based resin layer, the entire thickness is preferably 25 µm or more, more preferably 50 µm or more, still more preferably 75 µm or more, still more preferably 100 µm or more. As long as the thickness falls within the range, a trouble such as an insufficient mechanical strength hardly occurs. In addition, an upper limit for the entire thickness, which is not particularly determined, is preferably 500 µm or less, more preferably 400 µm or less, still more preferably 300 µm or less in terms of practicality because an excessively large thickness reduces handleability.
It should be noted that the case where a plurality of polyphenylene ether-based resin layers having different compositions exist is also naturally included in the category of a construction formed only of a polyphenylene ether-based resin layer.

Further, an easy-adhesion layer, a light-reflective colored layer, a hard coat layer, or the like may be additionally provided for the surface of each of the sheets for solar cells of the present inventions 1 and 2.

Although a polyphenylene ether-based resin layer expresses good adhesiveness with a encapsulating material as described later, an easy-adhesion layer may be provided in order that additional adhesiveness may be expressed. The easy-adhesion layer is formed by a known approach such as co-extrusion, dry lamination, or coating.
When the easy-adhesion layer is formed by co-extrusion, a polyolefin-based resin (such as a high-density polyethylene, a low-density polyethylene, a linear, low-density polyethylene or polypropylene, or a cyclic polyolefin) or a denatured polyolefin-based resin (such as an unsaturated carboxylic acid-denatured polyolefin-based resin), or a copolymerized vinyl compound such as an ethylene-vinyl acetate copolymer is preferably used.
The easy-adhesion layer may be formed by the following method instead of the formationof those resins into the layer by co- extrusion. The resins are each formed into a single film, and then the films are subjected to dry lamination with a known adhesive such as a polyurethane-based adhesive.
When the easy-adhesion layer is formed by coating, an acrylic resin or an epoxy-based resin is preferably used.
When the easy-adhesion layer is formed by co-extrusion or dry lamination, its thickness is preferably 5 µm or more, more preferably 10 µm or more, still more preferably 25 µm or more. A thickness within the range is preferred because good adhesiveness can be expressed. An upper limit for the thickness, which is not particularly determined, is preferably 150 µm or less from the viewpoint of handleability. When the layer is formed by coating, its thickness is preferably 0.5 µm or more, more preferably 1 µm or more, still more preferably 2 µm or more. It is suitable that an upper limit for the thickness, which is not particularly determined, should be 20 µm or less because an excessive reduction in productivity can be avoided.

In addition, a light-reflective colored layer may be provided. The light-reflective colored layer is used as a constituent on a side contacting a encapsulating material on the back surface side of a back sheet for a solar cell for the purposes of: reflecting sunlight that has passed through the solar cell to improve generation efficiency; and reflecting or absorbing ultraviolet light to prevent the deterioration of a constituent for the back sheet for the solar cell by ultraviolet light and to improve various characteristics of the back sheet such as weatherability, durability, heat resistance, thermal dimensional stability, andastrength. Thewhiteningof the layer is particularly effective in terms of the improvement in generation efficiency by the reflection of sunlight.
Further, the design and decoration of a solar cell module can be improved by coloring the layer in various ways typified by blackening.
It should be noted that the term "light reflection" in the light-reflective colored layer comprehends light scattering as well as light reflection.

A method involving dispersing and adding a pigment as a colorant and/or a method involving adding apolymer or fine particles incompatible with a base material and forming gaps or air bubbles at a blend interface at the time of the orientation of the film can each/can be employed as a method of coloring the light-reflective colored layer.

A resin for forming the light-reflective colored layer is exemplified by a polyethylene-based resin, a polypropylene-based resin, a cyclic polyolefin-based resin, a polystyrene-based resin, an acrylonitrile-styrene copolymer (AS resin), an acrylonitrile-butadiene-styrene copolymer (ABS resin), a polyvinyl chloride-based resin, a poly(meth)acrylic resin, a polycarbonate-based resin, a polyester-based resin, a fluorine-based resin, a polyamide-based resin, a polyimide-based resin, a polyamideimide-based resin, a polyarylphthalate-based resin, a silicone-based resin, a polysulfone-based resin, a polyphenylene sulfide-based resin, a polyether sulfone-based resin, a polyurethane-based resin, an acetal-based resin, and a cellulose-based resin.

Of the above-mentioned resins, preferred are a polyester-based resin, a fluorine-based resin, a polyethylene-based resin, a polypropylene-based resin, and a cyclic polyolefin-based resin having high heat resistance, strength, weatherability, durability, and gas barrier property against water vapor or the like. In particular, a layer formed of the polyester-based resin and a film formed of the polypropylene-based resin have the following features. Silver deposition or the like is easily conducted on the layer, and hence a function of increasing a reflectance is easily imparted to the layer. The film has high hydrolysis resistance and high weatherability, is excellent in stability over time, and shows good hot-melt adhesiveness with the encapsulating resin layer of the solar cell module.

Examples of the above-mentioned polyester-based resin include a polylactic acid, a polyethylene terephthalate, and a polyethylene naphthalate. Of those polyester-based resins, the polyethylene terephthalate having a good balance among the aspects of various functions such as heat resistance and weatherability, and a price aspect is particularly preferably used. A film with its surface treated for preventing the yellowing of its polyester is also preferably used.

Examples of the above-mentioned cyclic polyolefin-based resin include polymers obtained by polymerizing cyclic diene such as cyclopentadiene and derivatives thereof, dicyclopentadiene and derivatives thereof, cyclohexadiene and derivatives thereof, and norbornadiene and derivatives thereof, and copolymers obtained by copolymerizing the cyclic dienes with one kind or two or more kinds of olefin-based monomers such as ethylene, propylene, 4-methyl-1-pentene, styrene, butadiene, and isoprene. Of those cyclic polyolefin-based resins, preferred are polymers of cyclic dienes such as cyclopentadiene and derivatives thereof, dicyclopentadiene and derivatives thereof, or norbornadiene and derivatives thereof excellent in, for example, strength, heat resistance, and weatherability.

Examples of the above-mentioned polyethylene-based resin include a homopolymer of ethylene, low density polyethylene, linear low density polyethylene, high density polyethylene, an ethylene-α-olefin copolymer obtained through polymerization with a metallocene-based catalyst, and a mixture thereof.

In addition, examples of the above-mentioned polypropylene-based resin include a homopolymer of propylene, a copolymer of propylene, a reactor-type, polypropylene-based thermoplastic elastomer, and a mixture thereof.
Examples of the homopolymer of propylene include an isotactic polypropylene-based resin, a syndiotactic polypropylene-based resin, and an atactic polypropylene-based resin. In addition, a mixture of two or more kinds of polypropylene-based resins can be used. Of those, an isotactic polypropylene-based resin is preferably used in view of ease with which a sheet for a solar cell module, which is applicable to a wide range of use environments, is produced.
Examples of the copolymer of propylene include a random copolymer (random polypropylene) or block copolymer (block polypropylene) of propylene with ethylene or any other α-olefin, and a block copolymer or graft copolymer containing a rubber component. The other α-olefin copolymerizable with propylene is preferably one having 4 to 12 carbon atoms, and examples thereof include 1-butene, 1-pentene, 1-hexene, 1-heptene, 1-octene, 4-methyl-1-pentene, and 1-decene. One kind or a mixture of two or more kinds thereof is used. The mixing ratio of the α-olefin is usually about 1 to 10 mass%.

Preferred examples of the pigment to be used for coloring include a white pigment and a black pigment. Although the white pigment is not particularly limited, for example, calcium carbonate, anatase-type titanium oxide, rutile-type titanium oxide, zinc oxide, lead carbonate, barium sulfate, basic lead carbonate, basic lead sulfate, basic lead silicate, zinc white, zinc sulfide, or lithopone can be used as the pigment. Rutile-type titanium oxide is preferred to anatase-type titanium oxide because of the following reason. Rutile-type titanium oxide reduces the extent of the yellowing of a polyester film after long-term irradiation with rays, and is hence suitable for suppressing a change in color difference.
Of the above-mentioned white pigments, inorganic fine particles of at least one kind selected from the group consisting of rutile-type titanium oxide, barium sulfate, calcium carbonate, and silicon dioxide are preferred in terms of stabilityandanon-heavy metal compound. Barium sulfate or rutile-type titanium oxide is more preferred, and barium sulfate is still more preferred.

Barium sulfate is stable both physically and chemically, is a good white material showing reflectances of 99% or more for visible light rays over substantially the entire region, and is a substance used as a reference for a white color. In addition, barium sulfate is a material having high coloring property and high opacifying property, and hence enables efficient whitening and exerts a high ray-reflecting effect when used in a back sheet for a solar cell.

Although the black pigment is not particularly limited either, carbon black, black iron oxide, or the like is used as the pigment. Of those, the carbon black is preferably used from the viewpoint of, for example, long-term stability. For example, a dye or a pigment is added to any such resin as described above in order that any other color (such as a blue color, a red color, or a yellow color) may be expressed. Of those, the pigment is preferably added from the viewpoint of long-term stability.

When each of the above-mentioned layers is provided as a plurality of layers, a method based on co-extrusion may be adopted, or a known adhesive or pressure-sensitive adhesive may be used. The polyphenylene ether-based resin layer of the present invention can be easily provided as a plurality of layers because the layer shows an affinity for the adhesive or pressure-sensitive adhesive and hence has a strong adhesive force.

In addition, a side to serve as the outermost surface when the sheet is formed as a solar cell module may be subjected to a known hard coat treatment or antifouling treatment so as to be caused to express surface characteristics such as scratch resistance and antifouling property.
In addition, a treatment for forming irregularities on the surface of the sheet may be performed for the purposes of improving the sliding property of the surface and improving handleability at the time of the assembly or laying of the module. Arbitrary means such as a method involving embossing the film at the time of its molding, a method involving incorporating inorganic particles of silica, talc, or the like into the surface layer, or amethod involving subjecting a layer containing inorganic particles to co-extrusion, cooling the layer to solidify the layer, and peeling the solidified layer may be employed for forming the irregularities on the surface. Of course, the surface may be smoothened by employing a known approach such as coating from the viewpoint of, for example, a design.

The sheets for solar cells of the present inventions 1 and 2 can each be produced by a conventionally known method.
The respective compounding agents may be kneaded in advance, or may be collectively kneaded at the time of film formation.
A molding method, which may be based on any one of the extrusion, calender, and flow casting modes, is preferably extrusion molding from the viewpoints of the ease with which a thin-film product is recovered and its production efficiency.
Gum (resin attachment) or foreign matter is produced to impair the external appearance because the extrusion molding is performed at a high temperature. A method involving opening the lip gap of a mouthpiece to reduce a shear rate, a method involving plating the flow channel surface of the mouthpiece, a method involving subjecting any other resin having good sliding property between the polyphenylene ether-based resin layer and a metal to co-extrusion, or the like is available for preventing the production. When the other resin is subjected to co-extrusion, the other resin is typically peeled after having been cooled to solidify, provided that when the other resin is used by being laminated on the sheet for a solar cell of the present invention, such an aspect that the other resin is not peeled from one surface or each of both surfaces can also be adopted.

In order that the extrusion molding may be performed, a shearing viscosity measured with a flow tester is preferably 50 Pa·s (500 poise) or more, more preferably 100 Pa·s (1,000 poise) or more, still more preferably 500 Pa·s (5,000 poise) or more when a shear rate at 300°C is 100 sec⁻¹. As long as the shearing viscosity falls within the range, troubles such as excessive deterioration of physical properties hardly occur. In addition, the shearing viscosity is preferably 5,000 Pa·s (50,000 poise) or less, more preferably 3,500 Pa·s (35,000 poise) or less, still more preferably 2,000 Pa·s (20,000 poise) or less. A shearing viscosity within the range is preferred from the viewpoint of productivity because a molding machine is prevented from shouldering an excessive load owing to poor extrusion property.
The following approach is available for adjusting the shearing viscosity to any such value as described above. The molecular weight of the polyphenylene ether is adjusted, the ratio of a component such as a styrene-based resin, an ethylene-based resin, or a polyamide-based resin is adjusted, the kind and addition amount of the flame retardant are adjusted, or any other plasticizer or the like is added.

The sheets for solar cells of the present inventions 1 and 2 are excellent in flame retardancy. The spread of fire upon occurrence of fire can be prevented by virtue of the flame retardancy. Each of the sheets is evaluated for its flame retardancy by judging its burning behavior based on a burning test. As described in the foregoing, the polyphenylene ether is a resin excellent in flame retardancy, and such an approach as described below is available for imparting flame retardancy. The content of the polyphenylene ether is raised, the addition amount of the flame retardant is raised, the amount of a component such as a lubricant is reduced, or the thickness ratio of the polyphenylene ether-based resin layer with respect to the entire thickness is increased.

As the sheet for a solar cell is exposed to an external environment, hydrolysis resistance as one aspect of durability is needed for stably protecting a solar cell for a long time period. The sheet is evaluated for its hydrolysis resistance by measuring its physical properties after a promotion evaluation under an arbitrary environment. In order that the hydrolysis resistance may be imparted, the amount of a low-molecular weight component (such as an additive) has only to be reduced, or the amount of a composition having hydrolyzability (such as a polyamide, a polyester, or a polycarbonate) has only to be reduced. The mixing of a hydrolysis inhibitor (such as a carbodiimide) is also permitted.

A mechanical strength typified by, for example, an elastic modulus in tension or a tensile elongation at break is needed for handleability in the step of forming a module, the protection of a cell from an external impact after the installation of the module, or the like. In order that the mechanical strength may be imparted, the thickness of the sheet for a solar cell has only to be increased or a component having impact resistance such as an elastomer has only to be added.

In addition, a crosslinking step for a crosslinked EVA as a general encapsulating resin is performed at about 150°C for about 30 minutes. Therefore, the sheet must have heat resistance and show a small dimensional change in order that a trouble may be avoided in the step of forming the solar cell module. Its deflection temperature under load is preferably 100°C or more, more preferably 120°C or more, still more preferably 140°C or more in order that the heat resistance may be expressed. As long as the deflection temperature under load is 100°C or more, a trouble such as an increase in dimensional change due to insufficient heat resistance hardly occurs. In addition, an upper limit for the deflection temperature under load, which is not particularly determined, is preferably 200°C or less, more preferably 180°C or less, still more preferably 160°C or less. As long as the deflection temperature under load is 200°C or less, a trouble such as poor productivity due to an excessive increase in the above-mentioned shearing viscosity hardly occurs.
The deflection temperature under load of a two-component blend system of a polyphenylene ether and a polystyrene generally changes in a linear fashion depending on a compounding ratio, and the deflection temperature under load changes from about 190°C to about 80°C as the content of the polyphenylene ether changes from 100% to 0%. Therefore, raising the content of the polyphenylene ether is effective in increasing the deflection temperature under load. Reducing the addition amount of, for example, a flame retardant or plasticizer which lowers the deflection temperature under load, blending a high-heat resistant resin such as a polyphenylene sulfide or a polyamide, or compounding an inorganic filler is also effective .

The polyphenylene ether is preferred for solar cell applications that are expected to undergo an increase in demand in the future in terms of the following as well. As the polyphenylene ether has been supplied as a general-purpose engineering plastic in a large amount, the polyphenylene ether can be stably supplied even if its consumption will further enlarge in the future.

### (Sheet for solar cell of the present invention 3)

A sheet for a solar cell of the present invention 3 is a sheet to be used for constructing a solar cell module, and particular examples of the sheet include a front surface- or back surface-sealing sheet (front sheet or back sheet) and a substrate sheet. In particular, the sheet is a sheet for a solar cell that can be suitably used as a back sheet. The sheet for a solar cell of the present invention 3 is formed of a laminated sheet having at least one layer of each of at least a layer (I) and a layer (II), and the contents of the respective constituting layers are as described below.

### <Layer (I) >

The layer (I) must be formed of a resin composition using a polyphenylene ether (which may hereinafter be abbreviated as "PPE") as a main component. It should be noted that the meaning of the term "main component" is the same as that of each of the present inventions 1 and 2 (the same holds true for the present invention 4).

### <Polyphenylene ether (PPE)>

With regard to specific examples of the polyphenylene ether (PPE), any one of the same examples as those of the polyphenylene ether according to each of the present inventions 1 and 2 can be suitably used. A material for the polyphenylene ether, a product to be compounded and its ratio, an applicable commercial product, and the like are also the same as those in the case of the polyphenylene ether according to each of the present inventions 1 and 2.

### <Method of producing layer (I)>

The layer (I) is produced by using the polyphenylene ether-based resin composition using the PPE formed of the above-mentioned contents as a main component. The shape of the layer is typically a film or sheet shape, and with regard to its production method, the layer can be produced by a conventionally known molding method. The respective compositions may be kneaded in advance, or may be collectively kneaded at the time of the production (film formation).

A molding method, which may be based on any one of the extrusion molding method, calender molding method, and flow casting molding method as in the case of each of the present inventions 1 and 2, is preferably extrusion molding method from the viewpoints of the ease with which a thin-film product is recovered and its production efficiency.
As each composition is subjected to extrusion molding at a relatively high temperature (260°C to 320°C) in the extrusion molding method, a pyrolysis product such as gum or foreign matter is apt to be produced at the time of the molding to impair the external appearance of a film or sheet to be obtained. As a measure against this problem, a method involving opening the lip gap of a mouthpiece to reduce a shear rate, a method involving plating the flow channel surface of the mouthpiece, a method involving subjecting any other resin having good sliding property between the polyphenylene ether-based resin layer and a metal to co-extrusion, or the like is available. When the other resin is subjected to co-extrusion, the other resin is typically peeled after having been cooled to solidify, provided that when the other resin is used by being laminated on the sheet for a solar cell of the present invention, such an aspect that the other resin is not peeled from one surface or each of both surfaces can also be adopted.

In order that the extrusion molding may be performed by using the above-mentioned resin composition, the shearing viscosity of the above-mentioned resin composition measured with a flow tester preferably falls within the same range as that in the case of each of the present inventions 1 and 2. An approach to adjusting the shearing viscosity to any such value as described above is also the same as that in the case of each of the present inventions 1 and 2.

### <Layer (II)>

The layer (II) in the sheet for a solar cell of the present invention 3 must be a layer having specific gas barrier property, and its water vapor permeability (measurement method: JIS K7127) must be less than 10 g/m²·24 hr.
The gas barrier properties of a sheet typically refer to oxygen barrier property and water vapor barrier property. Particularly in a solar cell, however, excellent water vapor barrier property is requested in order that a reduction in the performance of the solar cell element due to moisture may be suppressed. Although the level at which the property is requested varies depending on the kind and construction of the solar cell, when comparison is performed in terms of a water vapor permeability characteristic of the water vapor barrier property, the water vapor permeability must be less than 10 g/m²·24 hr, and is preferably less than 5 g/m²·24 hr, more preferably less than 1 g/m²·24 hr in crystalline silicon-based solar cell applications that are prevailing to the largest extent. In addition, additional water vapor barrier property is requested of a solar cell called a next-generation solar cell such as a thin-film silicon-, inorganic compound-, organic compound-, or dye sensitization-based solar cell, and such a water vapor permeability is less than 0.1 g/m²·24 hr.

In order that such gas barrier property may be expressed, the layer (II) is preferably formed of a layer selected from the following layers (a) to (e) depending on, for example, requested gas barrier property:
(a) a metal thin-film layer;
(b) an inorganic thin-film layer;
(c) a resin layer using a resin selected from a cyclic olefin, a high-density polyethylene, a polypropylene, a polyvinylidene chloride, a polytetrafluoroethylene, and a polychlorotrifluoroethylene as a main component;
(d) a resin layer containing flat inorganic particles; and
(e) a coating layer using a resin selected from a polyvinylidene chloride, a polyvinyl alcohol, an acrylic resin, and an epoxy-based resin as a main component.

Of those, (a) the metal thin-film layer expresses gas barrier property most easily. (b) The inorganic thin-film layer has the following advantages. The layer expresses excellent gas barrier property, has an insulation characteristic, and can be made transparent. (c) The resin single-body layer can be easily molded, and is excellent in insulation characteristic because the layer is free of any metal. (d) The inorganic particle composite layer can be easily molded and express more excellent gas barrier property than that of the resin single body. (e) The resin coating layer has the following advantages. The layer can be easily molded, easily expresses gas barrier property, has an insulation characteristic, and can be made transparent.
Hereinafter, the above-mentioned respective layers (a) to (e) are described.

### < (a) Metal thin-film layer>

An aluminum foil canbe suitablyusedbecause of ease of handling and availability. A reduction in gas barrier property due to a pinhole can be prevented as long as the layer has a thickness of 20 µm or more.

### < (b) Inorganic thin-film layer>

Specific examples of a base material for forming an inorganic thin-film layer include polyolefins such as homopolymers or copolymers of ethylene, propylene, butene, and the like, amorphous polyolefins such as a cyclic polyolefin, polyesters such as polyethylene terephthalate and polyethylene-2,6-naphthalate, polyamides such as nylon 6, nylon 66, nylon 12, and copolymer nylon, a partially hydrolyzed product of an ethylene-vinyl acetate copolymer (partially saponified product, EVOH), polyimide, polyetherimide, polysulfone, polyethersulfone, polyether ether ketone, polycarbonate, polyvinylbutyral, polyarylate, and an acrylate resin. Of those, polyesters, polyamides, and polyolefins are preferred in view of film physical properties. Of those, polyethylene terephthalate and polyethylene naphthalate are more preferred in view of film strength. Further, polyethylene naphthalate is still more preferred in view of weather resistance and hydrolysis resistance.

An inorganic substance for constructing the inorganic thin film layer is exemplified by silicon, aluminum, magnesium, zinc, tin, nickel, titanium, or hydrogenated carbon, or an oxide, carbide, or nitride thereof, or a mixture thereof. Of those, silicon oxide, aluminum oxide, and diamond-like carbon mainly formed of hydrogenated carbon are preferred. In particular, silicon oxide, silicon nitride, silicon oxynitride, and aluminum oxide are preferred because they can stably maintain high gas barrier property.

Any one of the methods such as a vapor deposition method and a coating method can be employed as a method of forming the inorganic thin-film layer on the base material. Of those, the vapor deposition method is preferred because a uniform thin film having high gas barrier property is obtained. The vapor deposition method comprehends methods such as physical vapor deposition (PVD) and chemical vapor deposition (CVD). Examples of the physical vapor deposition method include vacuum deposition, ion plating, and sputtering. Examples of the chemical vapor deposition method include plasma CVD involving utilizing plasma and a catalytic chemical vapor deposition method (Cat-CVD) involving subjecting a material gas to catalytic pyrolysis with a heating catalyst body.

A material gas that may be used for chemical vapor deposition is preferably formed of at least one kind of gas. For example, in the formation of a silicon compound thin film, a second raw material gas such as ammonia, nitrogen, oxygen, hydrogen, or a noble gas, e.g., argon is preferably used with a first raw material gas containing silicon.
Examples of the first raw material gas containing silicon include monosilane, tetramethoxysilane, methyltrimethoxysilane, dimethyldimethoxysilane, phenyltrimethoxysilane, diphenyldimethoxysilane, tetraethoxysilane, methyltriethoxysilane, dimethyldiethoxysilane, phenyltriethoxysilane, diphenyldiethoxysilane, hexyltrimethoxysilane, hexyltriethoxysilane, decyltrimethoxysilane, decyltrimethoxysilane, trifluoropropyltrimethoxysilane, hexamethyldisiloxane, and hexamethyldisilazane, which may be used alone or in combination of two or more kinds thereof.
In addition, each raw material gas may be a liquid or a gas at room temperature, and a liquid raw material can be supplied to the inside of an apparatus by being vaporized with a raw material vaporizer. In a catalytic chemical vapor deposition method, a monosilane gas is preferred in terms of the deterioration of a heating catalyst body, reactivity, and a reaction rate.

### <(c) Resin single-body layer>

The layer is a resin having gas barrier property by itself, and a sheet having crystallinity or an orientation-aligned film can be suitably used. A path through which a gas permeates elongates depending on a crystal and alignment, and hence the layer expresses the gas barrier property. A resin selected from a cyclic olefin, a high-density polyethylene, a polypropylene, a polyvinylidene chloride, a polytetrafluoroethylene, and a polychlorotrifluoroethylene can be suitably used. The cyclic olefin can be most suitably used because of its excellent gas barrier property.

### < (d) Resin layer containing flat inorganic particles>

Gas barrier property can be improved by incorporating flat inorganic particles into a thermoplastic resin. The flat inorganic particles are made of, for example, mica or clay, and the incorporation of such flat particles elongates a path through which a gas permeates, thereby enabling the expression of the gas barrier property. The content of the particles is typically about 10 to 50 mass% with respect to the resin component, and it is suitable that the resin and the flat inorganic particles should be subjected to extrusion molding while being kneaded with a biaxial extruder because the flat inorganic particles can be uniformly dispersed in the resin and excellent productivity can be achieved. In addition, a product molded out of a nanocomposite of, for example, nylon and clay can be suitably used as a film or a sheet.

### <(e) Resin coating layer>

With regard to a resin component of the layer, a resin selected from a polyvinylidene chloride, a polyvinyl alcohol, an acrylic resin, and an epoxy-based resin is used as a main component, and a base material can be coated with the resin component dissolved in an ordinary solvent. Of those, the polyvinylidene chloride can be suitably used because of its excellent gas barrier property.

### <Layer construction of sheet for solar cell>

The sheet for a solar cell of the present invention 3 is of such a layer construction as to have at least one layer of each of the layer (I) and the layer (II) whose contents have been described above, and the following layer constructions can be given as examples of the layer construction. It should be noted that various layer constructions except the following are also permitted as long as the layer constructions do not violate the gist of the present invention.
1: [layer (I)/layer (II)] → encapsulating resin layer side
2: [layer (I)/layer (II)/layer (I)] → encapsulating resin layer side
3: [layer (I)/layer (II)/light-shielding colored layer] → encapsulating resin layer side
4: [layer (I)/intermediate layer/layer (II)] → encapsulating resin layer side
5: [layer (I)/layer (II)/layer (I)/easy-adhesion layer] → encapsulating resin layer side

Layers except the layer (I) and the layer (II) in the above-mentioned layer constructions are layers corresponding to characteristics requested of the sheet for a solar cell, and specific contents of the layers are described later. In addition, for example, a layer construction in which the plurality of layers (I) are described comprehends such a construction that the contents of the compositions of the layers differ from each other as well.
Of those constructions, the construction 1 is preferred from the viewpoints of an improvement in productivity by the simplification of the construction and reliability by virtue of a small number of layer interfaces, and the construction 2 is preferred because high reliability can be obtained as a result of the placement of the layer (I) excellent in heat resistance, durability, and flame retardancy as each of both outer layers.

The sheet formed of any such layer construction can be formed by a co-extrusion molding method depending on a resin to be used. Alternatively, the sheet can be formed by a dry lamination method with a known adhesive such as a polyurethane- or polyester-based adhesive after the formation of the sheet as a monolayer film. At that time, a known treatment such as a corona discharge treatment may be performed for improving adhesiveness with each layer and for improving adhesiveness with a encapsulating material or a junction box.
In each of all the sheets for solar cells given above, the layer (I) is placed on the outer surface. As a result, long-term adhesiveness with a junction box included with a solar cell module to be described later or with an adherend such as a steel plate or a resin plate can be easily expressed. In addition, long-term reliability is obtained by placing the layer (I) excellent in heat resistance, durability, and flame retardancy on the outer surface.

In addition, in the layer construction described in the above-mentioned section 2, the layer (I) is placed on the inner surface as well. With the construction, adhesiveness with a encapsulating resin layer is easily improved. In particular, a polyphenylene ether-based resin layer preferably exists on the inner surface because the resin layer has strong adhesiveness with a encapsulating resin having a radical generator to be described later.
Here, the term "outer surface" means a surface exposed to the outside when the sheet is built in a solar cell module, and the term "inner surface" means a surface contacting a encapsulating resin layer when the sheet is built in the solar cell module.

A ratio of the total thickness of the layer (I) in the sheet for a solar cell of the present invention 3 to the entire thickness of the sheet is preferably more than 50%, more preferably 65% or more, still more preferably 80% or more of the entire thickness. When the layer (I) is formed so that its thickness may account for more than 50% of the entire thickness, characteristics influenced by the thickness such as flame retardancy, heat resistance, and a mechanical strength can be favorably exerted. The gas barrier property of the entire sheet of a multilayer construction in the sheet is determined by the layer having the highest gas barrier property, and is influenced by a thickness ratio to a small extent. Accordingly, the thickness ratio of the layer (II) is not particularly limited, and the placement of the layer (II) can exert an effect concerning the gas barrier property.

The entire thickness of a sheet of such a construction that each of the above-mentioned layers is provided as a plurality of layers is preferably 25 µm or more, more preferably 50 µm or more, still more preferably 75 µm or more, still more preferably 100 µm or more. As long as the thickness falls within the range, a trouble such as an insufficient mechanical strength hardly occurs. In addition, an upper limit for the thickness, which is not particularly determined, is preferably 500 µm or less, more preferably 400 µm or less, still more preferably 300 µm or less in terms of practicality because an excessively large thickness reduces handleability.

### <Other layer constructions easy-adhesion layer>

In the layer construction described in the above-mentioned section 5, an easy-adhesion layer is provided for the inner surface. Providing the layer can additionally improve the adhesiveness with the encapsulating resin layer. As in the case of each of the present inventions 1 and 2, the easy-adhesion layer can be formed by a known method such as co-extrusion, dry lamination, or coating. A method of forming the easy-adhesion layer, a material for the layer, the thickness of the layer, and the like are the same as those in the case of each of the present inventions 1 and 2.

### <Other layer constructions intermediate layer>

In the layer construction described in the above-mentioned section 4, an intermediate layer is placed between the layer (I) and the layer (II). As in the case of each of the present inventions 1 and 2, the formation of the intermediate layer can increase the entire thickness of the sheet for a solar cell, and can additionally improve the mechanical strength, the insulation characteristic, and the heat resistance.

A resin to be used in the intermediate layer, a preferred resin, and the like are the same as those in the case of each of the present inventions 1 and 2 except that the polyphenylene sulfide-based resin is not given as an example.

### <Other layer constructions polyphenylene sulfide (PPS) layer>

A polyphenylene sulfide layer may be provided, for example, between the layer (I) and the layer (II). The polyphenylene sulfide (PPS) to be used refers to a polymer having 80 mol% or more, preferably 90 mol% or more of a repeating unit represented by the following formula (1).

### [Chem. 1]

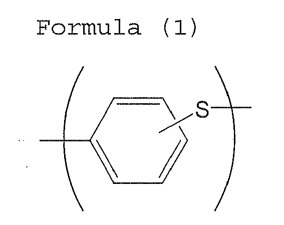

The above-mentioned polyphenylene sulfide may contain any other copolymerizable unit containing a sulfide bond as long as the unit accounts for less than 20 mol%, preferably less than 10 mol% of the repeatingunit. Examples of suchother copolymerizable unit containing a sulfide bond include a trifunctional unit, an ether unit, a sulfone unit, a ketone unit, a meta bond unit, an aryl unit having a substituent such as an alkyl group, a biphenyl unit, a terphenylene unit, a vinylene unit, and a carbonate unit. The polyphenylene sulfide can be constructed by using one of those units or by causing two or more thereof to coexist. In this case, the constitutional unit may be of each of a random type and a block type.
In addition, the polyphenylene sulfide, which may be a polymer having a branched chain or may be a polymer partially having a crosslinked structure, is preferably a straight-chain, linear polymer having a molecular weight of 50,000 or more in expressing its extrusion moldability and physical properties.

For the purpose of improving physical properties such as extrusion moldability, impact resistance, heat resistance, flame retardancy, and adhesiveness, there are preferably blended, in the above-mentioned polyphenylene sulfide, appropriate amounts of styrene-based resins such as general-purpose polystyrene (GPPS), high impact polystyrene (HIPS), acrylonitrile-butadiene-styrene (ABS), a hydrogenated styrene-butadiene-styrene block copolymer (SEBS), a styrene-butadiene-styrene block copolymer (SBS), and a hydrogenated styrene-isoprene-styrene block copolymer (SEPS), ethylene-based resins such as an ethylene/propylene copolymer, an ethylene/1-butene copolymer, an ethylene/propylene/non-conjugated diene copolymer, an ethylene/ethyl acrylate copolymer, an ethylene/glycidyl methacrylate copolymer, an ethylene/vinyl acetate/glycidyl methacrylate copolymer, and an ethylene/propylene-g-maleic anhydride copolymer, polyester-based resins such as a polyester-polyether elastomer and a polyester-polyester elastomer, and polyamide-based resins. Of those, the polyamide-based resin excellent in compatibility can be suitably used because compounding the resin enables the expression of good physical properties.

With regard to the addition amount of any such product, the product is preferably compounded in an appropriate amount within such a range as not to exceed the content (mass%) of the polyphenylene sulfide. For example, the content of each of a polystyrene-based resin and a polyethylene-based resin is 1 mass% or more, preferably 3 mass% or more, still more preferably 5 mass% or more. Compounding any such resin at a content within the range can improve melt processability and impact resistance. In addition, any such resin is preferably added at a content of 40 mass% or less, more preferably 30 mass% or less, more preferably 25 mass% or less, still more preferably 20 mass% or less because problems such as an excessive reduction in heat resistance and the inhibition of flame retardancy do not occur.

The polyphenylene sulfide is a resin excellent in flame retardancy because the polyphenylene sulfide has an aromatic ring and a sulfur atom in its unit skeleton.
Further, an improvement in flame retardancy can be achieved by adding, for example, a halogen-based flame retardant such as brominated biphenyl ether, a metal hydroxide flame retardant such as magnesium hydroxide, or an inorganic flame retardant such as a nitrogen-based compound or an antimony-based compound. Of those, any such phosphorus-based flame retardant as described in the above-mentioned section <Polyphenylene ether> is preferred from the viewpoints of, for example, an environmental load, the impartment of flame retardancy, and the securement of a mechanical strength.

In addition to the above-mentioned components, other additional components such as inorganic fillers including a carbon filler, a glass filler, talc, and mica for improving heat resistance and a mechanical strength, heat stabilizers, antioxidants, and plasticizers (e.g., oils, low-molecular weight polyethylenes, epoxidized soybean oils, polyethylene glycols, and aliphatic esters) for improving extrusion moldability, flame retardant aids for improving flame retardancy, weatherability (light fastness) improvers for improving durability, nucleating agents, and various colorants may each be added as required to such an extent that the feature and effect of the present invention are not impaired.

Although the above-mentioned polyphenylene sulfide-based resin composition using polyphenylene sulfide as a main component is formed by adding the above-mentioned various components to the polyphenylene sulfide, a commercial product in which the components have been mixed in advance may be used.
Examples of the commercially available polyphenylene sulfide-based resin composition include a "FORTRON 0220C9" and a "FORTRON 0220A9" manufactured by Polyplastics Co., Ltd., a "DIC.PPS LD10P11, a "DIC.PPS FZ2100," and a "DIC.PPS Z200E5" manufactured by DIC CORPORATION, and a "Ryton QC160N" and a "Ryton XE3202NA" manufactured by Chevron Phillips Chemical Company. Of those, a "FORTRON 0220C9" manufactured by Polyplastics Co., Ltd. can be particularly suitably used because it is excellent in moldability and mechanical physical properties.

It should be noted that the PPS is a crystalline resin. Accordingly, the resin must be subjected to a crystallization treatment in order that heat resistance to be described later may be obtained. The crystallization can be achieved by treating a noncrystalline sheet so that the sheet may have a temperature suitable for the crystallization (110°C to 230°C). Here, it is suitable that the heat treatment should be performed in a state in which a sheet end is constrained in order that a dimensional change in association with the crystallization may be suppressed. In addition, an improvement in productivity through an increase in crystallization rate can be achieved by adjusting the heat treatment temperature to the temperature at which the crystallization progresses rapidly (typically 150°C to 190°C) or by orienting the noncrystalline sheet to align molecules toward the same direction. Upon performance of the extrusion molding described in the foregoing, a temperature upon solidification of a resin ejected from a mouthpiece with a cooling roll is preferably set to the above-mentioned crystallization temperature because such setting enables one to obtain a crystallized sheet having a desired thickness while obviating the need for any post-step and is hence excellent in productivity.

### <Other layer constructions light-blocking colored layer>

In the layer construction described in the above-mentioned section 3, a light-blocking colored layer is provided for the inner surface. The light-blocking colored layer is used as a constituent on a side contacting a encapsulating material on the back surface side of a back sheet for a solar cell for the purposes of: reflecting sunlight that has passed through the solar cell to improve generation efficiency; and reflecting or absorbing ultraviolet light to prevent the deterioration of a constituent for the back sheet for the solar cell by ultraviolet light and to improve various characteristics of the back sheet such as weatherability, durability, heat resistance, thermal dimensional stability, and a strength. The same aspects as those of the light-reflective colored layer of each of the present inventions 1 and 2 can be adopted as specific aspects (such as a coloring method, a resin (details about specific examples thereof, a preferred resin, and the like), and a pigment).

In addition, a side to serve as an outer surface when the sheet is formed as a solar cell module may be subjected to a known hard coat treatment or antifouling treatment so as to be caused to express surface characteristics such as scratch resistance and antifouling property.

In the sheet for a solar cell formed of the layer construction whose contents have been described above, the use of a polyphenylene ether-based resin excellent in flame retardancy as the layer (I) can improve the flame retardancy of the entire sheet. The spread of fire upon occurrence of fire can be prevented by virtue of the flame retardancy. The sheet is evaluated for its flame retardancy by judging its burning behavior based on a burning test.
As described in the foregoing, the resin to be used in the layer (I) is a resin excellent in flame retardancy, and such a method as described below is available for additionally improving the flame retardancy. The content of the PPE in the layer (I) is raised, the addition amount of the flame retardant is raised, or the amount of a component such as a lubricant is reduced. Further, a method such as an increase in a ratio of the thickness of the layer (I) to the entire thickness is available.

As the sheet for a solar cell is exposed to an external environment as described in the foregoing, hydrolysis resistance as one aspect of durability is needed for stably protecting a solar cell element for a long time period. The sheet is evaluated for its hydrolysis resistance by measuring its physical properties after a promotion evaluation under an arbitrary environment in the same manner as in the present inventions 1 and 2. Therefore, the same approach as that of each of the present inventions 1 and 2 can be adopted for imparting the hydrolysis resistance. The same description as that in the case of each of the present inventions 1 and 2 is applicable to a mechanical strength typified by, for example, an elastic modulus in tension or a tensile elongation at break as well.

As described in the present inventions 1 and 2, the sheet must have heat resistance and show a small dimensional change in order that a trouble may be avoided in the step of forming the solar cell module. Its deflection temperature under load is preferably set to fall within the same temperature range as that of each of the present inventions 1 and 2 in order that the heat resistance may be expressed.

When the polyphenylene ether-based resin is used in the layer (I), the deflection temperature under load of a two-component blend system of a polyphenylene ether and a polystyrene generally changes in a linear fashion depending on a compounding ratio, and the deflection temperature under load changes from about 190°C to about 80°C as the content of the polyphenylene ether changes from 100% to 0%. Therefore, raising the content of the polyphenylene ether is effective in increasing the deflection temperature under load. Reducing the addition amount of, for example, a flame retardant or plasticizer which lowers the deflection temperature under load, blending a high-heat resistant resin such as a polyphenylene sulfide or a polyamide, or compounding an inorganic filler is also effective.

In addition, a treatment for forming irregularities on the surface of the sheet may be performed for the purposes of improving the sliding property of the surface and improving handleability at the time of the assembly or laying of the module. Arbitrary means such as a method involving embossing the film at the time of its molding, a method involving incorporating inorganic particles of silica, talc, or the like into the surface layer, or a method involving subjecting a layer containing inorganic particles to co-extrusion, cooling the layer to solidify the layer, and peeling the solidified layer may be employed for forming the irregularities on the surface. Of course, the surface may be smoothened by employing a known approach such as coating from the viewpoint of, for example, a design.

### (Sheet for solar cell of the present invention 4)

A sheet for a solar cell of the present invention 4 is a sheet to be used for constructing a solar cell module, and particular examples of the sheet include a front surface- or back surface-sealing sheet (front sheet or back sheet) and a substrate sheet. In particular, the sheet is a sheet for a solar cell that can be suitably used as a back sheet. The sheet for a solar cell of the present invention 4 is formed of a laminated sheet having at least one layer of each of at least a layer (I), a layer (II), and a layer (III), and the contents of the respective constituting layers are as described below.

### <Layer (I)>

The layer (I) is the same as the layer (I) according to the present invention 3.

### <Layer (II)>

The layer (II) in the sheet for a solar cell of the present invention 4 must be a layer having specific gas barrier property, and its water vapor permeability (measurement method: JIS K7129) must be less than 10 g/m²·24 hr. Although (a) the metal thin-film layer, (c) resin single-body layer, (d) resin layer containing flat inorganic particles, and (e) resin coating layer of the layer (II) are the same as those of the present invention 3, (b) the inorganic thin-film layer of the layer (II) differs from that of the present invention 3 in the following points.

First, in addition to those listed in (b) the inorganic thin-film layer of the present invention 3, a polyphenylene ether (PPE) or a polyphenylene sulfide (PPS) is also preferably used as a base material that forms the inorganic thin-film layer in terms of durability, flame retardancy, dimensional stability, and a mechanical strength.

The layer formed of a resin composition using a polyphenylene ether (PPE) as a main component in the layer (I) or the light-blocking colored layer in the layer (III) may also be used as the base material that forms the inorganic thin-film layer, and any such layer is preferred because of, for example, the following reason. The number of laminating steps can be reduced.

Further, the above-mentioned inorganic thin-film layer is preferably provided as a plurality of layers because high gas barrier property can be stably maintained and secured for a long time period under a harsh environment. At that time, various known film-forming methods may be combined. For example, the following multilayer inorganic thin film constructions are given: a vacuum-deposited film and a vacuum-deposited film, a vacuum-deposited film and a plasma CVD film, a vacuum-deposited film, a plasma-treated film, and a vacuum-deposited film, a vacuum-deposited film, a plasma CVD film, and a vacuum-deposited film, avacuum-depositedfilm, aCat-CVDfilm, andavacuum-deposited film, a vacuum-deposited film, a weatherproof coat film, and a vacuum-deposited film, a plasma CVD film and a vacuum-deposited film, or a plasma CVD film, a vacuum-deposited film, and a plasma CVD film are laminated in the stated order on a weatherproof coat layer. Of those, the plurality of layers formed of the vacuum-deposited film and the plasma CVD film are preferred in terms of good gas barrier property, adhesiveness, and productivity.

It should be noted that barrier property can be improved by superimposing a plurality of films each constructed of the inorganic thin-film layer and the base material according to, for example, a known dry lamination method.
The thickness of each inorganic thin-film layer, which is generally about 0.1 to 500 nm, is preferably 0.5 to 100 nm, more preferably 1 to 50 nm. As long as the thickness falls within the above-mentioned range, sufficient gas barrier property is obtained. In addition, the inorganic thin-film layer neither cracks nor peels, and excellent productivity is achieved.

When the gas barrier property layer as the above-mentioned layer (II) is formed as an inorganic thin-film layer on the base material, a method involving placing the weatherproof coat layer on the base material and then forming the inorganic thin-film layer is preferred because weatherability and gas barrier property can be improved.
The weatherproof coat layer is formed of at least one kind selected from (A) a crosslinked product of a polycaprolactone polyol and/or a polycarbonate polyol, (B) a crosslinked product of a denatured polyvinyl alcohol, and (C) an acrylic copolymer having at least one kind of group selected from the group consisting of a UV-stable group, a UV-absorbing group, and a cycloalkyl group.

### <(A) Cross-linked product of polycaprolactone polyol and/or polycarbonate polyol>

Conventionally, a polyester polyol or a polyether polyol is often used as an anchor coat agent, but the polyester polyol is apt to be hydrolyzed. A polycaprolactone polyol is excellent in water resistance as compared to adipate polyester polyol, and is excellent in weatherability and heat resistance as compared to the polyether polyol. In addition, a polycarbonate polyol is excellent in heat resistance, moisture resistance, and weatherability as compared to the polyester polyol and the polyether polyol. From the above-mentioned viewpoints, in the present invention, a cross-linked product of the polycaprolactone polyol and/or the polycarbonate polyol is used as a weatherproof coat agent.
The polycaprolactone polyol and the polycarbonate polyol can improve interlayer adhesiveness as compared to the polyester polyol by means of, for example, adjusting the degree of surface treatment such as corona treatment of a base material film, previously coating the base material film with an adhesion component such as a crosslinking agent alone or a silane-based coupling agent or a titanium-based coupling agent at a very small thickness, or increasing the blending ratio of a cross-linkable compound in a coating material, to thereby additionally improve the weather ability of the coat layer.

### <Polycaprolactone polyol>

The polycaprolactone polyol is produced by subjecting ε-caprolactone to ring opening polymerization with the following polyhydric alcohol as an initiator in the presence of a catalyst in accordance with a known method.
Examples of the polyhydric alcohol serving as the polymerization initiator for ε-caprolactone include ethylene glycol, diethylene glycol, 1,2-propylene glycol, dipropylene glycol, 1,3-butanediol, 1,4-butanediol, 1,6-hexanediol, neopentyl glycol, trimethylolpropane, glycerin, pentaerythritol, and polytetramethylene ether glycol. Further, there can also be used: aliphatic polyhydric alcohols such as polymerization products or copolymerization products obtained by subjecting ethylene oxide, propylene oxide, and butylene oxide to ring opening polymerization with those polyhydric alcohols as initiators; polyhydric alcohols each containing a cyclohexyl group including cyclohexanedimethanol, cyclohexanediol, and hydrogenated bisphenol A and polymerization products or copolymerization products obtained by subjecting ethylene oxide, propylene oxide, and butylene oxide to ring opening polymerization with these glycols as initiators; polyhydric alcohols each containing an aromatic group including bisphenol A, hydroquinone bis(2-hydroxyethyl ether), p-xylylene glycol, and bis(β-hydroxyethyl) terephthalate and polymerization products or copolymerization products obtained by subjecting ethylene oxide, propylene oxide, and butylene oxide to addition polymerization with these glycols as initiators; and polyhydric alcohols having various functional groups including glycols each having a carboxyl group, such as dimethylol propionic acid and diphenolic acid, and glycols each having a tertiary amine, such as N-methyldiethanolamine.

### <Polycarbonate polyol>

The polycarbonate polyol can be produced by a known method. As a polycarbonatediol, there are preferably used aliphatic diols each having 2 to 12 carbon atoms, such as 1,4-butanediol, 1,5-pentanediol, 1,6-hexanediol, 1,8-octanediol, and 1,10-decanediolor a polycarbonatediolobtained by causing diphenyl carbonate or phosgene to act on a mixture of those diols to perform polycondensation.

In view of compatibility with an organic solvent and a crosslinking agent, preferred is an ether-modified polycarbonate polyol having the repeating structural unit -[(CH₂)₃-OC(O)O]- or -[(CH₂)₂C(CH₃)(CH₂)₂-OC(O)O]- obtained by causing a polyalkylene carbonate polyol having a number average molecular weight of 10, 000 or less, preferably 500 to 5,000 and a polyethylene glycol monoalkyl ether having a number average molecular weight of 5,000 or less to react with each other. It should be noted that the number average molecular weight is a value in gel permeation chromatography in terms of polystyrene as described above.
In addition, the polycarbonate polyol has a terminal hydroxyl group index of preferably 92.5 to 98.5, more preferably 95.0 to 97.5 in order that a crosslinking reaction between the polyol and the crosslinking agent may be homogeneously performed, that is, the polyol may be prevented from partially having an increased molecular weight, and that the molecular weight distribution of the product and its hydrolysis resistance after the crosslinking may be controlled. It should be noted that the terminal hydroxyl group index is a ratio of the peak area of the polyol to the sum of the peak areas of a monoalcohol and the polyol analyzed by gas chromatography, the ratio being represented in a percentage unit. The analysis by gas chromatography was performed with a flame ionization detector (FID) by increasing the temperature of the polyol from 40°C to 220°C at 10°C/min and holding the temperature at the value for 15 minutes.

### <Crosslinking agent>

A crosslinking agent for obtaining the crosslinked product of the polycaprolactone polyol and/or the polycarbonate polyol is not particularly limited as long as the crosslinking agent is a compound or polymer containing, per one molecule, two or more functional groups each of which undergoes a crosslinking curing reaction with a hydroxyl group which the polycaprolactone polyol and/or the polycarbonate polyol described above each have/has, and one kind or two or more kinds of such agents can be appropriately selected and used.
Examples of the crosslinking agent include a compound or polymer having a phenol group, an epoxy group, a melamine group, an isocyanate group, or a dialdehyde group. In view of a crosslinking reactivity and a pot life, a compound or polymer containing an epoxy group, a melamine group, or an isocyanate group is preferred, and in view of pot life control, an isocyanate compound and/or an epoxy compound is more preferred. In particular, an isocyanate compound, which is a two-part reactive coat agent, is desirable in view of the reactivity of each component and weatherability derived from the reactivity, and the hardness and flexibility of the coat layer.

### <(B) Cross-linked product of modified polyvinyl alcohol>

Examples of the modified polyvinyl alcohol include a resin obtained by modifying a hydroxyl group of polyvinyl alcohol into a silanol group, a silyl group, an amino group, an ammonium group, an alkyl group, an isocyanate group, an oxazoline group, a methylol group, a nitrile group, an acetoacetyl group, a cation group, a carboxyl group, a carbonyl group, a sulfone group, a phosphoric acid group, acetal group, a ketal group, a carboxylic acid ester group, or a cyanoethyl group. Of those, modification through acetoacetalization or butyralization is preferred in view of water resistance under high temperature and high humidity.
In addition, the denatured polyvinyl alcohol has a remaining hydroxyl group, and hence its water resistance can be additionally improved by crosslinking the hydroxyl group.

### <Polyvinyl butyral>

A polyvinyl butyral as a denatured body obtained by the above-mentionedbutyralation, which can be produced by a known method, is desirably a polyvinyl butyral having a degree of butyralation of preferably 50 to 80 mol%, more preferably 60 to 75 mol%, and a remaining isotactic triad-type hydroxyl group content of preferably 1 mol% or less, more preferably 0.5 mol% or less in order that a uniform coat layer having good weatherability and improved solvent solubility may be obtained.
The weatherability and solvent solubility of the polyvinyl butyral depend on its degree of butyralation, and the degree of butyralation is desirably high. However, not 100 mol% of the polyvinyl alcohol can be subjected to butyralation, and to increase the degree of butyralation to an absolute maximum is not efficient in terms of industrial production. In addition, the solvent compatibility of the polyvinyl butyral changes depending on the kind of remaining hydroxyl group, and when its isotactic triad-type hydroxyl group content is large, its solubility in an organic solvent is poor.

### <Polyvinyl acetoacetal>

In addition, a polyvinyl acetoacetal as a denatured body obtained by the above-mentioned acetoacetalation, which can be produced by a known method, desirably has a high degree of acetalation in terms of heat resistance, and the degree of acetalation is preferably 50 to 80 mol%, more preferably 65 to 80 mol%. In order that a polyvinyl acetoacetal resin having a narrow particle diameter distribution may be obtained for forming a uniform coat layer having improved solvent solubility, it is desirable that: an aldehyde having 3 or more carbon atoms be mixed in an appropriate amount; and an acetalated product be held at an appropriate temperature after its precipitation.

### <Crosslinking agent>

A crosslinking agent for obtaining the crosslinked product of the denatured polyvinyl alcohol is not particularly limited as long as the crosslinking agent is a compound or polymer containing, peronemolecule, two or more functional groups each of which undergoes a crosslinking curing reaction, and one kind or two or more kinds of such agents can be appropriately selected and used depending on the kind of functional group which the above-mentioned denatured polyvinyl alcohol has.
For example, when the crosslinkable compound is crosslinked with a hydroxyl group of the denatured polyvinyl alcohol, examples of the crosslinkable compound include a compound or polymer having a phenol group, an epoxy group, a melamine group, an isocyanate group, or a dialdehyde group. In view of a crosslinking reactivity and a pot life, a compound or polymer containing an epoxy group, a melamine group, or an isocyanate group is preferred, and in view of pot life control, a compound or polymer containing an isocyanate group is particularly preferred.

< (C) Acrylic copolymer having at least one kind of group selected from group consisting of UV-stable group, UV-absorbing group, and cycloalkyl group>
A method involving incorporating a UV stabilizer or a UV absorber is generally available as a method of imparting weatherability to a polymer. However, each of the stabilizer and the absorber, which have relatively low molecular weights, bleeds out of a main material during its long-term use, and hence the weatherability is hardly maintained. In the weatherproof coat layer, a UV-stable group or a UV-absorbing group is copolymerized with a cycloacryl group having water resistance. As a result, the layer can show its weatherability for a long time period without causing the bleedout.

The above-mentioned UV-stable group has actions of capturing a generated radical and inactivating the radical, and specifically, a hindered amine group is preferably given as an example of the group in terms of the foregoing. That is, a stable nitroxy radical generated on the hindered amine group is bonded to an active polymer radical, and then the radical itself returns to the original stable nitroxy radical; the foregoing is repeated.
In addition, the UV-absorbing group suppresses the generation of a radical by absorbing applied ultraviolet light, and specifically, a benzotriazole group and/or a benzophenone group are each/is preferably given as an example of the group in terms of the foregoing.
The cycloalkyl group has an action of imparting water resistance and water vapor permeation resistance to a resin such as an acrylic copolymer which constructs the weatherproof coat layer.

Therefore, the deterioration of the gas barrier property of the gas barrier property film can be prevented by using a resin such as an acrylic copolymer having at least one kind of group selected from the group consisting of a UV-stable group, a UV-absorbing group, and a cycloalkyl group in the coat layer. In the present invention, a synergistic effect in terms of weatherability can be obtained by bringing together the UV-stable group, the UV-absorbing group, and the cycloalkyl group.
The above-mentioned acrylic copolymer can be obtained by copolymerizing at least one kind selected from the group consisting of at least a polymerizable UV-stable monomer, a polymerizable UV-absorbing monomer, and a cycloalkyl (meth)acrylate.

### <Polymerizable UV-stable monomer>

The polymerizable UV-stable monomer preferably has a hindered amine group, and more preferably has, in a molecule thereof, at least one of each of a hindered amine group and a polymerizable unsaturated group.
The polymerizable UV-stable monomer is preferably a compound represented by the following general formula (2) or (3).

### [Chem. 2]

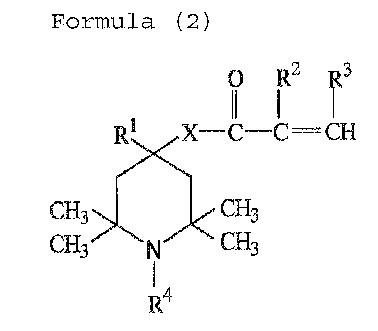

(In the general formula (2), R¹ represents a hydrogen atom or a cyano group, R² and R³ each independently represent a hydrogen atom or a hydrocarbon group having 1 or 2 carbon atoms, R⁴ represents a hydrogen atom or a hydrocarbon group having 1 to 18 carbon atoms, and X represents an oxygen atom or an imino group.)

### [Chem. 3]

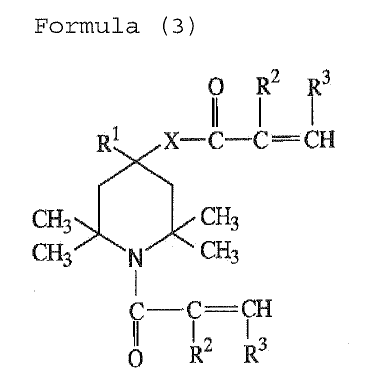

(In the general formula (3), R¹ represents a hydrogen atom or a cyano group, R² and R³ each independently represent a hydrogen atom or a hydrocarbon group having 1 or 2 carbon atoms, and X represents an oxygen atom or an imino group.)

In the UV-stable monomer represented by the general formula (2) or (3), specific examples of the hydrocarbon group having 1 to 18 carbon atoms represented by R⁴ include: chain hydrocarbon groups such as a methyl group, an ethyl group, a propyl group, an isopropyl group, a butyl group, an isobutyl group, a t-butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, and an octadecyl group; alicyclic hydrocarbon groups such as a cyclopropyl group, a cyclopentyl group, a cyclohexyl group, a cycloheptyl group, and a cyclooctyl group; and aromatic hydrocarbon groups such as a phenyl group, a tolyl group, a xylyl group, a benzyl group, and a phenethyl group. Of those, in the present invention, R⁴ preferably represents a hydrogen atom or a methyl group in view of light stability.
Examples of the hydrocarbon group having 1 or 2 carbon atoms represented by each of R² and R³ include a methyl group and an ethyl group. Of those, a methyl group is preferred.

Specific examples of the UV-stable monomer represented by the general formula (2) include 4-(meth)acryloyloxy-2,2,6,6-tetramethylpiperidine, 4-(meth)acryloylamino-2,2,6,6-tetramethylpiperidine, 4-(meth)acryloyloxy-1,2,2,6,6-pentamethylpiperidine, 4-(meth)acryloylamino-1,2,2,6,6-pentamethylpiperidine, 4-cyano-4-(meth)acryloylamino-2,2,6,6-tetramethylpiperidine, 4-crotonoyloxy-2,2,6,6-tetramethylpiperidine, and 4-crotonoylamino-2,2,6,6-tetramethylpiperidine. Of those, in the present invention, in view of light stability, 4-(meth)acryloyloxy-2,2,6,6-tetramethylpiperidine, 4-(meth)acryloylamino-2,2,6,6-tetramethylpiperidine, 4-(meth)acryloyloxy-1,2,2,6,6-pentamethylpiperidine, and 4-(meth)acryloylamino-1,2,2,6,6-pentamethylpiperidine are preferred, and 4-methacryloyloxy-2,2,6,6-tetramethylpiperidine and 4-methacryloyloxy-1,2,2,6,6-pentamethylpiperidine are more preferred. Only one kind of those monomers may be used, or an appropriate mixture of two or more kinds thereof may be used. The UV-stable monomer represented by the general formula (2) is not limited to those compounds as a matter of course.

Specific examples of the UV-stable monomer represented by the general formula (3) include 1-(meth)acryloyl-4-(meth)acryloylamino-2,2,6,6-tetramethylpipe ridine, 1-(meth)acryloyl-4-cyano-4-(meth)acryloylamino-2,2,6,6-tetrame thylpiperidine, and 1-crotonoyl-4-crotonoyloxy-2,2,6,6-tetramethylpiperidine. Of those, in the present invention, in view of general-purpose properties of raw materials, 1-acryloyl-4-acryloylamino-2,2,6,6-tetramethylpiperidine and 1-methacryloyl-4-methacryloylamino-2,2,6,6-tetramethylpiperidi ne are preferred, and 1-methacryloyl-4-methacryloylamino-2,2,6,6-tetramethylpiperidi ne is more preferred. Only one kind of those monomers may be used, or an appropriate mixture of two or more kinds thereof may be used. It should be noted that the UV-stable monomer represented by the general formula (3) is not limited to those monomers.

The above-mentioned polymerizable UV-stable monomer is preferably incorporated at a content of 0.1 to 50 mass% into all polymerizable monomer components for obtaining the acrylic copolymer in terms of light stability. The monomer is incorporated at a content within the range of more preferably 0.2 to 10 mass%, still more preferably 0.5 to 5 mass%. As long as the content falls within the above-mentioned range, weatherability is sufficiently exerted.

### <Polymerizable UV-absorbing monomer>

Preferred examples of the polymerizable UV-absorbing monomer to be used in the present invention 4 include polymerizable benzotriazoles and/or polymerizable benzophenones.

### <Polymerizable benzotriazoles>

Preferred specific examples of the polymerizable benzotriazoles in the present invention include compounds each represented by the following general formula (4) or (5).

### [Chem. 4]

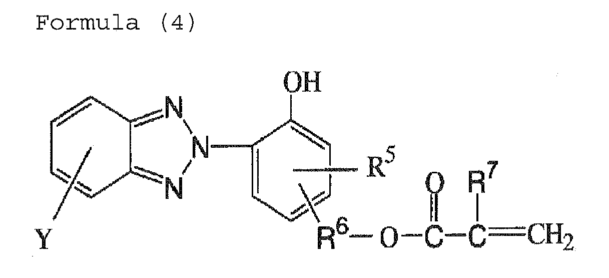

(In the general formula (4), R⁵ represents a hydrogen atom or a hydrocarbon group having 1 to 8 carbon atoms, R⁶ represents a lower alkylene group, R⁷ represents a hydrogen atom or a methyl group, and Y represents a hydrogen atom, a halogen atom, a hydrocarbon group having 1 to 8 carbon atoms, a lower alkoxy group, a cyano group, or a nitro group.)

### [Chem. 5]

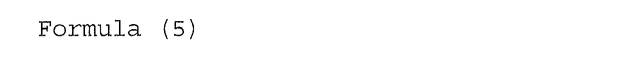

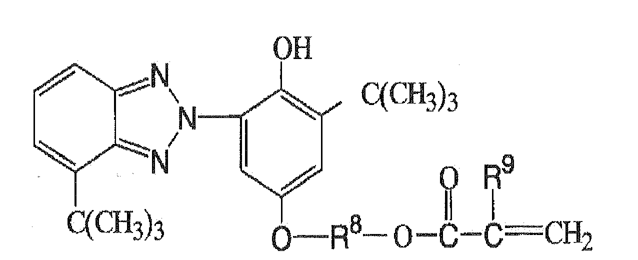

(In the general formula (5), R⁸ represents an alkylene group having 2 or 3 carbon atoms and R⁹ represents a hydrogen atom or a methyl group.)

Specific examples of the hydrocarbon group having 1 to 8 carbon atoms represented by R⁵ in the general formula (4) include: chain hydrocarbon groups such as a methyl group, an ethyl group, a propyl group, an isopropyl group, a butyl group, an isobutyl group, a t-butyl group, a pentyl group, a hexyl group, a heptyl group, and an octyl group; alicyclic hydrocarbon groups such as a cyclopropyl group, a cyclopentyl group, a cyclohexyl group, a cycloheptyl group, and a cyclooctyl group; and aromatic hydrocarbon groups such as a phenyl group, a tolyl group, a xylyl group, a benzyl group, and a phenethyl group. R⁵ preferably represents a hydrogen atom or a methyl group.

The lower alkylene group represented by R⁶ preferably represents an alkylene group having 1 to 6 carbon atoms, and specific examples thereof include linear alkylene groups such as a methylene group, an ethylene group, a propylene group, a butylene group, a pentylene group, and a hexylene group, and branched alkylene groups such as an isopropylene group, an isobutylene group, an s-butylene, a t-butylene group, an isopentylene group, and a neopentylene group. Of those, a methylene group, an ethylene group, and a propylene group are preferred.
Examples of the substituent represented by Y include : hydrogen; halogens such as fluorine, chlorine, bromine, and iodine; the hydrocarbon group having 1 to 8 carbon atoms represented by R⁵; lower alkoxy groups each having 1 to 8 carbon atoms such as a methoxy group, an ethoxy group, a propoxy group, a butoxy group, a pentoxy group, and a heptoxy group; a cyano group; and a nitro group. Of those, a hydrogen atom, a chlorine atom, a methoxy group, a t-butyl group, a cyano group, and a nitro group are preferred in view of a reactivity.

Specific examples of the UV-absorbing monomer represented by the general formula (4) include 2-[2'-hydroxy-5'-(methacryloyloxymethyl)phenyl]-2H-benzotriazole, 2-[2'-hydroxy-5'-(methacryloyloxyethyl)phenyl]-2H-benzotriazole, 2-[2'-hydroxy-3'-t-butyl-5'-(methacryloyloxyethyl)phenyl]-2H-benzotriazole, 2-[2'-hydroxy-5'-t-butyl-3'-(methacryloyloxyethyl)phenyl]-2H-benzotriazole, 2-[2'-hydroxy-5'-(methacryloyloxyethyl)phenyl]-5-chloro-2H-benzotriazole, 2-[2'-hydroxy-5'-(methacryloyloxyethyl)phenyl]-5-methoxy-2H-benzotriazole, 2-[2'-hydroxy-5'-(methacryloyloxyethyl)phenyl]-5-cyano-2H-benzotriazole, 2-[2'-hydroxy-5'-(methacryloyloxyethyl)phenyl]-t-butyl-2H-benzotriazole, and 2-[2'-hydroxy-5'-(methacryloyloxyethyl)phenyl]-5-nitro-2H-benzotriazole. Of those, in view of UV-absorbing property, 2-[2'-hydroxy-5'-(methacryloyloxymethyl)phenyl]-2H-benzotriazole, 2-[2'-hydroxy-5'-(methacryloyloxyethyl)phenyl]-2H-benzotriazole, 2-[2'-hydroxy-3'-t-butyl-5'-(methacryloyloxyethyl)phenyl]-2H-benzotriazole, and 2-[2'-hydroxy-5'-(methacryloyloxyethyl)phenyl]-t-butyl-2H-benzotriazole are preferred, and 2-[2'-hydroxy-5'-(methacryloyloxymethyl)phenyl]-2H-benzotriazo le and 2-[2'-hydroxy-5'-(methacryloyloxyethyl)phenyl]-2H-benzotriazole are more preferred. Only one kind of those UV-absorbing monomers each represented by the general formula (4) may be used, or an appropriate mixture of two or more kinds thereof may be used.

In addition, in the UV-absorbing monomer represented by the general formula (5), the alkylene group having 2 or 3 carbon atoms represented by R⁸ in the formula is specifically an ethylene group, a trimethylene group, a propylene group, or the like.
Examples of the UV-absorbing monomer represented by the general formula (5) include 2-[2'-hydroxy-5'-(β-methacryloyloxyethoxy)-3'-t-butylphenyl]-4-t-butyl-2H-benzotriazole, 2-[2'-hydroxy-5'-(β-acryloyloxyethoxy)-3'-t-butylphenyl]-4-t-butyl-2H-benzotriazole, 2-[2'-hydroxy-5'-(β-methacryloyloxy n-propoxy)-3'-t-butylphenyl]-4-t-butyl-2H-benzotriazole, and 2-[2'-hydroxy-5'-(β-methacryloyloxy i-propoxy)-3'-t-butylphenyl]-4-t-butyl-2H-benzotriazole. Of those, 2-[2'-hydroxy-5'-(β-methacryloyloxyethoxy)-3'-t-butylphenyl]-4 -t-butyl-2H-benzotriazole is preferred in view of UV-absorbing property. Only one kind of those UV-absorbing monomers each represented by the general formula (5) may be used, or an appropriate mixture of two or more kinds thereof may be used.

### <Polymerizable benzophenones>

Examples of the polymerizable benzophenones to be used as the polymerizable UV-absorbing monomer include monomers each obtained by causing 2,4-dihydroxybenzophenone or 2,2',4-trihydroxybenzophenone and glycidyl acrylate or glycidyl methacrylate to react with each other, such as 2-hydroxy-4-(3-methacryloyloxy-2-hydroxy-propoxy)benzophenone, 2-hydroxy-4-(3-acryloyloxy-2-hydroxy-propoxy)benzophenone, 2,2'-dihydroxy-4-(3-methacryloyloxy-2-hydroxypropoxy)benzophen one, and 2,2'-dihydroxy-4-(3-acryloyloxy-2-hydroxypropoxy)benzophenone. Of those, 2-hydroxy-4-(3-methacryloyloxy-2-hydroxypropoxy)benzophenone is preferred in view of general-purpose properties of raw materials.

The polymerizable UV-absorbing monomer is used for additionally improving the weatherability of the coat layer containing the acrylic copolymer to be obtained, and its content in all the polymerizable monomer components is as described below. In the case of the polymerizable benzotriazoles, the content is preferably 0.1 to 50 mass%, more preferably 0.5 to 40 mass%, still more preferably 1 to 30 mass% in terms of sufficient UV-absorbing performance and the prevention of coloring due to ultraviolet irradiation. In the case of the polymerizable benzophenones, the content is preferably 0.1 to 10 mass%, more preferably 0.2 to 5.0 mass% in terms of sufficient UV-absorbing performance and good compatibility.

### <Cycloalkyl (meth)acrylate>

A cycloalkyl (meth) acrylate is a component used for improving the hardness, elasticity, solvent resistance, gasoline resistance, and weatherability of a coating film particularly when the resultant acrylic copolymer is used for a two-part urethane resin paint. Preferred examples of the cycloalkyl (meth)acrylate include cyclohexyl (meth)acrylate, methylcyclohexyl (meth)acrylate, t-butylcyclohexyl (meth) acrylate, and cyclododecyl (meth) acrylate. One kind or a combination of two or more kinds of those cycloalkyl (meth) acrylates may be used. The cycloalkyl (meth) acrylate is used at a content within the range of preferably 5 to 80 mass%, more preferably 10 to 70 mass%, still more preferably 15 to 50 mass% in the polymerizable monomer components. A usage within the above-mentioned range is preferred because the performance of a coating film such as a hardness or weatherability is sufficiently exerted, and compatibility between its drying property and leveling property is achieved.

### <Crosslinkable functional group>

The above-mentioned weatherproof coat layer is preferably formed by the crosslinking of a crosslinkable functional group which the acrylic copolymer has and a crosslinking agent. In this case, the above-mentioned acrylic copolymer has a crosslinked structure, and hence the physical properties and weatherability of the coat layer are improved. As a result, excellent weathering performance is maintained over a long time period.
Examples of the crosslinkable functional group possessed by the above-mentioned acrylic copolymer include a hydroxyl group, an amino group, a carboxyl group or anhydride thereof, an epoxy group, and an amide group. Only one kind of those crosslinkable functional groups may exist, or two or more kinds thereof may exist in the acrylic copolymer. In the present invention, of those crosslinkable functional groups, a group having active hydrogen, such as a hydroxyl group, an amino group, or a carboxyl group is preferred in view of stability.

Examples of the polymerizable unsaturated monomer containing a hydroxyl group include (meth)acrylic monomers each having a hydroxyl group, such as hydroxyethyl (meth)acrylate, hydroxypropyl (meth)acrylate, caprolactone-modified hydroxy (meth) acrylate, and mono (meth) acrylate of polyester diol obtained from phthalic acid and propylene glycol. Of those, hydroxypropyl acrylate and hydroxyethyl methacrylate are preferred. One kind or a combination of two or more kinds of those monomers may be used.
A polymerizable monomer containing a crosslinkable functional group is a component needed for a reaction with any other crosslinkable compound typified by a polyisocyanate when the acrylic copolymer to be obtained is compounded with such crosslinkable compound so that a resin composition for a thermosetting paint may be obtained, and the monomer is used at a content within the range of 2 to 35 mass%, preferably 3.5 to 23 mass% in all the polymerizable monomer components. As long as the usage falls within the above-mentioned range, the amount of a crosslinkable functional group in the acrylic copolymer to be obtained is appropriate, reactivity between the acrylic copolymer and the crosslinkable compound is maintained, a crosslink density becomes sufficient, and target coating film performance is obtained. In addition, storage stability after the compounding of the crosslinkable compound is good.

<Other polymerizable unsaturated monomers> In the present invention 4, any other polymerizable unsaturated monomer for forming the acrylic copolymer can be used.
Examples of the other polymerizable unsaturated monomer to be used in the present invention 4 include: (meth) acrylic acid alkyl esters such as methyl (meth) acrylate, ethyl (meth)acrylate, propyl (meth)acrylate, isopropyl (meth)acrylate, butyl (meth)acrylate, isobutyl (meth)acrylate, tertiary-butyl (meth)acrylate, 2-ethylhexyl (meth)acrylate, lauryl (meth)acrylate, and stearyl (meth)acrylate; epoxy group-containing unsaturated monomers such as glycidyl (meth)acrylate; nitrogen-containing unsaturated monomers such as (meth)acrylamide, N,N'-dimethylaminoethyl (meth)acrylate, vinylpyridine, and vinylimidazole; halogen-containing unsaturated monomers such as vinyl chloride and vinylidene chloride; aromatic unsaturated monomers such as styrene, α-methylstyrene, and vinyltoluene; vinyl esters such as vinyl acetate; vinyl ether; and unsaturated cyanide compounds such as (meth)acrylonitrile. One kind or two or more kinds selected from the group of those monomers may be used.

In addition, in view of an internal catalytic action during a crosslinking reaction, a polymerizable unsaturated monomer containing an acidic functional group can also be used, and examples thereof include: carboxyl group-containing unsaturated monomers such as (meth)acrylic acid, crotonic acid, itaconic acid, maleic acid, and maleic anhydride; sulfonic acid group-containing unsaturated monomers such as vinylsulfonic acid, styrenesulfonic acid, and sulfoethyl (meth)acrylate; acidic phosphoric acid ester-based unsaturated monomers such as 2- (meth) acryloyloxyethyl acid phosphate, 2-(meth)acryloyloxypropyl acid phosphate, 2-(meth)acryloyloxy-2-chloropropyl acid phosphate, and 2-methacryloyloxyethylphenylphosphoric acid. One kind or two or more kinds selected from the group of those monomers may be used.

Any such other polymerizable monomer as described above can be used as required to such an extent that an action of the acrylic copolymer in the present invention is not impaired, and its usage can be set to 0 to 92.9 mass% in the polymerizable monomer components. In addition, a polymerizable monomer containing an acidic functional group out of the other polymerizable monomers serves as an internal catalyst when the acrylic copolymer undergoes a crosslinking reaction with the crosslinking agent, and its content canbe set to 0 to 5 mass%, preferably 0.1 to 3 mass% in the polymerizable monomer components.

### <Method of polymerizing acrylic copolymer>

A method of obtaining the acrylic copolymer with the above-mentioned monomers is not particularly limited, and a conventionally known polymerization method can be employed.
For example, when a solution polymerization method is adopted, examples of the solvent to be used include: toluene, xylene, and other high-boiling aromatic solvents; ester-based solvents such as ethyl acetate, butyl acetate, cellosolve acetate, and propylene glycol monomethyl ether acetate; ketone-based solvents such as methyl ethyl ketone and methyl isobutyl ketone; aliphatic alcohols such as isopropanol, n-butanol, and isobutanol; and alkylene glycol monoalkyl ethers such as propylene glycol monomethyl ether, propylene glycol monoethyl ether, and diethylene glycol monoethyl ether. One kind or a mixture of two or more kinds of those solvents may be used.

In addition, examples of the polymerization initiator include general radical polymerization initiators such as 2,2'-azobis-(2-methylbutyronitrile), t-butylperoxy-2-ethylhexanoate, 2,2'-azobisisobutyronitrile, benzoyl peroxide, and di-t-butyl peroxide. Those initiators may be used alone or in combination of two or more kinds thereof. The usage of the polymerization initiator is not particularly limited and can be appropriately set depending on desired characteristics of the acrylic resin.
Reaction conditions such as a reaction temperature and a reaction time are not particularly limited, and the reaction temperature falls within the range of, for example, room temperature to 200°C, preferably 40 to 140°C. The reaction time can be appropriately set depending on the composition of the monomer components and the kind of polymerization initiator so that the polymerization reaction may be completed.

### <Crosslinking agent>

A crosslinking agent is not particularly limited as long as the crosslinking agent is a compound or polymer containing, per one molecule, two or more functional groups each of which undergoes a crosslinking curing reaction with the crosslinkable functional group described above, and one kind or two or more kinds of such agents can be appropriately selected and used depending on the kind of functional group which the above-mentioned acrylic copolymer has.
For example, when the crosslinkable group which the acrylic copolymer has is a hydroxyl group, examples of the crosslinking agent include a compound or polymer having a phenol group, an epoxy group, a melamine group, an isocyanate group, or a dialdehyde group. In view of a crosslinking reactivity and a pot life, a compound or polymer containing an epoxy group, a melamine group, or an isocyanate group is preferred, and in view of pot life control, a compound or polymer containing an isocyanate group is particularly preferred.

When the crosslinkable functional group which the acrylic copolymer has is a carboxyl group or an anhydride thereof, examples of the crosslinking agent include crosslinkable compounds such as a polyisocyanate compound or a denatured product thereof, an aminoplast resin, and an epoxy resin. When the crosslinkable functional group is an epoxy group, examples of the crosslinking agent include crosslinking agents each containing a compound such as an amine, a carboxylic acid, an amide, or an N-methylol alkyl ether. When the crosslinkable functional group is a hydroxyl group or an amino group, examples of the crosslinking agent include crosslinking agents such as a polyisocyanate compound or a denatured product thereof, an epoxy resin, and an aminoplast resin. Of those, a polyisocyanate compound and/or an epoxy resin are each/ is preferred when used in combination with a group having active hydrogen.
In the above-mentioned acrylic copolymer, such a combination that the crosslinkable functional group is a hydroxyl group and the crosslinking agent is an isocyanate compound is desirable as a two-part reactive coat agent in terms of the reactivity of each component and weatherability derived from the reactivity, and the hardness and flexibility of the coat layer.

### <Cross-linking agent in weatherproof coat layer>

As described above, in the weatherproof coat layer of the gas barrier property layer, an isocyanate compound is preferably used as a crosslinking agent. A polyisocyanate is preferably used as the isocyanate compound. The polyisocyanate may be one kind of a diisocyanate, a dimer thereof (uretdione), a trimer thereof (isocyanurate, triol adduct, biuret), and the like, or a mixture of two or more kinds thereof. Examples of the diisocyanate component include 2,4-tolylene diisocyanate, 2,6-tolylene diisocyanate, p-phenylene diisocyanate, diphenylmethane diisocyanate, m-phenylene diisocyanate, hexamethylene diisocyanate, tetramethylene diisocyanate, 3,3'-dimethoxy-4,4'-biphenylene diisocyanate, 1,5-naphthalene diisocyanate, 2,6-naphthalene diisocyanate, 4,4'-diisocyanatodiphenyl ether, 1,5-xylylene diisocyanate, 1,3-diisocyanatomethylcyclohexane, 1,4-diisocyanatomethylcyclohexane, 4,4'-diisocyanatocyclohexane, 4,4'-diisocyanatocyclohexylmethane, isophorone diisocyanate, a dimer acid diisocyanate, and norbornene diisocyanate. In addition, xylene diisocyanate (XDI)-based, isophorone diisocyanate (IPDI)-based, and hexamethylene diisocyanate (HDI)-based components and the like are preferred in view of non-yellowing property. In addition, an isocyanurate body or biuret body of hexamethylene diisocyanate is preferred in view of fastness, gas barrier property, and weatherability.

The epoxy compound is not particularly limited as long as the compound has two or more epoxy groups per molecule, and examples thereof include sorbitol polyglycidyl ether, sorbitan polyglycidyl ether, polyglycerol polyglycidyl ether, pentaerythritol polyglycidyl ether, triglycidyl, tris(2-hydroxyethyl) isocyanurate, neopentyl glycol diglycidyl ether, 1,6-hexanediol diglycidyl ether, ethylene glycol diglycidyl ether, and an bisphenol-type epoxy resin.

Although the usage of the above-mentioned crosslinking agent is not particularly limited and can be appropriately determined depending on, for example, the kind of the crosslinking agent, a reactive group ratio between the crosslinkable group (such as a hydroxyl group) of the above-mentioned polycaprolactone polyol, the above-mentioned polycarbonate polyol, the above-mentioned denatured polyvinyl alcohol, or the above-mentioned acrylic copolymer and the crosslinking group of the crosslinkable compound "hydroxyl group:crosslinking group" is desirably 1:1 to 1:20 in terms of an intralayer cohesive force and interlayer adhesiveness, and is preferably 1:1 to 1:10. A crosslinking group ratio within the above-mentioned range is advantageous in terms of, for example, adhesiveness, high-temperature, high-humidity resistance, gas barrier property, and blocking resistance.
In addition, one or two or more kinds of crosslinking catalysts such as salts, inorganic substances, organic substances, acid substances, and alkali substances maybe added to the above-mentioned crosslinking agent for accelerating the crosslinking reaction. For example, when a polyisocyanate compound is used as the crosslinking agent, one or two or more kinds of known catalysts such as dibutyltin dilaurate and a tertiary amine may be added.
In addition, the crosslinking agent may contain a silane-based coupling agent, a titanium-based coupling agent, a light screening agent, a UV absorber, a stabilizer, a lubricant, ablocking inhibitor, an antioxidant, and the like, or a crosslinking agent obtained by copolymerizing those components with the above-mentioned resin may be used.

### <Method of forming weatherproof coat layer>

The weatherproof coat layer can be formed by appropriately adopting a known coating method. For example, any method such as a coating method involving using a reverse roll coater, a gravure coater, a rod coater, an air doctor coater, a spray, or a brush can be used. After the application, the solvent can be evaporated by employing a known drying method such as hot-air drying at a temperature of about 80 to 200°C, heat drying such as heat roll drying, or infrared drying. In addition, a crosslinking treatment by electron beam irradiation can be performed for improving water resistance and durability.

The weatherproof coat layer has a thickness of preferably about 0.005 to 5 µm, more preferably 0.01 to 1 µm. A thickness of 5 µm or less as described above is preferred because good sliding property is obtained and nearly no peeling from the base material film due to the internal stress of the weatherproof coat layer itself occurs. In addition, a thickness of 0.005 µm or more is preferred because a uniform thickness can be maintained.
In addition, the particles that form the inorganic thin-film layer densely deposit by virtue of the smoothening of the surface of the base material film with the weatherproof coat layer, and the layer can be easily formed so as to have a uniform thickness. Accordingly, high gas barrier property can be obtained.

### <Layer (III)>

In the sheet for a solar cell of the present invention 4, the layer (III) is a light-blocking colored layer, and is generally used as a constituent on a side contacting a encapsulating resin layer side as a back sheet for a solar cell for the purposes of: reflecting sunlight that has passed through the solar cell to improve generation efficiency;and reflecting or absorbing ultraviolet light to prevent the deterioration of a constituent for the sheet for the solar cell by ultraviolet light and to improve various characteristics of the sheet such as weatherability, durability, heat resistance, thermal dimensional stability, and a strength. Providing light-blocking property by whitening is particularly effective in terms of the improvement in generation efficiency by causing the layer to reflect sunlight and reusing the light that has passed through a solar cell.
Further, the design and decoration of a solar cell module can be improved by providing light-blocking property by coloring the layer in various ways typified by blackening and bluing.
It should be noted that the term "light reflection" in the light-blocking colored layer comprehends light scattering as well as light reflection.

The light-blocking colored layer has a maximum light transmittance for a wavelength region of 300 nm to 400 nm of preferably less than 10%, more preferably less than 5%, still more preferably less than 1% in order that the layer may be caused to reflect or absorb light beams to prevent deterioration by ultraviolet light.
In addition, the layer has an average reflectance in a region of 500 nm to 700 nm where the absorption intensity of a general solar cell exists of preferably 50% or more, more preferably 60% or more, still more preferably 70% or more in order that generation efficiency may be improved by light reflection.
A method involving dispersing and adding a pigment as a colorant and/or a method involving adding a polymer or fine particles incompatible with a base material and forming gaps or air bubbles at a blend interface at the time of the orientation of the film can each/can be employed as a method of coloring the light-blocking colored layer.

The same examples as those of the present invention 3 are each given as a resin that constructs the light-blocking colored layer (details about specific examples thereof, a preferred resin, and the like).

It should be noted that a polyphenylene ether (PPE) or a polyphenylene sulfide (PPS) may be used as a base material that constructs the light-blocking colored layer.

Preferred examples of the pigment to be used for coloring include a white pigment and a black pigment. Although the white pigment and the black pigment are not particularly limited, examples of the pigments include those described in the present invention 3.

It has been known that the generation efficiency of a crystalline silicon-type solar cell reduces with increasing temperature. Meanwhile, it has been said that the generation efficiency of a dye sensitization-type solar cell can be improved as a result of the absorption of light by its back sheet because the peak of the generation efficiency exists at around room temperature.
The crystalline solar cell shows a color tone close to a black color when the solar cell is a single crystal, or shows a color tone close to a blue color when the solar cell is a polycrystal. Accordingly, when the back sheet is white, the entire module looks like a grid, and hence its design is impaired in some cases. In view of the foregoing, when the back sheet is turned black or blue, the entire module looks integrated, and hence its design can be improved.
Alternatively, the design can be improved by turning the back sheet red, yellow, or the like.

### <Layer construction of sheet for solar cell>

The sheet for a solar cell of the present invention 4 is of such a layer construction as to have at least one layer of each of the layer (I), the layer (II), and the layer (III) whose contents have been described above, and the following layer constructions can be given as examples of the layer construction. It should be noted that various layer constructions except the following are also permitted as long as the layer constructions do not violate the gist of the present invention.
1: [layer (I)/layer (II)/layer (III)] → encapsulating resin layer side
2: [layer (I)/layer (II)/layer (I)/layer (III)] → encapsulating resin layer side
3: [layer (I)/intermediate layer/layer (II)/layer (III)] → encapsulating resin layer side
4: [layer (I)/layer (II)/layer (I)/layer (III)/easy-adhesionlayer] → encapsulating resin layer side
Layers except the layer (I), the layer (II), and the layer (III) in the above-mentioned layer constructions are layers corresponding to characteristics requested of the sheet for a solar cell, and specific contents of the layers are described later.
In addition, a layer construction in which the plurality of layers (I) are described comprehends such a construction that the contents of the compositions of the layers differ from each other as well.
Of those constructions, the construction 1 is preferred from the viewpoints of an improvement in productivity by the simplification of the construction and reliability by virtue of a small number of layer interfaces, and the constructions 2 and 4 is preferred because high reliability can be obtained as a result of a large proportion of the layer (I) excellent in heat resistance, durability, and flame retardancy in the entire sheet.
The sheet formed of any such layer construction can be formed by a co-extrusion molding method depending on a resin to be used. Alternatively, the sheet can be formed by a dry lamination method with a known adhesive such as a polyurethane-based adhesive after the formation of the sheet as a monolayer film. At that time, a known treatment such as a corona discharge treatment may be performed for improving adhesiveness with each layer and for improving adhesiveness with a encapsulating material or a junction box.
In each of all the sheets for solar cells given above, the layer (I) is placed on the outer surface. As a result, long-term adhesiveness with a junction box included with a solar cell module to be described later or with an adherend such as a steel plate or a resin plate can be easily expressed.

Here, the "external surface" and the "internal surface" are the same as described in the case of the present invention 3.
A ratio of the total thickness of the layer (I) in the sheet for a solar cell of the present invention 4 to the entire thickness of the sheet is preferably more than 50%, more preferably 65% or more, still more preferably 80% or more of the entire thickness. When the layer (I) is formed so that its thickness may account for more than 50% of the entire thickness, characteristics influenced by the thickness such as flame retardancy, heat resistance, and a mechanical strength can be favorably exerted.
The gas barrier property of the entire sheet of a multilayer construction in the sheet is determined by the layer having the highest gas barrier property, and is influenced by a thickness ratio to a small extent. Accordingly, the thickness ratio of the layer (II) is not particularly limited, and the placement of the layer (II) can exert an effect concerning the gas barrier property.

The entire thickness of a sheet of such a construction that each of the above-mentioned layers is provided as a plurality of layers is preferably 25 µm or more, more preferably 50 µm or more, still more preferably 75 µm or more, still more preferably 100 µm or more. As long as the thickness falls within the range, a trouble such as an insufficient mechanical strength hardly occurs. In addition, an upper limit for the thickness, which is not particularly determined, is preferably 500 µm or less, more preferably 400 µm or less, still more preferably 300 µm or less in terms of practicality because an excessively large thickness reduces handleability.

### <Other layer constructions easy-adhesion layer>

In the layer construction described in the above-mentioned section 4, as in the case of the present invention 3, an easy-adhesion layer is provided for the inner surface. Providing the layer can improve the adhesiveness with the encapsulating resin layer. The easy-adhesion layer can be formed by a known method such as co-extrusion, dry lamination, or coating. Details about the easy-adhesion layer (method of forming the layer, the thickness of the layer, a material for the layer, and the like) are the same as those in the case of the present invention 3.
It should be noted that the easy-adhesion layer may be provided for the internal surface in the construction described in each of the above-mentioned sections 1 and 3.

### <Other layer constructions intermediate layer>

In the layer construction described in the above-mentioned section 3, an intermediate layer is placed between the layer (I) and the layer (II). The formation of the intermediate layer can increase the entire thickness of the sheet for a solar cell, and can additionally improve the mechanical strength, the insulation characteristic, and the heat resistance.
A resin to be applied to the intermediate layer may be the same as those in the case of the present inventions 3.

### <Other layer constructions>

In addition, a side to serve as an outer surface when the sheet is formed as a solar cell module may be subjected to a known hard coat treatment or antifouling treatment so as to be caused to express surface characteristics such as scratch resistance and antifouling property. The polyphenylene sulfide layer to be applied to the present invention 3 may be appropriately provided.

### (Sheet for solar cell of the present invention 5)

A sheet for a solar cell of the present invention 5 is a laminated sheet for a solar cell obtained by laminating and integrating the following layer (IV) and the following layer (V), the following layer (V) showing a dimensional change ratio of 3% or less when heat-treated in a dry air stream at 150°C for 30 minutes:
(IV) a encapsulating resin layer; and
(V) a base material layer having, on a surface contacting the layer (IV), a polyphenylene ether-based resin layer formed of a resin composition using a polyphenylene ether as a main component.

The sheet is evaluated for its heat resistance in terms of the dimensional change ratio, and the dimensional change ratio of the layer (V) when heat-treated in a dry air stream at 150°C for 30 minutes has only to be 3% or less, preferably 1% or less, more preferably 0.5% or less. It is suitable that the dimensional change ratio should fall within such range because a trouble such as poor productivity hardly occurs. In order that the dimensional change ratio may be adjusted to fall within the range, the deflection temperature under load of the polyphenylene ether-based resin layer in the layer (V) has only to be adjusted to the predetermined value described in the foregoing, or the polyphenylene ether-based resin layer has only to be composited with any other layer showing a small dimensional change.

It should be noted that the purport of the term "as a main component" in the present invention 5 is that any other component may be incorporated to such an extent that the actions and effects of resins constructing the respective layers of the laminated sheet for a solar cell of the present invention are not impaired. Further, the term, which does not impose any limitation on a specific content, refers to a component that accounts for 50 mass% or more, preferably 65 mass% or more, still more preferably a percentage in the range of 80 mass% or more and 100 mass% or less of the entire constituents of the resin composition.
Hereinafter, a laminated sheet for a solar cell as one example of an embodiment of the present invention 5 is described, provided that the scope of the present invention is not limited to an embodiment to be described below.

### <Layer (IV)>

The layer (IV) out of the layers that construct the laminated sheet for a solar cell of the present invention 5 is a encapsulating resinlayer. Here, the layer (IV), which is not particularly limited, is preferably formed of a resin composition using a polyolefin-based resin or a denatured polyolefin-based resin as a main component. Specific examples of the polyolefin-based resin and the denatured polyolef in-based resin are described below. One kind of those resins may be used alone, or two or more kinds thereof may be used as a mixture. In addition, the layer (IV) may be a single layer, or may be obtained by laminating two or more layers as long as each layer is formed of a resin composition using a polyolefin-based resin or a denatured polyolefin-based resin as a main component.

### [Polyolefin-based resin]

Although the kind of the polyolefin-based resin is not particularly limited, the resin is preferably at least one kind of resin selected from the group consisting of a polyethylene-based polymer, a polypropylene-based polymer, and a cyclic olefin-based polymer.

### [Polyethylene-based polymer]

The kind of the polyethylene-based polymer is not particularly limited, and specific examples of the polymer include a very-low-density polyethylene, a low-density polyethylene, a linear, low-density polyethylene (ethylene-α-olefin copolymer), a medium-density polyethylene, a high-density polyethylene, and a very-high-density polyethylene. Of those, the linear, low-density polyethylene (ethylene-α-olefin copolymer) is preferred because of the following reasons. The polyethylene has low crystallinity and is excellent in transparency and flexibility, and hence troubles such as the inhibition of the power-generating characteristic of a solar cell element and the application of an excessive stress to the solar cell element responsible for damage hardly occur.

The ethylene-α-olefin copolymer may be a random copolymer or a block copolymer. While the kind of the α-olefin to be copolymerized with ethylene is not particularly limited, an α-olefin having 3 to 20 carbon atoms is typically suitably used. Here, examples of the α-olefin to be copolymerized with ethylene include propylene, 1-butene, 1-pentene, 1-hexene, 1-heptene, 1-octene, 1-nonene, 1-decene, 3-methyl-butene-1, and 4-methyl-pentene-1. In the present invention, from the viewpoints of, for example, industrial availability, various characteristics, and economic efficiency, propylene, 1-butene, 1-hexene, or 1-octene is suitably used as the α-olefin to be copolymerized with ethylene. Only one kind of the α-olefins to be copolymerized with ethylene may be used, or two or more kinds thereof may be used in combination.

In addition, the content of the α-olefin to be copolymerized with ethylene, which is not particularly limited, is typically 2 mol% ormore, preferably 3 mol% ormore, more preferably 5 mol% or more, and is typically 40 mol% or less, preferably 30 mol% or less, more preferably 25 mol% or less. A content within the range is preferred because transparency is improved by a reduction in crystallinity by the component to be copolymerized and a trouble such as the blocking of a raw material pellet hardly occurs. It should be noted that the kind and content of the α-olefin to be copolymerized with ethylene can be subjected to qualitative and quantitative analysis by a known method such as a nuclear magnetic resonance (NMR)-measuring apparatus or any other instrumental analysis apparatus.

A method of producing the polyethylene-based polymer is not particularly limited, and a known polymerization method involving using a known catalyst for olefin polymerization can be adopted. Examples of such method include a slurry polymerization method, a solution polymerization method, a bulk polymerization method, and a vapor phase polymerization method each involving using a multi-site catalyst typified by a Ziegler-Natta catalyst or a single-site catalyst typified by a metallocene-based catalyst or a post-metallocene-based catalyst, and a bulk polymerization method involving using a radical initiator. The ethylene-α-olefin copolymer to be used as a encapsulating resin layer is preferably a relatively soft resin, and a polymerization method involving using a single-site catalyst by which a raw material containing a small amount of a low-molecular weight component and having a narrow molecular weight distribution can be polymerized is suitable from the viewpoints of, for example, the ease of granulation (pelletization) after the polymerization and the prevention of the blocking of the raw material pellet.

Specific examples of the polyethylene-based polymer to be used in the present invention 5 include the trade names "Hizex, " "Neozex," and "Ultzex" manufactured by Prime Polymer Co., Ltd., the trade names "Novatec HD," "Novatec LD," and "Novatec LL" manufactured by Japan Polyethylene Corporation, the trade names "Engage," "Affinity," and "Infuse" manufactured by Dow Chemical Company, the trade names "TAFMER A" and "TAFMER P" manufactured by Mitsui Chemicals, Inc., and the trade name "Karnel" manufactured by Japan Polyethylene Corporation.

### [Polypropylene-based polymer]

The kind of the polypropylene-basedpolymer is not particularly limited, and specific examples thereof include a homopolymer of propylene, a copolymer of propylene, a reactor-type, polypropylene-based thermoplastic elastomer, and a mixture thereof.
Examples of the copolymer of propylene include a random copolymer (random polypropylene) or block copolymer (block polypropylene) of propylene with ethylene or any other α-olefin, and a block copolymer or graft copolymer containing a rubber component. The other α-olefin copolymerizable with propylene is preferably one having 4 to 12 carbon atoms, and examples thereof include 1-butene, 1-pentene, 1-hexene, 1-heptene, 1-octene, 4-methyl-1-pentene, and 1-decene. One kind or a mixture of two or more kinds thereof is used.

In addition, the content of the α-olefin to be copolymerized with propylene, which is not particularly limited, is typically 2 mol% or more, preferably 3 mol% ormore, more preferably 5 mol% or more, and is typically 40 mol% or less, preferably 30 mol% or less, more preferably 25 mol% or less. A content within the range is preferred because transparency is improved by a reduction in crystallinity by the component to be copolymerized and a trouble such as the blocking of a raw material pellet hardly occurs. It should be noted that the kind and content of the α-olefin to be copolymerized with propylene can be subjected to qualitative and quantitative analysis by a known method such as a nuclear magnetic resonance (NMR)-measuring apparatus or any other instrumental analysis apparatus.

A method of producing the polypropylene-based polymer is not particularly limited, and a known polymerization method involving using a known catalyst for olefin polymerization can be adopted. Examples of such method include a slurry polymerization method, a solution polymerization method, a bulk polymerization method, and a vapor phase polymerization method each involving using a multi-site catalyst typified by a Ziegler-Natta catalyst or a single-site catalyst typified by a metallocene-based catalyst or a post-metallocene-based catalyst, and a bulk polymerization method involving using a radical initiator. The propylene-α-olefin copolymer to be used as a encapsulating resin layer is preferably a relatively soft resin, and a polymerization method involving using a single-site catalyst by which a raw material containing a small amount of a low-molecular weight component and having a narrow molecular weight distribution can be polymerized is suitable from the viewpoints of, for example, the ease of granulation (pelletization) after the polymerization and the prevention of the blocking of the raw material pellet.

Specific examples of the polypropylene to be used in the present invention 5 include the trade names "Novatec PP" and "WINTEC" manufactured by Japan Polypropylene Corporation, the trade names "Prime Polypro" and "PRIME TPO" manufactured by Prime Polymer Co., Ltd., and the trade name "Noblene" manufactured by Sumitomo Chemical Co., Ltd.

### [Cyclic olefin-based polymer]

The kind of the cyclic olefin-based polymer is not particularly limited, and specific examples of the polymer include a cyclic olefin polymer obtained by the ring-opening polymerization of one or more kinds of cyclic olefins and a hydride thereof, a block copolymer of a linear α-olefin and a cyclic olefin, and a random copolymer of a linear α-olefin and a cyclic olefin.

The kind of cyclic olefin for constructing the cyclic olefin-based polymer is not particularly limited, and examples thereof include bicyclohept-2-ene (2-norbornene) and derivatives thereof, such asnorbornene,6-methylnorbornene, 6-ethylnorbornene, 6-n-butylnorbornene, 5-propylnorbornene, 1-methylnorbornene, 7-methylnorbornene, 5,6-dimethylnorbornene, 5-phenylnorbornene, and 5-benzylnorbornene, and tetracyclo-3-dodecene and derivatives thereof such as 8-methyltetracyclo-3-dodecene, 8-ethyltetracyclo-3-dodecene, 8-hexyltetracyclo-3-dodecene, 2,10-dimethyltetracyclo-3-dodecene, and 5,10-dimethyltetracyclo-3-dodecene. In the present invention, from the viewpoints of, for example, industrial availability, various characteristics, and economic efficiency, norbornene, tetracyclododecene, or the like is suitably used.

While the kind of the linear α-olefin to be copolymerized with cyclic olefin is not particularly limited, a linear α-olefin having 2 to 20 carbon atoms is typically suitably used. Here, examples of the linear α-olefin to be copolymerized with cyclic olefin include ethylene, propylene, 1-butene, 1-pentene, 1-hexene, 1-heptene, 1-octene, 1-nonene, and 1-decene. In the present invention, from the viewpoints of, for example, industrial availability, various characteristics, and economic efficiency, ethylene is suitably used as the linear α-olefin to be copolymerized with cyclic olefin. Only one kind of the linear α-olefins to be copolymerized with cyclic olefin may be used, or two or more kinds thereof may be used in combination.

In addition, the content of the cyclic olefin to be copolymerized with linear α-olefin, which is not particularly limited, is typically 5 mol% or more, preferably 10 mol% or more, more preferably 20 mol% or more, and is typically 70 mol% or less, preferably 60 mol% or less, more preferably 50 mol% or less. Larger content of the cyclic olefin is suitable for improving heat resistance, barrier property, and transparency, and smaller content of the cyclic olefin suitable for improving flexibility. A content of the cyclic olefin within the range is preferred because transparency is expressed by a reduction in crystallinity by the component to be copolymerized and a trouble such as the blocking of a raw material pellet hardly occurs. It should be noted that the kind and content of the cyclic olefin to be copolymerized with linear α-olefin can be subjected to qualitative and quantitative analysis by a known method such as a nuclear magnetic resonance (NMR)-measuring apparatus or any other instrumental analysis apparatus.

It should be noted that the cyclic olefin-based polymer to be used in the present invention 5 can be produced in accordance with a known method described in, for example, JP 60-168708 A, JP 61-120816 A, JP 61-115912 A, JP 61-115916 A, JP 61-271308 A, JP 61-272216 A, JP 62-252406 A, or JP 62-252407 A.

Specific examples of the cyclic olefin-based polymer to be used in the present invention 5 include the trade name "LAPEL" manufactured by Mitsui Chemicals, Inc., the trade name "TOPAS" manufactured by Topas Advanced Polymers, and the trade names "ZEONOR" and "ZEONEX" manufactured by Zeon Corporation.

### [Modified polyolefin-based resin]

While the kind of the modified polyolefin-based resin for constructing the layer (IV) in the present invention is not particularly limited, the modified polyolefin-based resin is preferably at least one kind of resin selected from the group consisting of an ethylene-vinyl acetate copolymer (EVA), an ethylene-vinyl alcohol copolymer (EVOH), an ethylene-methyl methacrylate copolymer (E-MMA), an ethylene-ethyl acrylate copolymer (E-EAA), an ethylene-glycidyl methacrylate copolymer (E-GMA), ionomer resins (ionically crosslinkable ethylene-methacrylic acid copolymer and ionically crosslinkable ethylene-acrylic acid copolymer), a silane crosslinkable polyolefin, and a maleic anhydride graft copolymer.

As described in the foregoing, the laminated sheet for a solar cell of the present invention 5 is obtained by laminating and integrating the layer (IV) as a encapsulating resin layer and the layer (V) having, on the surface contacting the layer (IV), the polyphenylene ether-based resin layer formed of the resin composition using the polyphenylene ether as a main component. When the layer (IV) is constructed by using the denatured polyolef in-based resin as a main component, adhesiveness with the polyphenylene ether-based resin layer is improved by reason of the presence of a denatured group thereof.

In addition, the content of various monomers used for modifying the modified polyolefin-based resin, which is not particularly limited, is typically 0.5 mol% or more, preferably 1 mol% or more, more preferably 2 mol% or more, and is typically 40 mol% or less, preferably 30 mol% or less, more preferably 25 mol% or less. A content within the range is preferred because transparency is improved by a reduction in crystallinity by the component to be copolymerized and a trouble such as the blocking of a raw material pellet hardly occurs. It should be noted that the kind and content of the various monomers used for modifying the modified polyolefin-based resin can be subjected to qualitative and quantitative analysis by a known method such as a nuclear magnetic resonance (NMR)-measuring apparatus or any other instrumental analysis apparatus.

A method of producing the modified polyolefin-based resin to be used in the present invention 5 is not particularly limited, and the modified polyolefin-based resin, except an ionomer resin, a silane crosslinkable polyolefin, and a maleic anhydride graft copolymer described below, can be obtained by, for example, a known polymerization method using a known catalyst for olefin polymerization, such as a slurry polymerization method, a solution polymerization method, a bulk polymerization method, or a vapor phase polymerization method each involving using a multi-site catalyst typified by a Ziegler-Natta catalyst or a single-site catalyst typified by a metallocene catalyst, or a bulk polymerization method involving using a radical initiator.

The ionomer resin can be obtained by neutralizing at least part of an unsaturated carboxylic acid component of a copolymer formed of ethylene, an unsaturated carboxylic acid, and any other unsaturated compound as an arbitrary component with at least one of a metal ion and an organic amine. Alternatively, the ionomer resin can be obtained by saponifying at least part of an unsaturated carboxylic acid ester component of a copolymer formed of ethylene, an unsaturated carboxylic acid ester, and any other unsaturated compound as an arbitrary component.

The silane crosslinkable polyolefin can be obtained by melting and mixing the polyolefin-based resin, a silane coupling agent to be described later, and a radical generator to be described later at a high temperature, and subjecting the mixture to graft polymerization.

The maleic anhydride graft copolymer can be obtained by melting and mixing the polyolefin-based resin, a maleic anhydride, and a radical generator to be described later at a high temperature, and subjecting the mixture to graft polymerization.

Specific examples of the modified polyolefin-based resin to be used in the present invention 5 include ethylene-vinyl acetate copolymers (EVA) such as the trade name "Novatec EVA" manufactured by Japan Polyethylene Corporation, the trade name "EVAFLEX" manufactured by DUPONT-MITSUI POLYCHEMICALS CO., LTD., and a "NUC" series manufactured by Nippon Unicar Company Limited, ethylene-vinyl alcohol copolymers (EVOH) such as the trade name "Soarnol" manufactured by The Nippon Synthetic Chemical Industry Co., Ltd. and the trade name "EVAL" manufactured by KURARAY CO. LTD., ethylene-methyl methacrylate copolymers (E-MMA) such as the trade name "ACRYFT" manufactured by Sumitomo Chemical Co., Ltd., ethylene-ethylacrylate copolymers (E-EAA) such as the trade name "REXPEARL EEA" manufactured by Japan Polyethylene Corporation, ethylene-glycidyl methacrylate copolymers (E-GMA) such as the trade name"BONDFAST"manufactured bySumitomo Chemical Co. , Ltd. , ionomer resins such as the trade name "Himilan" manufactured by DUPONT-MITSUI POLYCHEMICALS CO., LTD., silane crosslinkable polyolefins such as the trade name "LINKLON" manufactured by Mitsubishi Chemical Corporation, and maleic anhydride graft copolymers such as "ADMER" Mitsui Chemicals, Inc.

The melt flow rate (MFR) of each of the polyolefin-based resin and the modified polyolefin-based resin is not particularly limited. For example, in the case of using polyethylene, one having an MFR (JIS K7210, temperature: 190°C, load: 21.18N) of preferably 0.5g/10 min or more, more preferably 2g/10 min or more, still more preferably 3g/10 min or more and preferably 30g/10 min or less, more preferably 25g/10 min or less, still more preferably 20g/10 min or less is used. Here, the MFR has only to be selected in consideration of, for example, molding processability upon molding of the sheet, adhesiveness at the time of the sealing of a solar cell element (cell), or the degree of wraparound. For example, when the sheet is subjected to calender molding, it is preferred that the MFR be relatively low, specifically 0.5 g/10 min or more and 5 g/10 min or less in terms of handleability upon peeling of the sheet from a molding roll. In addition, when the sheet is subjected to extrusion molding with a T-die, a resin having an MFR of preferably 2 g/10 min or more, more preferably 3 g/10 min or more, and preferably 30 g/10 min or less, more preferably 20 g/10 min or less has only to be used from the viewpoints of a reduction in extrusion load and an increase in extrusion output. Further, a resin having an MFR of preferably 2 g/10 min or more, more preferably 3 g/10 min or more, and preferably 30 g/10 min or less, more preferably 20 g/10 min or less has only to be used from the viewpoints of the adhesiveness at the time of the sealing of the solar cell element (cell) and the ease of wraparound.

In the resin composition for constructing the layer (IV) in the present invention 5, a resin other than the above-mentioned polyolefin-based resin or modified polyolefin-based resin can be mixed for the purpose of additionally improving, for example, various physical properties (such as flexibility, heat resistance, transparency, and adhesiveness), molding processability, or economic efficiency within a range not departing from the gist of the present invention 5.
Examples of the resin include other polyolefin-based resins, various elastomers (such as olefin-based and styrene-based ones), a resin modified with polar group such as a carboxyl group, an amino group, an imide group, a hydroxyl group, an epoxy group, an oxazoline group, or a thiol group, and a tackiness-imparting resin.

Examples of the tackiness-imparting resin include a petroleum resin, a terpene resin, a coumarone-indene resin, a rosin-based resin, and hydrogenated derivatives thereof. Specifically, examples of the petroleum resin include an alicyclic petroleum resin obtained from cyclopentadiene or a dimer thereof and an aromatic petroleum resin obtained from a C9 component, examples of the terpene resin include a terpene resin and a terpene-phenol resin obtained from β-pinene, and examples of the rosin-based resin include rosin resins such as a gum rosin and a wood rosin, and esterified rosin resins obtained through modification with glycerin orpentaerythritol. Although the tackiness-imparting resins having various softening temperatures are obtained depending mainly on their molecular weights, a hydrogenated derivative of an alicyclic petroleum resin having a softening temperature of preferably 100°C or more, more preferably 120°C or more, and preferably 150°C or less, more preferably 140°C or less is particularly preferred in terms of, for example, compatibility when mixed with the polyolefin-based resin or denatured polyolefin-based resin component described in the foregoing, bleeding property over time, a color tone, and heat stability. If a resin except the above-mentioned polyolefin-based resin or denatured polyolefin-based resin is mixed, the content of any such resin is preferably 20 mass% or less, more preferably 10 mass% or less in ordinary cases when the content of the resin composition that constructs the layer (IV) is set to 100 mass%.

In addition, various additives can each be added to the resin composition that constructs the layer (IV) in the present invention 5 as required. Examples of the additives include a radical generator (crosslinking agent/crosslinking aid), a silane coupling agent, an antioxidant, a UV absorber, a weathering stabilizer, a light-diffusing agent, a nucleating agent, a pigment (such as a white pigment), a flame retardant, and a discoloration inhibitor. In the present invention, at least one kind of additive selected from the radical generator, the silane coupling agent, the antioxidant, the UV absorber, and the weathering stabilizer is preferably added because of, for example, the following reasons.

### [Radical generator]

When the polyolefin-based resin or the denatured polyolefin-based resin is used as the encapsulating resin layer, the radical generator (crosslinking agent/crosslinking aid) is useful in providing the layer with a crosslinked structure for the purposes of, for example, improving its heat resistance and increasing its mechanical strength. The radical generator, which is not particularly limited, is, for example, an organic peroxide, an azo compound such as azobisisobutyronitrile (AIBN) or a polymer azo compound, or an organometallic compound such as allyltin or triethylborane. Of those, an organic peroxide that generates a radical at 100°C or more and has a 10-hour halflife decomposition temperature of 70°C or more is particularly suitably used from the viewpoints of a reaction rate and safety at the time of compounding.
As such radical generator, there can be preferably used, for example: 2,5-dimethylhexane-2,5-dihydroperoxide; 2,5-dimethyl-2,5-di(t-butylperoxy)hexane; di-t-butyl peroxide; dicumyl peroxide; 2,5-dimethyl-2,5-di(t-butylperoxy)hexyne; dicumyl peroxide; a,a'-bis(t-butylperoxyisopropyl)benzene; n-butyl-4,4-bis(t-butylperoxy)butane; 2,2-bis(t-butylperoxy)butane; 1,1-bis(t-butylperoxy)cyclohexane; 1,1-bis(t-butylperoxy)-3,3,5-trimethylcyclohexane; t-butyl peroxybenzoate; and benzoyl peroxide. Any such radical generator is added at a content of preferably 5 mass% or less, more preferably 3 mass% or less with respect to 100 mass% of the resin composition that constructs the layer (IV) in the present invention 5 to the advantage of a molding processing in order that an increase in resin pressure and the production of a foreign matter such as a gel or a fish eye may be suppressed, and that a trouble such as a bleedout from a molded product may be suppressed. In addition, the content is preferably 0.25 mass% or more, more preferably 0.5 mass% or more, still more preferably 0.75 mass% or more in order that a crosslinking reaction may be efficiently advanced.

### [Silane coupling agent]

The silane coupling agent is useful for improving adhesiveness for a protective material (such as glass or a front sheet or back sheet made of a resin) for the encapsulating resin layer, a solar cell element, and the like, and examples thereof include compounds each having a hydrolyzable group such as an alkoxy group together with an unsaturated group such as a vinyl group, a acryloxy group, or a methacryloxy group, an amino group, an epoxy group, or the like. Specific examples of the silane coupling agent include N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, and γ-methacryloxypropyltrimethoxysilane. In the present invention, γ-glycidoxypropyltrimethoxysilane or γ-methacryloxypropyltrimethoxysilane is preferably used because they have satisfactory adhesiveness and cause little coloring such as yellowing. The silane coupling agent is added at a content of preferably 5 mass% or less, more preferably 3 mass% or less with respect to 100 mass% of the resin composition that constructs the layer (IV) in the present invention 5 in order that an increase in resin pressure and the production of a foreign matter such as a gel or a fish eye may be suppressed, and that a trouble such as a bleedout from a molded product may be suppressed. In addition, the content is preferably 0.1 mass% or more, more preferably 0.2 mass% or more in order that adhesiveness may be expressed.
A coupling agent such as an organic titanate compound can also be effectively exploited as in the silane coupling agent.

As described in the foregoing, the laminated sheet for a solar cell of the present invention 5 is obtained by laminating and integrating the layer (IV) as a encapsulating resin layer and the layer (V) having, on the surface contacting the layer (IV), the polyphenylene ether-based resin layer formed of the resin composition using the polyphenylene ether as a main component. When the layer (IV) contains the radical generator (crosslinking agent or crosslinking aid) or the silane coupling agent, its adhesiveness with the polyphenylene ether-based resin layer becomes particularly good.
Although the mechanism via which the adhesiveness becomes particularly good is unclear, it is assumed that active hydrogen in the polyphenylene ether-based resin as the main component of the polyphenylene ether-based resin layer and the radical generator or a reactive group (alkoxysilane group) of the silane coupling agent react with each other to form a crosslinked structure, thereby improving the adhesiveness between both the layers significantly.

### [Antioxidant]

Various commercially available products are applicable to the antioxidant, and examples thereof include antioxidants of various types such as monophenol-based, bisphenol-based, high molecular weight phenol-based, sulfur-based, and phosphite-based types. Examples of the monophenol-based antioxidant include 2,6-di-tert-butyl-p-cresol, butylated hydroxyanisole, and 2,6-di-tert-butyl-4-ethylphenol. Examples of the bisphenol-based antioxidant include 2,2'-methylene-bis-(4-methyl-6-tert-butylphenol), 2,2'-methylene-bis-(4-ethyl-6-tert-butylphenol), 4,4'-thiobis-(3-methyl-6-tert-butylphenol), 4,4'-butylidene-bis-(3-methyl-6-tert-butylphenol), and 3,9-bis[{1,1-dimethyl-2-{β-(3-tert-butyl-4-hydroxy-5-methylphe nyl)propionyloxy}ethyl}2,4,9,10-tetraoxaspiro]5,5-undecane.

Examples of the high molecular weight phenol-based antioxidant include 1,1,3-tris-(2-methyl-4-hydroxy-5-tert-butylphenyl)butane, 1,3,5-trimethyl-2,4,6-tris(3,5-di-tert-butyl-4-hydroxybenzyl)b enzene, tetrakis-{methylene-3-(3',5'-di-tert-butyl-4'-hydroxyphenyl)pr opionate}methane, bis{(3,3'-bis-4'-hydroxy-3'-tert-butylphenyl)butyric acid} glycol ester, 1,3,5-tris(3',5'-di-tert-butyl-4'-hydroxybenzyl)-s-triazine-2, 4,6-(1H,3H,5H)trione, and triphenol (vitamin E).

Examples of the sulfur-based antioxidant include dilauryl thiodipropionate, dimyristyl thiodipropionate, and distearyl thiodipropionate.

Examples of the phosphite-based antioxidant include triphenyl phosphite, diphenyl isodecyl phosphite, phenyl diisodecyl phosphite, 4,4'-butylidene-bis(3-methyl-6-tert-butylphenyl-di-tridecyl) phosphite, cyclic neopentanetetrayl bis(octadecyl phosphite), tris(mono and/or di)phenyl phosphite, diisodecyl pentaerythritol diphosphite, 9,10-dihydro-9-oxa-10-phosphaphenanthrene-10-oxide, 10-(3,5-di-tert-butyl-4-hydroxybenzyl)-9,10-dihydro-9-oxa-10-p hosphaphenanthrene-10-oxide, 10-decyloxy-9,10-dihydro-9-oxa-10-phosphaphenanthrene, cyclic neopentanetetrayl bis(2,4-di-tert-butylphenyl) phosphite, cyclic neopentanetetrayl bis(2,6-di-tert-methylphenyl) phosphite, and 2,2-methylenebis(4,6-tert-butylphenyl)octyl phosphite. In the present invention, phenol- and phosphite-based antioxidants are each preferably used in terms of, for example, the effects, heat stability, and economical efficiency of the antioxidants, and both the antioxidants are more preferably used in combination because the effects of the antioxidants with respect to their addition amounts can be improved. In ordinary cases, any such antioxidant is added at a content within the range of preferably 0.1 mass% or more, more preferably 0.2 mass% or more, and preferably 1 mass% or less, more preferably 0.5 mass% or less with respect to 100 mass% of the resin composition that constructs the layer (IV) in the present invention 5.

### [UV absorber]

Various commercially available products are applicable to the UV absorber, and examples thereof include UV absorbers of various types such as benzophenone-based, benzotriazole-based, triazine-based, and salicylic acid ester-based types. Examples of the benzophenone-based UV absorber include 2-hydroxy-4-methoxybenzophenone, 2-hydroxy-4-methoxy-2'-carboxybenzophenone, 2-hydroxy-4-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone, and 2,2',4,4'-tetrahydroxybenzophenone.

Examples of the benzotriazole-based UV absorber include hydroxyphenyl-substituted benzotriazole compounds such as 2-(2-hydroxy-5-methylphenyl)benzotriazole, 2-(2-hydroxy-5-t-butylphenyl)benzotriazole, 2-(2-hydroxy-3,5-dimethylphenyl)benzotriazole, 2-(2-methyl-4-hydroxyphenyl)benzotriazole, 2-(2-hydroxy-3-methyl-5-t-butylphenyl)benzotriazole, 2-(2-hydroxy-3,5-di-t-amylphenyl)benzotriazole, and 2-(2-hydroxy-3,5-di-t-butylphenyl)benzotriazole. In addition, examples of the triazine-based UV absorber include 2-[4,6-bis(2,4-dimethylphenyl)-1,3,5-triazin-2-yl]-5-(octyloxy )phenol and 2-(4,6-diphenyl-1,3,5-triazin-2-yl)-5-(hexyloxy)phenol.
Examples of the salicylic acid ester-based UV absorber include phenyl salicylate and p-octylphenyl salicylate. The addition amount of the UV absorber is preferably such that the UV absorber is added in the range of generally 0.01 mass% or more, preferably 0.05 mass% or more and 2.0 mass% or less, preferably 0.5 mass% or less with respect to 100 mass% of the resin composition for constructing the layer (IV) in the present invention 5.

### [Weathering stabilizer]

A hindered amine-based light stabilizer is suitably used as the weathering stabilizer that imparts weatherability except the above-mentioned UV absorber. The hindered amine-based light stabilizer does not absorb ultraviolet light unlike the UV absorber, but shows a significant synergistic effect when used in combination with the UV absorber. Although products each functioning as a light stabilizer except the hindered amine-based light stabilizer exist, the products are often colored and hence not preferred for the layer (IV) in the present invention 5.

Examples of the hindered amine-based light stabilizer include a dimethyl succinate-1-(2-hydroxyethyl)-4-hydroxy-2,2,6,6-tetramethylpipe ridine polycondensation product, poly[{6-(1,1,3,3-tetramethylbutyl)amino-1,3,5-triazine-2,4-diy 1}{(2,2,6,6-tetramethyl-4-piperidyl)imino}hexamethylene{{2,2,6 ,6-tetramethyl-4-piperidyl}imino}], an N,N'-bis(3-aminopropyl)ethylenediamine-2,4-bis[N-butyl-N-(1,2, 2,6,6--pentamethyl-4-piperidyl)amino]-6-chloro-1,3,5-triazine condensation product, bis(2,2,6,6-tetramethyl-4-piperidyl) sebacate, and bis(1,2,2,6,6-pentamethyl-4-piperidyl) 2-(3,5-di-tert-butyl-4-hydroxybenzyl)-2-n-butylmalonate. In ordinary cases, the hindered amine-based light stabilizer is added at a content within the range of preferably 0.01 mass% or more, more preferably 0.05 mass% or more, and preferably 0.5 mass% or less, more preferably 0.3 mass% or less with respect to 100 mass% of the resin composition that constructs the layer (IV) in the present invention 5.

The addition amount of each of the antioxidant, the UV absorber, and the weathering stabilizer described above is preferably limited to the minimum required amount because in general, yellowing is more likely to occur as the addition amount increases. Such an embodiment that none of the products is added is also preferred.

In general, the temperature of a solar cell module increases to about 85 to 90°C owing to, for example, heat generation at the time of its power generation or the radiant heat of sunlight. An approach to suppressing a trouble such as the flow of the layer (IV) at that time is, for example, to cause the layer (IV) to form a crosslinked structure with the radical generator, silane coupling agent, or the like described in the foregoing, to use a crystalline resin in the layer, or to use a resin having a high glass transition point in the layer. A crystal melting peak temperature when the crystalline resin is used or a glass transition temperature when a noncrystalline resin is used is preferably 100°C or more, more preferably 110°C or more, still more preferably 120°C or more, and is preferably 160°C or less, more preferably 150°C or less, still more preferably 145°C or less, still more preferably 140°C or less. It is suitable that the upper limit temperature should fall within the above-mentioned range because a solar cell element can be sealed at a not very high temperature in the step of sealing the element. It is suitable that the lower limit temperature should fall within the above-mentioned range because a trouble such as the flow of the layer (IV) during use hardly occurs.

The flexibility of the layer (IV) in the present invention 5 has only to be appropriately adjusted in consideration of, for example, the shape and thickness of a solar cell to be applied, and the place where the solar cell is installed. For example, the layer has only to show a storage modulus (E') at a temperature of 20°C of preferably 1 MPa or more, more preferably 5 MPa or more, still more preferably 10 MPa or more when subjected to dynamic viscoelasticity measurement under the conditions of an oscillation frequency of 10 Hz, a strain of 0.1%, and a rate of temperature increase of 3°C/min. It is suitable that the storage modulus should fall within such range because troubles such as the breakage of a solar cell element due to the application of an excessive stress and the breakage of the solar cell element upon application of an impact to the solar cell module hardly occur. In addition, the storage modulus has only to be preferably less than 1,000 MPa, more preferably 500 MPa or less, still more preferably 100 MPa or less. It is suitable that the storage modulus should fall within such range because of the following reasons. When the layer (IV) in the present invention 5 is recovered in a sheet shape or the like, troubles such as insufficient handleability and the occurrence of blocking between sheet surfaces hardly occur. In addition, sufficient flexibility can be imparted to the layer upon production of a pliable module.

The total light transmittance of the layer (IV) in the present invention 5 may not be very highly valued depending on the kind of a solar cell to be applied, for example, when the layer is applied to an amorphous, thin-film silicone-type solar cell or a site that does not block sunlight which reaches a solar cell element (such as a gap between the solar cell element and a back sheet). In ordinary cases, however, the total light transmittance is preferably 85% or more, more preferably 90% or more in consideration of, for example, the photoelectric conversion efficiency of the solar cell and handleability at the time of the superimposition of various members.

### [Method of forming layer (IV)]

Next, a method of forming the layer (IV) in the present invention 5 is described. Its thickness, which is not particularly limited, has only to be 30 µm or more, preferably 50 µm or more, more preferably 100 µm or more, and about 1,000 µm (1.0 mm) or less, preferably 700 µm or less, more preferably 500 µm or less in ordinary cases.
As the laminated sheet for a solar cell of the present invention is of a laminated construction of the layer (IV) having flexibility and the layer (V) having rigidity, its handleability is not reduced even when the thickness is small, and the layer (IV) may be reduced in thickness depending on the kind and construction of a solar cell to be applied, and in consideration of economical efficiency.
A known method such as an extrusion casting method or calender method involving using a melting and mixing facility such as a uniaxial extruder, a multi-axial extruder, a Banbury mixer, or a kneader and a T-die can be adopted as a method of forming the layer (IV), and the method is not particularly limited. In the present invention, however, the extrusion casting method involving using a T-die is suitably employed in terms of, for example, handleability and productivity. A molding temperature in the extrusion casting method involving using a T-die, which is appropriately adjusted depending on, for example, the flow characteristic and film formability of a resin composition to be used, is generally 80°C or more, preferably 100°C or more, more preferably 120°C or more, still more preferably 140°C or more, and is generally 300°C or less, preferably 250°C or less, more preferably 200°C or less, still more preferably 180°C or less. When a radical generator, a silane coupling agent, or the like is added, the molding temperature is preferably reduced in order that an increase in resin pressure in association with a crosslinking reaction and an increase in amount of a fish eye may be suppressed. Various additives such as a radical generator, a silane coupling agent, an antioxidant, a UV absorber, and a weathering stabilizer may each be dry-blended with the resin in advance before being supplied to a hopper. Alternatively, the following is permitted. All materials are melted and mixed in advance so that a pellet may be produced, and then the pellet is supplied. Alternatively, the following is permitted. A master batch produced by concentrating only any such additive in the resin in advance is produced and supplied. In addition, the front surface and/or back surface of the layer (IV) in the present invention 5 obtained in a sheet shape may each/may be subj ected to embossing or processings for forming various irregularities (of, for example, a conical or pyramidal shape and a hemispherical shape) as required for the purposes of, for example, preventing blocking between parts of the sheet when the sheet is turned into a roll, and improving handleability and ease of removal of air in the step of sealing a solar cell element. Further, upon production of the sheet, the layer may be laminated together with another base material film (such as an oriented polyester film (OPET) or an oriented polypropylene film (OPP)) by a method such as an extrusion lamination method or a sand lamination method for the purpose of, for example, improving handleability at the time of the formation of the sheet.
As described later, the extrusion lamination of the layer onto the polyphenylene ether-based resin layer in the layer (V), the co-extrusion of the layer with the polyphenylene ether-based resin layer in the layer (V), or the like is also suitable because a production step can be shortened.

### <Layer (V) >

The layer (V) in the laminated sheet for a solar cell of the present invention 5 is a base material layer having, on the surface contacting the layer (IV), the polyphenylene ether-based resin layer formed of the resin composition using the polyphenylene ether as a main component. The layer (V) may be formed only of the polyphenylene ether-based resin layer, or may be obtained by providing one or more other layers on the surface opposite to the surface contacting the layer (IV) in the polyphenylene ether-based resin layer. Examples of the other layers include an intermediate layer for expressing a mechanical strength, an insulation characteristic, or heat resistance, and a gas barrier property layer.

### [Polyphenylene ether-based resin layer]

A lower limit for the content of the polyphenylene ether as the main component of the polyphenylene ether-based resin layer, which is not particularly determined, is preferably 50 mass% or more, more preferably 65 mass% or more, still more preferably 80 mass% or more. As long as the content falls within the range, durability, flame retardancy, dimensional stability, a high mechanical strength, and high adhesiveness with the encapsulating resin layer or the like can be achieved.
It should be noted that with regard to specific examples of the polyphenylene ether (PPE), any one of the same examples as those of the polyphenylene ether according to each of the present inventions 1 and 2 can be suitably used. A material for the polyphenylene ether, a product to be compounded and its ratio, an applicable commercial product, and the like are also the same as those in the case of the polyphenylene ether according to each of the present inventions 1 and 2.

The molecular weight of the polyphenylene ether to be used in the present invention preferably falls within a range generally as described below. A lower limit for a weight average molecular weight measured by gel permeation chromatography (GPC) in terms of polystyrene is preferably 30, 000 or more, more preferably 40,000 or more, still more preferably 50,000 or more, and an upper limit therefor is preferably 100, 000 or less, more preferably 90, 000 or less, still more preferably 80,000 or less. When the molecular weight falls within this range, a balance among extrusion moldability, mechanical physical properties, flame retardancy, and the like can be achieved.

For the purpose of improving physical properties such as extrusion moldability, impact resistance, heat resistance, flame retardancy, and adhesiveness, there are preferably blended, in the above-mentioned polyphenylene ether, appropriate amounts of styrene-based resins such as general-purpose polystyrene (GPPS), high impact polystyrene (HIPS), acrylonitrile-butadiene-styrene (ABS), a hydrogenated styrene-butadiene-styrene block copolymer (SEBS), a styrene-butadiene-styrene block copolymer (SBS), and a hydrogenated styrene-isoprene-styrene block copolymer (SEPS), ethylene-based resins such as an ethylene-propylene copolymer, an ethylene-1-butene copolymer, an ethylene-propylene-non-conjugated diene copolymer, an ethylene-ethyl acrylate copolymer, an ethylene-glycidyl methacrylate copolymer, an ethylene-vinyl acetate-glycidyl methacrylate copolymer, and an ethylene-propylene-g-maleic anhydride copolymer, polyester-based resins such as a polyester-polyether elastomer and a polyester-polyester elastomer, polyamide-based resins, and polyphenylene sulfide-based resins. Of those, each of the styrene-based resins is suitably used because of its excellent compatibility with the polyphenylene ether-based resin and good adhesiveness with the layer (IV), and a hydrogenated elastomer such as a hydrogenated styrene-butadiene-styrene block copolymer (SEBS) is particularly suitably used because the number of troubles such as gelation and a granule at the time of extrusion molding is small.
With regard to the addition amount of any such product, the product is preferably compounded in an appropriate amount within such a range as not to exceed the content (mass%) of the polyphenylene ether described in the foregoing. For example, the content of each of a polystyrene-based resin and a polyethylene-based resin is 1 mass% or more, preferably 3 mass% or more, still more preferably 5 mass% or more. Compounding any such resin at a content within the range can improve melt processability and impact resistance. In addition, any such resin is preferably added at a content of 40 mass% or less, more preferably 30 mass% or less, more preferably 25 mass% or less, still more preferably 20 mass% or less because problems such as an excessive reduction in heat resistance and the inhibition of flame retardancy do not occur.

As described in the present inventions 1 and 2, the polyphenylene ether is easily formed into a char layer at the time of its combustion because the polyphenylene ether has an aromatic ring and an oxygen atom in its unit skeleton. In addition, the polyphenylene ether is a resin that does not cause the drip of a molten resin and is excellent in flame retardancy because of the following features. By virtue of the presence of active hydrogen, the polyphenylene ether has a radical-capturing ability and easily suppresses the breaking of a molecular chain.
Further, an improvement in flame retardancy can be achieved by adding, for example, a halogen-based flame retardant such as brominated biphenyl ether, a metal hydroxide flame retardant such as magnesium hydroxide, or an inorganic flame retardant such as a nitrogen-based compound or an antimony-based compound. Of those, any such phosphorus-based flame retardant as applicable in the present inventions 1 and 2 is preferred from the viewpoints of, for example, an environmental load, the impartment of flame retardancy, and the securement of a mechanical strength.

In addition to the above-mentioned components, any other additional component may be added as required to such an extent that the features and effects of the present invention 5 are not impaired as in each of the present inventions 1 and 2.

The polyphenylene ether-based resin layer may be transparent, or may be colored. When the layer is used mainly as a back sheet, the coloring is performed for, for example, the purposes of: causing the layer to reflect or absorb sunlight that has passed through a solar cell to improve generation efficiency; and causing the layer to reflect or absorb ultraviolet light to prevent the deterioration of a constituent for the laminated sheet for a solar cell of the present invention by ultraviolet light and to improve various characteristics of the laminated sheet for a solar cell such as weatherability, durability, heat resistance, thermal dimensional stability, and a strength. The whitening of the layer is particularly effective in terms of the improvement in generation efficiency by the reflection of sunlight.
Further, the design and decoration of a solar cell module can be improved by coloring the layer in various ways typified by blackening.
It should be noted that the term "light reflection" in the light-reflective colored layer comprehends light scattering as well as light reflection.

A method involving dispersing and adding a pigment as a colorant and a method involving adding a polymer or fine particles incompatible with a base material and forming gaps or air bubbles at a blend interface at the time of the orientation of the film can each be employed as a method of coloring the layer.

Preferred examples of the pigment to be used for coloring include a white pigment and a black pigment. Although the white pigment is not particularly limited, for example, calcium carbonate, anatase-type titanium oxide, rutile-type titanium oxide, zinc oxide, lead carbonate, barium sulfate, basic lead carbonate, basic lead sulfate, basic lead silicate, zinc white, zinc sulfide, or lithopone can be used as the pigment. Rutile-type titanium oxide is preferred to anatase-type titanium oxide because of the following reason. Rutile-type titanium oxide reduces the extent of the yellowing after long-term irradiation with rays, and is hence suitable for suppressing a change in color difference.
Of the above-mentioned white pigments, inorganic fine particles of at least one kind selected from the group consisting of rutile-type titanium oxide, barium sulfate, calcium carbonate, and silicon dioxide are preferred in terms of stability and a non-heavy metal compound. Barium sulfate or rutile-type titanium oxide is more preferred, and barium sulfate is still more preferred.

Barium sulfate is stable both physically and chemically, is a good white material showing reflectances of 99% or more for visible light rays over substantially the entire region, and is a substance used as a reference for a white color. In addition, barium sulfate is a material having high coloring property and high opacifying property, and hence enables efficient whitening and exerts a high ray-reflecting effect when used in a back sheet for a solar cell.

Although the black pigment is not particularly limited either, carbon black, black iron oxide, or the like is used as the pigment. Of those, the carbon black is preferably used from the viewpoint of, for example, long-term stability. For example, a dye or a pigment is added to any such resin as described above in order that any other color (such as a blue color, a red color, or a yellow color) may be expressed. Of those, the pigment is preferably added from the viewpoint of long-term stability.

Although the above-mentionedpolyphenylene ether-based resin composition is formed by adding the above-mentioned components to the polyphenylene ether, a commercial product in which the components have been mixed in advance may be purchased and used.
The commercially available polyphenylene ether-based resin composition is as described in the foregoing.

The polyphenylene ether-based resin layer in the present invention 5 can be produced by a conventionally known method.
The respective compounding agents may be kneaded in advance, or may be collectively kneaded at the time of film formation.
Although a molding method is the same as that in each of the present inventions 1 and 2, for example, a method involving subj ecting the polyphenylene ether-based resin layer and the layer (IV) to co-extrusion to provide the laminated sheet for a solar cell of the present invention is also available.

In order that the extrusion molding may be performed, a shearing viscosity measured with a Koka-type flow tester is preferably 50 Pa·s (500 poise) or more, more preferably 100 Pa·s (1,000 poise) or more, still more preferably 500 Pa·s (5, 000 poise) or more when a shear rate at 300°C is 100 sec⁻¹. As long as the shearing viscosity falls within the range, troubles such as excessive deterioration of physical properties hardly occur. In addition, the shearing viscosity is preferably 5,000 Pa·s (50,000 poise) or less, more preferably 3, 500 Pa·s (35,000 poise) or less, still more preferably 2, 000 Pa·s (20,000 poise) or less. A shearing viscosity within the range is preferred from the viewpoint of productivity because a molding machine is prevented from shouldering an excessive load owing to poor extrusion property.
The following approach is available for adjusting the shearing viscosity to any such value as described above. The molecular weight of the polyphenylene ether is adjusted, the ratio of a component such as a styrene-based resin, an ethylene-based resin, or a polyamide-based resin is adjusted, the kind and addition amount of the flame retardant are adjusted, or any other plasticizer or the like is added.

In the present invention 5, deflection temperature under load of the polyphenylene ether-based resin layer is preferably 100°C or more, more preferably 120°C or more, still more preferably 140°C or more in order that the heat resistance may be expressed. As long as the deflection temperature under load is 100°C or more, a trouble such as an increase in dimensional change due to insufficient heat resistance hardly occurs in a sealing step to be described later. In addition, an upper limit for the deflection temperature under load, which is not particularly determined, is preferably 200°C or less, more preferably 180°C or less, still more preferably 160°C or less. As long as the deflection temperature under load is 200°C or less, a trouble such as poor productivity due to an excessive increase in the above-mentioned shearing viscosity hardly occurs.

The deflection temperature under load of a two-component blend system of a polyphenylene ether and a polystyrene generally changes in a linear fashion depending on a compounding ratio, and the deflection temperature under load changes from about 190°C to about 80°C as the content of the polyphenylene ether changes from 100 mass% to 0 mass%. Therefore, raising the content of the polyphenylene ether is effective in increasing the deflection temperature under load. Reducing the addition amount of, for example, a flame retardant or plasticizer which lowers the deflection temperature under load, blending a high-heat resistant resin such as a polyphenylene sulfide or a polyamide, or compounding an inorganic filler is also effective.

### [Intermediate layer]

An intermediate layer is preferably formed in the layer (V) in the present invention 5 because the formation can increase the entire thickness of the laminated sheet for a solar cell, and can additionally improve the mechanical strength, the insulation characteristic, and the heat resistance. Details about the intermediate layer are the same as those about the intermediate layer according to each of the present inventions 1 and 2, and a polyphenylene sulfide-based resin or the like can also be used.

### [Gas barrier property layer]

Details about a gas barrier property layer are the same as those about the gas barrier property layer according to each of the present inventions 1 and 2, and specific examples and the like of the layer are also the same. An inorganic substance that constructs an inorganic thin-film layer, a material gas that can be used in chemical vapor deposition, a first raw material gas containing silicon, and a method of forming the inorganic thin-film layer of the gas barrier property film are also the same as those in the case of the gas barrier property layer according to each of the present inventions 1 and 2.

The surface contacting the layer (IV) of the layer (V) in the present invention 5 is formed as the polyphenylene ether-based resin layer. Further, the formation of the polyphenylene ether-based resin layer also on the surface opposite to the surface contacting the layer (IV) can facilitate the expression of long-term adhesiveness with a encapsulating material or a junction box, durability, and flame retardancy. In addition, the layer may be used as a multilayer construction in which the intermediate layer or the gas barrier property layer described above is formed.
The thicknesses of the polyphenylene ether-based resin layers when used in the multilayer construction, which is not particularly limited, account for preferably more than 50%, more preferably 65% or more, still more preferably 80% or more of the entire thickness so that characteristics of the polyphenylene ether-based resin layers such as flame retardancy, heat resistance, and a mechanical strength may be favorably exerted. In the present invention 5, that a thickness ratio of the polyphenylene ether-based resin layers with respect to the entire thickness exceeds 50% means that the total thickness of the respective polyphenylene ether-based resin layers including at least the surface contacting the layer (IV) accounts for more than 50% of the entire thickness of the layer (V).

In the case of such a construction that each of the above-mentioned layers is provided as a plurality of layers, or the case of a single polyphenylene ether-based resin layer, the entire thickness is preferably 25 µm or more, more preferably 50 µm or more, still more preferably 75 µm or more, still more preferably 100 µm or more. As long as the thickness falls within the range, a trouble such as an insufficient mechanical strength hardly occurs. In addition, an upper limit for the entire thickness, which is not particularly determined, is preferably 500 µm or less, more preferably 400 µm or less, still more preferably 300 µm or less in terms of practicality because an excessively large thickness reduces handleability.
It should be noted that the case where a plurality of polyphenylene ether-based resin layers having different compositions exist is also naturally included in the category of a construction formed only of a polyphenylene ether-based resin layer.

When each of the above-mentioned layers is provided as a plurality of layers, a method based on co-extrusion may be adopted, or a known adhesive or pressure-sensitive adhesive may be used. The polyphenylene ether-based resin layer in the present invention 5 can be easily provided as a plurality of layers because the layer shows an affinity for the adhesive or pressure-sensitive adhesive and hence has a strong adhesive force. In addition, a known approach such as a corona discharge treatment, a plasma treatment, or a flame treatment may be employed for the purpose of improving the affinity for the adhesive.

In addition, a side to serve as the outermost surface when the sheet is formed as a solar cell module, that is, the surface opposite to the surface contacting the layer (IV) may be subjected to a known hard coat treatment or antifouling treatment so as to be caused to express surface characteristics such as scratch resistance and antifouling property.
In addition, a treatment for forming irregularities on the surface of the sheet may be performed for the purposes of improving the sliding property of the surface and improving handleability at the time of the assembly or laying of the module. Arbitrary means such as a method involving embossing the film at the time of its molding, a method involving incorporating inorganic particles of silica, talc, or the like into the surface layer, or a method involving subjecting a layer containing inorganic particles to co-extrusion, cooling the layer to solidify the layer, and peeling the solidified layer may be employed for forming the irregularities on the surface. Of course, the surface may be smoothened by employing a known approach such as coating from the viewpoint of, for example, a design.

In the present invention, the layer (V) is preferably excellent in flame retardancy. It is preferred for safety reasons because, for example, the spread of fire upon occurrence of fire can be prevented by virtue of the flame retardancy. However, modules for solar cells poor in flame retardancy are not actively excluded in the present invention 5 because flame retardancy is not necessarily requested of all modules for solar cells depending on their applications and use situations.
Each of the sheets is evaluated for its flame retardancy by judging its burning behavior based on a burning test. As described in the foregoing, the polyphenylene ether is a resin excellent in flame retardancy, and such an approach as described below is available for imparting flame retardancy. The content of the polyphenylene ether in the polyphenylene ether-based resin layer is raised, the addition amount of the flame retardant is raised, the amount of a component such as a lubricant is reduced, or the thickness ratio of the polyphenylene ether-based resin layer with respect to the entire thickness is increased.

In general, as the laminated sheet for a solar cell is exposed to an external environment, hydrolysis resistance as one aspect of durability is needed for stably protecting a solar cell for a long time period. The sheet is evaluated for its hydrolysis resistance by measuring its physical properties after a promotion evaluation under an arbitrary environment. In order that the hydrolysis resistance may be imparted, the amount of a low-molecular weight component (such as an additive) has only to be reduced, or the amount of a composition having hydrolyzability (such as a polyamide, a polyester, or a polycarbonate) has only to be reduced. The mixing of a hydrolysis inhibitor (such as a carbodiimide) is also permitted.

A mechanical strength typified by, for example, an elastic modulus in tension or a tensile elongation at break is needed for handleability in the step of forming a module, the protection of a cell from an external impact after the installation of the module, or the like. In order that the mechanical strength may be imparted, the thickness of the layer (V) has only to be increased or a component having impact resistance such as an elastomer has only to be added.

The storage modulus of the layer (V) in the present invention 5 has only to be appropriately adjusted in consideration of, for example, the shape and thickness of a solar cell to be applied, and the place where the solar cell is installed. For example, the layer has only to show a storage modulus (E') at a temperature of 20°C of preferably 1,000 MPa or more, more preferably 1,500 MPa or more, still more preferably 2,000 MPa or more when subjected to dynamic viscoelasticity measurement under the conditions of an oscillation frequency of 10 Hz, a strain of 0.1%, and a rate of temperature increase of 3°C/min. It is suitable that the storage modulus should fall within such range because of the following reasons. Troubles such as the elongation and wrinkling of the film at the time of its conveyance hardly occur. In addition, even after the layer has been laminated and integrated with the layer (IV), handleability can be imparted in, for example, the step of forming the module to be described later. In addition, an upper limit for the storage modulus, which is not particularly limited, has only to be preferably 5,000 MPa or less, more preferably 4,000 MPa or less, still more preferably 3,000 MPa or less. It is suitable that the storage modulus should fall within such range because such a trouble as described below hardly occurs: the film is too hard to handle at the time of its conveyance. In order that the storage modulus may be adjusted to fall within the range, the storage modulus of the polyphenylene ether-based resin layer in the layer (V) has only to be adjusted, or the polyphenylene ether-based resin layer has only to be composited with any other layer having a high storage modulus.

In addition, a crosslinking step for a crosslinked EVA as a general encapsulating resin is performed at about 150°C for about 30 minutes. Therefore, the layer (V) in the present invention 5 must have heat resistance and show a small dimensional change in order that a trouble may be avoided in the step of forming the solar cell module (sealing step).

### <Laminated sheet for solar cell>

The laminated sheet for a solar cell of the present invention 5 is obtained by laminating and integrating the layer (IV) and the layer (V). A preferred range of the thickness of each of the layer (IV) and the layer (V) is as described in the foregoing, and the thickness ratio of each of the layers is not particularly limited, provided that it is suitable that the entire thickness of the laminated sheet for a solar cell of the present invention 5 should be preferably 100 µm or more, more preferably 150 µm or more, still more preferably 200 µm or more because handleability upon production of the solar cell module is not reduced, and should be preferably 1,000 µm (1.0 mm) or less, more preferably 800 µm or less, still more preferably 500 µm or less because a trouble such as the inhibition of productivity hardly occurs.

A conventionally known method can be employed as a method of laminating the layer (IV) and the layer (V) for producing the laminated sheet for a solar cell of the present invention 5 without any particular limitation. Specific examples of the method include a heating lamination method involving heating and crimping the layer (IV) and the layer (V) in a superimposed state to laminate the layers, an extrusion lamination method involving winding off the layer (V) or the layer (IV) upon extrusion of the layer (IV) or the layer (V) and crimping the layers with a cast unit portion or the like to laminate the layers, a co-extrusion method involving simultaneously extruding the layer (IV) and the layer (V), a dry lamination method, and a calendering method.
Two or more of those methods may be employed in combination. Of those, amethod involving laminating the layer (IV) by the extrusion lamination method in a state in which the layer (V) has been formed in advance is suitable because the method is excellent in productivity and improves the handleability of the encapsulating resin layer itself as the layer (IV).

In addition, as described later, a production process for the solar cell module may include a heat-crimping step to be performed at about 150°C for about 30 minutes for sealing a solar cell element and accelerating the crosslinking reaction of a encapsulating material. Therefore, upon lamination of the layer (IV) and the layer (V), such adhesiveness that the layers can be handled has only to be expressed. In the present invention 5, the adhesiveness can be improved even after the heat-crimping step, though whether the improvement can be achieved depends on a combination with the encapsulating resin layer to be applied. An interlayer peel strength between the layer (IV) and the layer (V) after the laminated sheet for a solar cell of the present invention 5 has been heat-treated under a pressure of 0.1 MPa (1 kgf/cm²) or more and 1.0 MPa (10 kgf/cm²) or less at 150°C for 30 minutes has only to be preferably 10 N/15 mm or more, more preferably 20 N/15 mm or more, still more preferably 30 N/15 mm or more. It is suitable that the peel strength should fall within such range because such a trouble as described below hardly occurs. At the time of the production process for the solar cell module, when the laminated sheet is used by being fixed to a structure such as a roof, or when the laminated sheet is used as a pliable module, the encapsulating resin layer and the outer layer sheet peel off each other, and hence moisture flows in or foreign matter is included. In addition, an upper limit for the peel strength, which is not particularly limited, is about 150 N/15 mm in terms of practicality because the laminated sheet has sufficient adhesiveness.

### [Solar cell module]

A solar cell module of the present invention is obtained by providing any one of the sheets for solar cells of the present inventions 1 to 5 described in the foregoing. Specifically, as illustrated in FIG.1, the solar cell module is obtained by: laminating a transparent substrate 10, a encapsulating resin layer 12A, solar cell elements 14A, 14B, a encapsulating resin layer 12B, and a sheet 16 for a solar cell (back sheet in this case) of the present invention in the stated order from a sunlight-receiving side; and bonding a junction box 18 (terminal box that connects a wiring for taking electricity generated from the solar cell elements to an outside) to the lower surface of the sheet 16 for a solar cell. The solar cell elements 14A and 14B are coupled with each other by a wiring 20 for conducting a generated current to the outside. The wiring 20 is taken to the outside through a through-hole (not shown) provided for the sheet 16 for a solar cell so as to be connected to the junction box 18.
The infiltration of moisture into the solar cell module causes its deterioration. Accordingly, upon mounting of an accessory like the junction box, sealing property must be sufficiently secured lest outside air should infiltrate into the solar cell module. However, according to the sheet for a solar cell of the present invention, the infiltration of the outside air can be easily and surely prevented because the sheet can be bonded by a heat treatment alone.

Glass, or a monolayer or multilayer plastic sheet of an acrylic resin, a polycarbonate, a polyester, a fluorine-containing resin, or the like is used as the transparent substrate. In the case of the plastic, as in the case of the gas barrier property film that constructs the sheet for a solar cell, an inorganic thin film can be formed on the plastic for the purpose of imparting gas barrier property, a crosslinking agent, an antioxidant, a light stabilizer, a UV absorber, an antistatic agent, a reinforced fiber, a flame retardant, an antiseptic, or the like can be added to the plastic for the purpose of improving heat resistance, weatherability, a mechanical strength, chargeability, dimensional stability, or the like, or various sheets and/or films can be laminated on the plastic. The thickness of the transparent substrate canbe appropriately set in terms of, for example, a strength, gas barrier property, and durability.

When the laminated sheet for a solar cell of any one of the present inventions 1 to 4 is used, any of various resins each of which combines translucency, shock absorption, and adhesiveness for a transparent substrate, a solar cell element, or a sheet for a solar cell is used for the encapsulating resin layer. Examples thereof include polyolefin-based resins (ethylene-based resins including a copolymer of ethylene with one kind or two or more kinds of copolymer components of α-olefins or the like such as 1-butene, 1-hexene, 1-octene, 1-decene, and 4-methyl-1-pentene, an ethylene/propylene copolymer, an ethylene/1-butene copolymer, anethylene/propylene/non-conjugated diene copolymer, an ethylene/ethyl acrylate copolymer, an ethylene/glycidyl methacrylate copolymer, an ethylene/vinyl acetate/glycidyl methacrylate copolymer, and an ethylene/propylene-g-maleic anhydride copolymer), an ethylene-vinyl acetate-based resin, an ionomer resin, a polyvinylbutyral-based resin, a silicone-based resin, an epoxy-based resin, and an acrylic resin. Of those, a polyolefin-based resin and an ethylene-vinyl acetate-based resin are preferred. It should be noted that a encapsulating resin layer having a thickness of 50 µm to 600 µm is generally used.

In addition, a radical generator, a crosslinking agent, an antioxidant, a light stabilizer, a UV absorber, and the like can be added to the encapsulating resin layer.
The polyphenylene ether-based resin layer is preferred because the layer has an affinity for an olefin-based resin or an ethylene-vinyl acetate-based resin and hence can express good adhesiveness. Further, the incorporation of a radical generator to be described later into any such resin causes active hydrogen which the polyphenylene ether has and a radical to react with each other, thereby resulting in the formation of a crosslinked structure. As a result, adhesiveness between both layers can be significantly improved.
The radical generator, which is not particularly limited, is, for example, an organic peroxide, an azo compound such as azobisisobutyronitrile (AIBN) or a polymer azo compound, or an organometallic compound such as allyltin or triethylborane. Of those, an organic peroxide to be described later is preferably used

It should be noted that when the polyolefin-based resin or the ethylene-vinyl acetate-based resin is used in a encapsulating resin layer, any such resin is preferably compounded with a crosslinking agent to have a crosslinked structure for the purposes of, for example, improving its heat resistance and increasing its mechanical strength. Organic peroxides, silane coupling agents, and the like are each used as the crosslinking agent. Of those, each of the organic peroxides is preferably used because the organic peroxides each serve as the above-mentioned radical generator as well. An organic peroxide that generates a radical at 100°C or more and has a 10-hour half life decomposition temperature of 70°C or more is particularly suitably used from the viewpoints of a reaction rate and safety at the time of compounding.
As such organic peroxides, there can be preferably used, for example: 2,5-dimethylhexane-2,5-dihydroperoxide; 2,5-dimethyl-2,5-di(t-butylperoxy)hexane; di-t-butyl peroxide; dicumyl peroxide; 2,5-dimethyl-2,5-di(t-butylperoxy)hexyne; dicumyl peroxide; α,α'-bis(t-butylperoxyisopropyl)benzene; n-butyl-4,4-bis(t-butylperoxy)butane; 2,2-bis(t-butylperoxy)butane; 1,1-bis(t-butylperoxy)cyclohexane; 1,1-bis(t-butylperoxy)-3,3,5-trimethylcyclohexane; t-butyl peroxybenzoate; and benzoyl peroxide. Any such organic peroxide is compounded at a content of preferably 5 parts by mass or less, more preferably 3 parts by mass or less with respect to 100 parts by mass of the base resin to the advantage of a molding processing. In addition, the content is preferably 0.25 part by mass or more, more preferably 0.5 part by mass or more, still more preferably 0.75 part by mass or more in order that a crosslinking reaction may be advanced.
In addition, to the silane coupling agent, the antioxidant, the light stabilizer, and the UV absorber, applicable are the silane coupling agent, antioxidant, weathering stabilizer, and UV absorber used for the layer (IV) of the present invention 5, respectively.

Inaddition, in the case where encapsulating resin layers are used at two or more sites in the solar cell module when the laminated sheet for a solar cell of the present invention 5 is used, encapsulating resin layers each formed of the same composition as the resin composition that constructs the layer (IV) in the present invention 5 may be used in all sites, or encapsulating resin layers formed of different resin compositions may be used. Although the encapsulating resin layer must be transparent when used in a site requested to have light permeability, the encapsulating resin layer as the layer (IV) may not be transparent when used as a lower protective material.

The solar cell elements are placed and wired between the encapsulating resin layers. Examples of the elements include single-crystalline silicon-type elements, polycrystalline silicon-type elements, amorphous silicon-type elements, various compound semiconductor-type elements, dye sensitization-type elements, and organic thin-film elements.

A method of producing the solar cell module when any one of the sheets for solar cells of the present inventions 1 to 5 is used as a back sheet, which is not particularly limited, generally includes a step involving laminating the transparent substrate, the encapsulating resin layer, the solar cell elements, the encapsulating resin layer, and the sheet for a solar cell in the stated order, and a step involving subjecting the laminated products to vacuum suction and crimping the products under heat.
The solar cell module can be suitably used in various applications irrespective of whether the module is small or large and whether the module is used indoors or outdoors because the sheet for a solar cell is excellent in durability, flame retardancy, and dimensional stability, and has a high mechanical strength.

### Examples

Next, the present inventions 1 to 5 are described more specifically by way of examples. However, the present invention is by no means limited by these examples.
It should be noted that a sheet to be used as a sheet for a solar cell and a sheet to be used as a encapsulating material to be used in each of examples and comparative examples are described below by listing specific examples of the sheets.

### [Sheet to be used as sheet for solar cell] PPE1

A resin sheet having a thickness of 50 µm was produced by: extruding a polyphenylene ether-based resin composition (deflection temperature under load; 150°C, polyphenylene ether content: 89 mass%, triphenyl phosphate content: 7 mass%, manufactured by SABIC Innovation Plastics, trade name "Noryl N300") with an extruder having a diameter of 65 mm from a monolayer mouthpiece having a width of 1,150 mm (with its temperature set to 300°C) while setting a barrel temperature to 240 to 300°C; cooling the extruded composition with a cast roll set to 80°C to solidify the composition; and adjusting the velocity of the cast roll.

### PPE2

A resin sheet was produced in the same manner as in the PPE1 except that the thickness was changed from 50 µm to 220 µm by adjusting the velocity of the cast roll.

### PPE3

A resin sheet was produced in the same manner as in the PPE1 except that the thickness was changed from 50 µm to 100 µm by adjusting the velocity of the cast roll.

### PPE4

A sheet having a thickness of 50 µm was produced in the same manner as PPE1 except that a polyphenylene ether-based resin composition (deflection temperature under load; 90°C, manufactured by SABIC INNOVATION PLASTICS, trade name "Noryl N190X") was used and the temperature of the cast roll was set to 60°C.

### PET1

A polyethylene terephthalate (PET) resin film (manufactured by Toray Industries, Inc., trade name "Lumirror X10S", thickness: 50 µm) was used.

### PET2

AwhitePETresinfilm (manufactured by Toray Industries, Inc.., trade name "Lumirror E20", thickness: 188 µm) was used.

### PET3

A silica-deposited PET resin film (thickness: 12 µm) was used.

### PET4

A white PET resin film (containing 15 mass% of barium sulfate, thickness: 150 µm) was used.

### PEN1

A polyethylene naphthalate (PEN) resin film (manufactured by Teijin DuPont Films Japan Limited, trade name "Teonex Q51C", thickness: 25 µm) was used.

### PEN2

A PEN resin film (manufactured by Teij in DuPont Films Japan Limited, trade name "Teonex Q65F", thickness: 50 µm) was used.

### ETFE1

A polyethylenetetrafluoroethylene (ETFE) resin film (manufactured by ASAHI GLASS CO., LTD., trade name "Aflex", thickness: 25 µm) was used.

### COC1

A cyclic olefin-based copolymer (COC) resin (manufactured by Topas Advanced Polymers, trade name "TOPAS6015") was extruded with a twin screw extruder having a diameter of 25 mm and cooled to solidify with a cast roll at 80°C. Thus, a sheet having a thickness of 50 µm was obtained.

### PC1

A sheet having a thickness of 50 µm was obtained in the same manner as for COC1 except that a polycarbonate (PC) resin (manufactured by Sumitomo Dow Limited, trade name "Calibre 301") was used.

### PMMA1

A sheet having a thickness of 50 µm was obtained in the same manner as for COC1 except that a polymethyl methacrylate (PMMA) resin film (manufactured by Sumitomo Chemical Co. , Ltd. , trade name "SUMIPEX MH") was used.

### HDPE1

A resin film (thickness: 80 µm) containing 40 mass% of mica having a particle size of 30 µm with respect to 100 mass% of a high density polyethylene (HDPE) resin was used.

### AL1

An aluminum foil (thickness: 20 µm) was used.

### PP1

Apolypropylene (PP) resin film (thickness: 100 µm) containing a black pigment (carbon black) was used.

### [Sheet to be used as encapsulating material]

### EVA1

A VISTASOLAR (EVA resin) (thickness: 500 µm) manufactured by ETIMEX was used.

### EVA2

An EVAFLEX150 manufactured by DUPONT-MITSUI POLYCHEMICALS CO., LTD. was extruded with a twin screw extruder having a diameter of 25 mm and cooled to solidify with a cast roll at 40°C. Thus, a sheet having a thickness of 500 µm was obtained.

### PO1

A sheet having a thickness of 500 µm and containing a crosslinking agent was obtained in the same manner as in the foregoing, using a raw material in which 1.0 part by mass of a Luperox TBEC manufactured by ARKEMA YOSHITOMI, LTD. as a crosslinking agent had been added to 100 parts by mass of a TAFMER A4085 manufactured by Mitsui Chemicals, Inc.

### PO2

A BONDFAST 7M manufactured by Sumitomo Chemical Co. , Ltd. was extruded with a twin screw extruder having a diameter of 25 mm and cooled to solidify with a cast roll at 40°C. Thus, a sheet having a thickness of 500 µm was obtained.

### PO3

A sheet having a thickness of 500µm was obtained in the same manner as in the foregoing, using a raw material in which 0.5 part by mass of a SILQUEST manufactured by Momentive Performance Materials Inc. as a silane coupling agent had been added to 100 parts by mass TAFMER A4085 manufactured by Mitsui Chemicals, Inc.

### <Example A>

First, the sheets for a solar cell according to the present inventions 1 and 2 are specifically described by way of examples.

### (Example 1, and Comparative Examples 1 and 2)

Each of the PPE1, the PET1, and the PEN1 out of the above-mentioned sheets for solar cells was evaluated for its heat resistance, durability, and flame retardancy by the following evaluation methods. Table 1 shows the results.

### Heat resistance

Each sample was cut into a square piece measuring 100 mm by 100 mm, and then the sample was treated in a circulating type oven set to 150°C for 30 minutes. After that, the absolute value of a ratio of a dimensional displacement to the original size was measured in a percentage unit. The lager one of the values in the longitudinal direction of the film and the direction perpendicular thereto was recorded and evaluated by the following criteria.
ⓞ: 0.5% or less
○: 1.0% or less
△: 3.0% or less
×: More than 3.0%

### Durability

Each sample was treated in an advanced accelerated life tester (pressure cooker tester; EHS-211Mmanufactured by ESPEC Corp.) under the conditions of a temperature of 120°C, a humidity of 100%, and two atmospheric pressures for 144 hours. Then, the tensile stress at break of the sample taken out of the tester was measured in conformity with JIS K7127 under the conditions of a temperature of 23°C and a testing speed of 200 mm/min.
A ratio of the measured value after the accelerated test to the initial measured value was measured in a percentage unit and evaluated by the following criteria.
○: The retention rate is 80% or more.
△: The retention rate is 50% or more and less than 80%.
×: The retention rate is less than 50% or the sample shape cannot be maintained.

### Flame retardancy

Each sample was cut into a test piece measuring 200 mm long by 50 mm wide. The test piece was wound in its width direction so as to be of a cylindrical shape, and then its side surface was fixed with an adhesive tape. The cylinder was vertically fixed with a clamp, and then its lower end was brought into contact with a 20-mm flame from a gas burner for 3 seconds. The contact was performed twice. Then, the sample was evaluated for its flame retardancy on the basis of the following judgement criteria.
○: The time period for which the combustion lasts is 30 seconds or less and no drip of a molten resin occurs.
x: The time period for which the combustion lasts exceeds 30 seconds or the drip of a molten resin occurs.

[Table 1]

**Table 1**

| | Example 1 | Comparative Example 1 | Comparative Example 2 |
|---|---|---|---|
| Sheet for solar cell | PPE1 | PET1 | PEN1 |
| Thickness (µm) | 50 | 50 | 25 |
| Heat resistance | ⊚ | △ | ○ |
| | 0.4% | 1.2% | 0.9% |
| Durability | ○ | × | △ |
| Flame retardancy | ○ | × | × |

Example 1 revealed that the sheet for a solar cell of the present invention showed excellent heat resistance, excellent durability, and excellent flame retardancy. Comparative Examples 1 and 2 showed that the durability and the flame retardancy were poor when a polyester-based resin was used.

### (Examples 2 to 6 and Comparative Examples 3 to 5)

Next, the above-mentioned sheets for solar cells and the above-mentioned encapsulating materials were combined as shown in Table 2 below, and then adhesiveness between a sheet for a solar cell and a encapsulating material was evaluated as described below.

First, a encapsulating material sheet was interposed between two samples each cut out to measure 150 mm by 150 mm. After that, the resultant was treated with a hot-press apparatus with its pressure adjusted to 10 kgf/cm² or less and its temperature set to 150°C for 30 minutes. The resultant sample was treated in the above-mentioned pressure cooker tester under the conditions of a temperature of 120°C, a humidity of 100%, and two atmospheric pressures for 48 hours.
An untreated sample and a treated sample were each cut out to have a width of 15 mm, and then their 180° peel strengths were measured at a testing speed of 50 mm/min. Table 2 below shows the results. It should be noted that evaluation indicators in Table 2 are as described below.
⊚: The peel strength is 30 N or more.
○: The peel strength is 20 N or more.
△: The peel strength is 10 N or more.
×: The peel strength is less than 10 N.

[Table 2]

**Table 2**

| | Example 2 | Example 3 | Example 4 | Example 5 | Example 6 | Comparative Example 3 | Comparative Example 4 | Comparative Example 5 |
|---|---|---|---|---|---|---|---|---|
| Sheet for solar cell | PPE1 | PPE2 | PPE2 | PPE2 | PPE2 | ETFE1 | PET2 | PET2 |
| Thickness (µm) | 50 | 220 | 220 | 220 | 220 | 25 | 188 | 188 |
| Encapsulating material | EVA1 | EVA1 | EVA2 | PO1 | PO2 | EVA1 | EVA1 | PO1 |
| Crosslinking agent | Present | Present | Absent | Present | Absent | Present | Present | Present |
| Initialstage (untreated) | Unable to peel | ⊚ 95N | ○ 20N | ⊚ 40N | ○ 20N | × Less than 10 N | △ 15N | × Less than 10 N |
| After endurance test (treated) | Unable to peel | ⊚ 100N | ○ 20N | ⊚ 40N | ○ 20N | × Less than 10 N | × Less than 10 N | × Less than 10 N |

In Example 2, an accurate value for the peel strength could not be obtained because the base material (sheet for a solar cell) and the encapsulating material adhered to each other so strongly that the base material broke. Examples 3 and 5 showed that a encapsulating material containing a crosslinking agent (radical generator) expressed strong adhesiveness. Examples 4 and 6 showed that even a system free of any crosslinking agent (radical generator) showed adhesiveness equal to or higher than that of each of the ETFE and PET base materials.

### <Example B>

Next, the sheet for a solar cell according to the present invention 3 is specifically described by way of examples.

Here, a curable adhesive using a polyester-based adhesive "DYNAGRAND IS-063" manufactured by TOYO INK CO., LTD. as a main agent and a polyisocyanate-based curing agent "DYNAGRAND LCR-085" manufactured by TOYO INK CO., LTD. as a curing agent was used for interlayer bonding in the case of a multilayer construction. After 100 mass% of the main agent had been mixed with 12.5 mass% of the curing agent, the mixture was diluted with ethyl acetate, and then the resultant was applied with a bar coater so as to have a thickness of 5 µm after drying.

First, each of the PPE1, the PET1, the PEN1, the COC1, and the ETFE1 out of the above-mentioned sheets for solar cells was evaluated for its junction box adhesiveness as described below as well as for its heat resistance, durability, and flame retardancy as described above. Table 3 shows the results.

### Junction box adhesiveness

A silicone sealant ("TSE392" manufactured by Momentive Performance Materials Inc.) was applied to the surface of each sample (thickness after drying: 500 µm), and was then evaluated for its adhesive force.
○: The sealant satisfactorily adheres.
×: The sealant is floating or peeling, or adheres but can be easily peeled.

[Table 3]

**Table 3**

| | Reference Example 1 | Reference Example 2 | Reference Example 3 | Reference Example 4 | Reference Example 5 |
|---|---|---|---|---|---|
| | PPE1 | PET1 | PEN1 | COC1 | ETFE1 |
| Thickness (µm) | 50 | 50 | 25 | 50 | 25 |
| Heat resistance | ⊚ | △ | ○ | △ | △ |
| | 0.4% | 1.2% | 0.9% | 1.8% | 1.4% |
| Durability | ○ | × | △ | ○ | ○ |
| Flame retardancy | ○ | × | × | × | ○ |
| Junction box adhesiveness | ○ | ○ | ○ | ○ | × |

As is apparent from Reference Example 1, the use of the PPE results in excellent heat resistance, excellent durability, excellent flame retardancy, and excellent junction box adhesiveness. Reference Examples 2 and 3 show that the use of a polyester-based resin, i.e., the PET or the PEN results in poor durability and poor flame retardancy. Reference Example 4 shows that the use of the COC results in poor flame retardancy. Reference Example 5 shows that the use of the ETFE results in poor junction box adhesiveness.

In addition, an evaluation for adhesiveness between a sheet for a solar cell and the junction box in Example B was performed in the same manner as in the evaluation for adhesiveness in each of Examples 2 to 6 and Comparative Examples 3 to 5 of Example A.

Next, a sheet for a solar cell was produced according to a construction shown in Table 4 below. A method of measuring gas barrier property is as described below.

### Gas barrier property

Table 3 shows a value for a water vapor permeability (unit: g/m²·24 hr) measured in conformity with JIS K7129 under the conditions of a temperature of 40°C and a humidity of 90%.

[Table 4]

**Table 4**

| | Example 7 | Example 8 | Example 9 | Example 10 | Comparative Example 6 | Comparative Example 7 | Comparative Example 8 |
|---|---|---|---|---|---|---|---|
| Layer (I) | PPE1 | PPE1 | PPE3 | PPE1 | PET1 | ETFE1 | COC1 |
| Layer (II) | AL1 | PET3 | HDPE1 | COC1 | AL1 | COC1 | - |
| Layer construction (µm) | PPE1 50 | PPE1 50 | PPE3 100 | PPE1 50 | PET 50 | ETFE1 25 | COC1 50 |
| | AL1 20 | PET3 12 | HDPE1 80 | COC1 50 | AL1 20 | COC1 50 | |
| | PPE1 50 | PPE1 50 | | PPE1 50 | PET2 188 | ETFE1 25 | |
| Layer (I) | 83 | 89 | 56 | 67 | - | - | - |
| Thickness ratio | | | | | | | |
| Layer (II) | 0.1 or less | 0.7 | 1.2 | 0.8 | 0.1 or less | 0.8 | 0.8 |
| Gas barrier property | | | | | | | |

Examples 7 to 10 are each excellent in reliability as a sheet for a solar cell because each of the examples has the layer (I) excellent in heat resistance, durability, flame retardancy, and junction box adhesiveness, and the layer (II) having gas barrier property. In particular, each of Examples 7, 8, and 10 is excellent in encapsulating material adhesiveness because the PPE contacts the encapsulating material (see Examples 2 to 6), and Example 9 is excellent in encapsulating material adhesiveness because the polyolefin-based resin contacts the encapsulating material. Each of Examples 7 and 8 can express the heat resistance, durability, and flame retardancy additionally satisfactorily because the thickness ratio of the layer (I) (ratio of the layer (I) with respect to the entire thickness) is large. In addition, Example 9 is excellent from the viewpoint of productivity as well because the example is of a simplified construction.
Comparative Example 6 is poor in durability and flame retardancy because the polyester-based resin is exposed to the outer surface, and is poor in encapsulating material adhesiveness because the polyester-based resin contacts the encapsulating material (see Comparative Examples 4 and 5). Comparative Example 7 cannot express sufficient adhesiveness with each of the junction box and the encapsulating material because the fluorine-based resin is placed on each of both surfaces. Comparative Example 8 is poor in flame retardancy (see Reference Example 4).

### <Example C>

Next, the sheet for a solar cell according to the present invention 4 is specifically described by way of examples. Here, the interlayer bonding in the case of a multilayer construction was, unless otherwise stated, conducted in the same manner as in Example B.

It should be noted that as shown in the following reference examples, when a product obtained by forming an inorganic thin-film layer on a base material is adopted as a gas barrier property layer serving as the layer (II), the placement of a specific weatherproof coat layer on the base material is effective in terms of combination.

Gas barrier property film: A biaxially oriented PET film having a thickness of 12 µm ("H100C12" manufactured by Mitsubishi Plastics, Inc.) was used as a base material film. One surface of the film was subj ected to a corona treatment, and then a weatherproof coat liquid shown in Table 5 was applied to the surface by a gravure coating method, followed by drying. Thus, a weatherproof coat layer having a thickness of 0.1 µm was formed.
Next, SiO was evaporated with a vacuum deposition apparatus in a vacuum of 1×10⁻⁵ Torr according to a high-frequency heating mode. Thus, a gas barrier property film having an SiOx (x=1.7) thin film having a thickness of 20 nm on the coat layer was obtained.
Here, the composition of the inorganic thin film was analyzed with an ESCA-3400 manufactured by Shimadzu Corporation, and the thickness of the inorganic thin film was determined by embedding the gas barrier property film in a resin, producing an ultra-thin slice in a sectional direction of the resultant, and observing the ultra-thin slice with a transmission electron microscope.

Weatherproof coat liquid: The following raw materials were mixed at a ratio shown in Table 5 to prepare weatherproof coat liquid.
PCL1: (polycaprolactonediol) "PLACCEL 205" manufactured by Daicel Chemical Industries Limited
EPX1: (epoxy resin) "DENACOL EX252" manufactured by Nagase ChemteX Corporation
PCD1: (polycarbonatediol) "NIPPOLAN 982R" manufactured by Nippon Polyurethane Industry Co., Ltd.
ICN1: (isocyanate resin) "CORONATE L" manufactured by Nippon Polyurethane Industry Co., Ltd.
PVB1: (polyvinylbutyral resin) "S-LEC BL-1" manufactured by SEKISUI CHEMICAL CO., LTD.
ACR1: (acrylic copolymer) Under a nitrogen gas stream, a raw material formed of the following polymerizable monomer components was mixed with 1 mass% of a polymerization initiator (benzoyl peroxide) in ethyl acetate at 80°C, to prepare an acrylic copolymer.

### [Polymerizable UV-stable monomer]

4-Methacryloyloxy-2,2,6,6-tetramethylpiperidine (3 mass%)

### [Polymerizable UV-absorbing monomer]

2-[2'-Hydroxy-5'-(methacryloyloxyethyl)phenyl]-2H-benzotriazol e (1 mass%)

### [Cycloalkyl (meth)acrylate]

Cyclohexyl methacrylate (40 mass%)

### [Polymer unsaturated monomer having hydroxyl group]

Hydroxyethyl methacrylate (5 mass%)

### [Other polymer unsaturated monomers]

n-Butyl methacrylate (20 mass%)

n-Butyl acrylate (30.5 mass%)

### Methacrylic acid (0.5 mass%)

ICN2: (isocyanate resin) "Sumidur N-3200" manufactured by Sumitomo Bayer Urethane Co., Ltd.

An evaluation sheet was obtained by compositing the above-mentioned gas barrier property film with the above-mentioned PET4 and PEN2 as described below.
An adhesive was applied to the PEN2 that had been subjected to a corona treatment, and then the PEN2 was attached to the inorganic thin-film surface of the gas barrier property film. Next, an adhesive was applied to the PET4 that had been subjected to a corona treatment, and then the PET4 was attached to the PET surface of the gas barrier property film.
A mixture of an "AD-76P1" and a "CAT-10L" manufactured by Toyo-Morton, Ltd. was used as each adhesive, and its thickness after drying was set to 10 g/cm².

### Water vapor permeability

A glass plate, an ethylene-vinyl acetate copolymer (EVA) sheet (Mitsui Chemicals Fabro, Inc., "SOLAREVA SC4"), and the back sheet for a solar cell thus produced were superimposed, and a peeling film was interposed between the EVA sheet and the back sheet at the central portion of the gap. In the foregoing form, crimp was performed in a vacuum at 150°C for 15 minutes so that the plate and the sheets were integrated. Further, the integrated product of the glass plate, the EVA sheet, and the back sheet for a solar cell was heated at 150°C for 30 minutes. After the plate and the sheets had been stored at 85°C and 85RH% for 1,000 hours or 3,000 hours, the back sheet at a peeling film area portion was cut out and air-dried for 2 days at room temperature. Then, the water vapor permeability of the back sheet was measured with a water vapor permeability apparatus (Model 7002 manufactured by Illinois Instruments) under the conditions of 40°C and 90RH%.

[Table 5]

**Table 5**

| | Reference Example 6 | Reference Example 7 | Reference Example 8 | Reference Example 9 | Reference Example 10 |
|---|---|---|---|---|---|
| Weatherproof coat layer | Coat liquid 1 | Coat liquid | Coat liquid 2 3 | Coat liquid 4 | None |
| | PCL1 | PCD1 | PVB1 | ACR1 | |
| | EXP1 | ICN1 | EXP1 | ICN2 | |
| Equivalent ratio | 1:2^{*1} | 1:1^{*2} | 1:1^{*1} | 1:1^{*2} | |
| Water vapor permeability | | | | | |
| Promotion for 1,000 hours Promotion for 3,000 hours | 0.6 | 0.6 | 0.5 | 0.3 | >50 |
| | 0.9 | 0.9 | 0.7 | 0.5 | >50 |

| | | | | | |
|---|---|---|---|---|---|
| *1 The equivalent ratio of an epoxy group with respect to a hydroxyl group *2 The equivalent ratio of an isocyanate group with respect to a hydroxyl group | | | | | |

Reference Examples 6 to 10 show that the placement of the weatherproof coat layer retains the water vapor permeability after the wet heat resistance test. Reference Example 10 shows that the value for the water vapor permeability of a product with no weatherproof coat layer is increased (its gas barrier property is reduced) by the treatment for 1,000 hours.

Here, Reference Examples 1 to 5 of Table 3 described above were used as references for the heat resistance, durability, flame retardancy, and junction box adhesiveness of the sheet for a solar cell in the present invention 4. In addition, Examples 2 to 6 and Comparative Examples 3 to 5 of Table 2 described above were each used as a reference for the adhesiveness between the sheet for a solar cell and the encapsulating material in the present invention 4.

Next, a sheet for a solar cell was produced according to a construction shown in Table 6 below. Methods of measuring evaluation items except the above-mentioned gas barrier property are as described below. It should be noted that a reference was made to Table 4 for the gas barrier property.

### Opacifying property

Each sample was cut into a 50-mm square size, and then its light transmittances were measured with a spectrophotometer provided with an integrating sphere ("U-4000" manufactured by Hitachi, Ltd.) at wavelengths from 240 nm to 800 nm and a scanning period of 0.5 nm. Table 6 shows the maximum of the light transmittances at 300 nm to 400 nm.

### Reflecting property

Each sample was cut into a 50-mm square size, and then its light reflectance were measured with a spectrophotometer provided with an integrating sphere ("U-4000" manufactured by Hitachi, Ltd.) at wavelengths from 240 nm to 800 nm and a scanning period of 0.5 nm. Table 6 shows the average values of the light reflectance at 400 nm to 700 nm.

[Table 6]

**Table 6**

| | Example 11 | Example 12 | Example 13 | Example 14 | Comparative Example 9 | Comparative Example 10 | Comparative Example 11 |
|---|---|---|---|---|---|---|---|
| Layer (I) | PPE1 | PPE2 | PPE1 | PPE1 | PEN1 | ETFE1 | PET1 |
| Layer (II) | AL1 | PET3 | PET3 | COC1 | AL1 | COC1 | PET3 |
| layer (III) | HDPE1 | HDPE1 | PP1 | PP1 | PET2 | ETFE1 | PP1 |
| Layer construction (µm) | PPE1 50 | PPE2 100 | PPE1 50 | PPE1 50 | PEN1 25 | ETFE1 25 | PET1 50 |
| | AL1 20 | PET3 12 | PET3 12 | COC1 50 | AL1 20 | COC1 50 | PET3 12 |
| | HDPE1 100 | HDPE1 100 | PP1 100 | PP1 100 | PET2 188 | ETFE1 25 | PP1 100 |
| | | | | | | | |
| Layer(II) Gas barrier property | 0,1 or less | 0.7 | 1.2 | 0.8 | 0.1 or less | 0.8 | 0.7 |
| Layer (III) Opacifying property | 2 | 2 | 1 | 1 | 3 | 92 | 1 |
| Layer (III) Reflecting property | 76 | 76 | - | - | 92 | - | - |

Examples 11 to 14 are each excellent in reliability as a sheet for a solar cell because each of the examples includes the layer (I) excellent in heat resistance, durability, flame retardancy, and adhesiveness, the layer (II) having barrier property, and the layer (III) having light-blocking property. In addition, Examples 11 to 14 are each excellent in encapsulating material adhesiveness because the polyolefin-based resin contacts the encapsulating material. Further, Examples 11 and 12 are preferred because each of the examples has reflecting property and hence can contribute to an improvement in generation efficiency when used as a solar cell module. In addition, Examples 13 and 14 are preferred in an application where a design is requested and an application where a cell temperature is increased so that generation efficiency may be improved because the examples have black external appearances. It should be noted that Examples 11 to 14 are excellent from the viewpoint of productivity as well because each of the examples is of a simplified construction.
Comparative Examples 9 and 11 are each poor in durability and flame retardancy because the polyester-based resin is exposed to the outer surface (see Reference Examples 2 and 3). In particular, Comparative Example 9 is poor in encapsulating material adhesiveness because the polyester-based resin contacts the encapsulating material. Comparative Example 10 cannot express sufficient adhesiveness with each of the junction box and the encapsulating material because the fluorine-based resin is placed on each of both surfaces (see Comparative Example 3 and Reference Example 5). In addition, the following trouble occurs because light passes through the sheet. The sheet undergoes weathering discoloration (yellowing).

### <Example D>

Next, the laminated sheet for a solar cell according to the present invention 5 is specifically described by way of examples.

First, each of the PPE1, the PET1, the PEN1, the COC1, the ETFE1, the PC1, and the PMMA1 out of the above-mentioned sheets constructing the laminated sheet solar cell was evaluated for its durability, flame retardancy, and junction box adhesiveness by the evaluation method described above. Table 7 shows the results.

[Table 7]

**Table 7**

| | Reference Example 11 | Reference Example 12 | Reference Example 13 | Reference Example 14 | Reference Example 15 | Reference Example 16 | Reference Example 17 |
|---|---|---|---|---|---|---|---|
| | PPE1 | PET1 | PEN1 | COC1 | ETFE1 | PC1 | PMMA1 |
| Thickness (µm) | 50 | 50 | 25 | 50 | 25 | 50 | 50 |
| Durability | ○ | × | △ | ○ | ○ | × | △ |
| Flame retardancy | ○ | × | × | × | ○ | ○ | × |
| Junction box adhesiveness | ○ | ○ | ○ | ○ | × | ○ | ○ |

As is apparent from Reference Example 11, the use of the PPE results in excellent durability, excellent flame retardancy, and excellent junction box adhesiveness. Reference Examples 12 and 13 show that the use of a polyester-based resin, i.e., the PET or the PEN results in poor durability and poor flame retardancy. Reference Examples 14 and 17 show that the use of the COC and the PMMA results in poor flame retardancy. Reference Example 15 shows that the use of the ETFE results in poor junction box adhesiveness. Reference Example 16 shows that the use of the PC results in durability.

Next, the laminated sheet of the present invention 5 was produced by: laminating the layer (IV) and the layer (V) out of the sheets to be used as sheets for solar cells and the sheets to be used as encapsulating materials described above according to a construction shown in Table 8; and treating the resultant with a hot-press apparatus with its pressure adjusted to 0.1 MPa (1 kgf/cm²) or more and 1.0 MPa (10 kgf/cm²) or less and its temperature set to 150°C for 30 minutes. Then, the heat resistance and storage modulus of the layer (V), and an interlayer peel strength between the layer (IV) and the layer (V) were evaluated as described below. Table 8 shows the results.

### Dimensional stability (Heat resistance)

Each sample was cut into a square piece measuring 100 mm by 100 mm, and then the sample was treated in a circulating type oven set to 150°C for 30 minutes. After that, the absolute value of a ratio of a dimensional displacement of the layer (V) to the original size was measured in a percentage unit. The lager one of the values in the longitudinal direction of the film and the direction perpendicular thereto was recorded, and its dimensional stability was evaluated by the following criteria.
⊚: 0.5% or less
○: More than 0.5% and 1.0% or less
△: More than 1.0% and 3.0% or less
×: More than 3.0%

### Storage modulus

The dynamic viscoelasticity of a sample (measuring 4 mm wide by 60 mm long) was measured with a viscoelasticity-measuring apparatus available under the trade name "Viscoelasticity Spectrometer DVA-200" from IT Keisoku Co., Ltd. at an oscillation frequency of 10 Hz, a strain of 0.1%, a rate of temperature increase of 3°C/min, and a chuck-to-chuck distance of 25 mm for its lateral direction (the direction perpendicular to the direction in which the sheet flowed from an extruder or the direction perpendicular to the longitudinal direction of a roll) until the sample started to melt at -150°C to preclude the measurement. A storage modulus (E') (MPa) at 20°C was determined from the resultant data and evaluated by the following criteria.
⊚: 2,000 MPa or more
○: 1,500 MPa or more and less than 2,000 MPa
△: 1,000 MPa or more and less than 1,500 MPa
x: Less than 1,000 MPa

### Peel strength

Each sample was cut into a square piece measuring 150 mm by 150 mm, and then the sample was treated in the pressure cooker tester under the conditions of a temperature of 120°C, a humidity of 100%, and two atmospheric pressures for 48 hours.
An untreated sample and a treated sample were each cut out to have a width of 15 mm, and then their 180° peel strengths were measured at a testing speed of 50 mm/min. The results were evaluated by the following criteria.
⊚: The peel strength is 30 N/15 mm or more.
○: The peel strength is 20 N/15mm or more and less than 30N/15 mm.
△: The peel strength is 10 N/15 mm or more and less than 20N/15 mm.
×: The peel strength is less than 10 N/15 mm.

[Table 8]

**Table 8**

| | | Example 15 | Example 16 | Example 17 | Example 18 | Example 19 | Example 20 | Comparative Example 12 | Comparative Example 13 | Comparative Example 14 | Comparative Example 15 |
|---|---|---|---|---|---|---|---|---|---|---|---|
| Layer (IV) | | EVA1 | EVA1 | PO1 | P03 | EVA2 | PO2 | EVA1 | EVA1 | PO1 | EVA1 |
| | Thickness (µm) | 50 | 50 | 50 | 50 | 50 | 50 | 50 | 50 | 50 | 50 |
| | Storage modulus (MPA) | 8 | 8 | 30 | 30 | 10 | 4 | 8 | 8 | 30 | 8 |
| | Radical generator or silane coupling agent | Present | Present | Present | Present | Absent | Absent | Present | Present | Present | Present |
| Layer (V) | | PPE1 | PPE2 | PPE2 | PPE2 | PPE2 | PPE2 | ETFE1 | PET2 | PET2 | PPE4 |
| | Thickness | 50 | 220 | 220 | 220 | 220 | 220 | 25 | 188 | 88 | 50 |
| | Dimension ratio (%) | ⊚ 0.4 | ⊚ 0.4 | ⊚ 0.4 | ⊚ 0.4 | ⊚ 0.4 | ⊚ 0.4 | △ 1.4 | △ 1.2 | △ 1.2 | × 3.5 |
| | Storage modulus (MPa) | ⊚ 2,200 | ⊚ 2,200 | ⊚ 2,200 | ⊚ 2,200 | ⊚ 2,200 | ⊚ 2,200 | △ 1,100 | ⊚ 4,300 | ⊚ 4,300 | ⊚ 2,300 |
| Interlayer | Untreated Peel strength (N/15 mm) | Unableto peel | ⊚ 95 | ⊚ 40 | ⊚ 30 | ○ 20 | ○ 20 | × Less than 10 | △ 15 | × Less than 10 | Unable to peel |
| | After treatment Peel strength (N/15 mm) | Unableto peel | ⊚ 100 | ⊚ 40 | ⊚ 30 | ○ 20 | ○ 20 | × Less than 10 | × 10 | × Less than 10 | Unable to peel |

In Example 15, an accurate value for the peel strength could not be obtained because the base material (sheet for a solar cell) and the encapsulating material adhered to each other so strongly that the base material broke. Examples 15 to 17 showed that a encapsulating material containing a crosslinking agent (radical generator) expressed strong adhesiveness. Example 18 showed that a encapsulating material containing a silane coupling agent expressed strong adhesiveness. Examples 19 and 20 showed that even a system free of any radical generator or silane coupling agent showed adhesiveness equal to or higher than that of each of the ETFE and PET base materials (Comparative Examples 12 to 14). In addition, Comparative Example 15 showed that a product in which the deflection temperature under load of the PPE was low had insufficient heat resistance, though the product expressed strong adhesiveness.
In addition, Examples 15 to 20 were each excellent in heat resistance and handleability as a laminated sheet for a solar cell because each of the examples sufficiently satisfied desired values for heat resistance and a storage modulus.

### Reference Signs List

- 10: transparent substrate
- 12A, 12B: encapsulating resin layer
- 14A, 14B: solar cell element
- 16: sheet for solar cell
- 18: junction box
- 20: wiring

## Claims

1. A sheet for a solar cell of a monolayer construction, comprising a polyphenylene ether-based resin layer formed of a resin composition using a polyphenylene ether as a main component.

2. A sheet for a solar cell of a multilayer construction, comprising, as both outer layers, polyphenylene ether-based resin layers each formed of a resin composition using a polyphenylene ether as a main component.

3. A sheet for a solar cell, comprising at least one layer of each of the following layer (I) and the following layer (II):
layer (I): a layer formed of a resin composition using a polyphenylene ether as a main component; and
layer (II) : a gas barrier property layer having a water vapor permeability (measurement method: JIS K7129) of less than 10 g/m²·24 hr.

4. A sheet for a solar cell, comprising at least one layer of each of the following layer (I), the following layer (II), and the following layer (III):
layer (I): a layer formed of a resin composition using a polyphenylene ether as a main component;
layer (II) : a gas barrier property layer having a water vapor permeability (measurement method: JIS K7129) of less than 10 g/m²·24 hr; and
layer (III): a light-blocking colored layer.

5. A laminated sheet for a solar cell obtained by laminating and integrating the following layer (IV) and the following layer (V), the following layer (V) showing a dimensional change ratio of 3% or less when heat-treated in a dry air stream at 150°C for 30 minutes:
(IV) a encapsulating resin layer; and
(V) a base material layer having, on a surface contacting the layer (IV), a polyphenylene ether-based resin layer formed of a resin composition using a polyphenylene ether as a main component.

6. The sheet for a solar cell according to claim 2, wherein a thickness ratio of the polyphenylene ether-based resin layers with respect to an entire thickness exceeds 50%.

7. The sheet for a solar cell according to claim 1 or 2, comprising a phosphorus-based flame retardant.

8. A solar cell module obtained by providing the sheet for a solar cell according to claim 1 or 2.

9. The solar cell module according to claim 8, wherein the module is obtained by bonding one surface of the sheet for a solar cell to a encapsulating resin layer.

10. The solar cell module according to claim 9, wherein the encapsulating resin layer contains one of a polyolefin-based resin and an ethylene-vinyl acetate-based resin.

11. The solar cell module according to claim 9, wherein the encapsulating resin layer contains a radical generator.

12. The solar cell module according to claim 8, wherein the module is obtained by bonding a junction box to one surface of the sheet for a solar cell.

13. The sheet for a solar cell according to claim 3, wherein the layer (II) is selected from the following layers (a) to (e):
(a) a metal thin-film layer;
(b) an inorganic thin-film layer;
(c) a resin layer using a resin selected from a cyclic olefin, a high-density polyethylene, a polypropylene, a polyvinylidene chloride, a polytetrafluoroethylene, and a polychlorotrifluoroethylene as a main component;
(d) a resin layer containing flat inorganic particles; and
(e) a coating layer using a resin selected from a polyvinylidene chloride, a polyvinyl alcohol, an acrylic resin, and an epoxy-based resin as a main component.

14. A solar cell module obtained by providing the sheet for a solar cell according to claim 3.

15. The solar cell module according to claim 3, wherein the module is obtained by bonding the layer (I) to a encapsulating resin layer that constructs the solar cell module.

16. The solar cell module according to claim 15, wherein the encapsulating resin layer contains one of a polyolefin-based resin and an ethylene-vinyl acetate-based resin.

17. The solar cell module according to claim 15, wherein the encapsulating resin layer contains a radical generator.

18. The solar cell module according to claim 14, wherein the module is obtained by bonding a junction box to one surface of the sheet for a solar cell.

19. The sheet for a solar cell according to claim 4, wherein the layer (II) is selected from the following layers (a) to (e):
(a) a metal thin-film layer;
(b) an inorganic thin-film layer;
(c) a resin layer using a resin selected from a cyclic olefin, a high-density polyethylene, a polypropylene, a polyvinylidene chloride, a polytetrafluoroethylene, and a polychlorotrifluoroethylene as a main component;
(d) a resin layer containing flat inorganic particles; and
(e) a coating layer using a resin selected from a polyvinylidene chloride, a polyvinyl alcohol, an acrylic resin, and an epoxy-based resin as a main component.

20. The sheet for a solar cell according to claim 4, wherein the layer (III) is formed of a light-blocking white film or a light-blocking black film.

21. The sheet for a solar cell according to claim 4, wherein:
the layer (II) includes a weatherproof coat layer and an inorganic thin-film layer; and
the weatherproof coat layer is formed of at least one kind selected from (A) a crosslinked product of a polycaprolactone polyol and/or a polycarbonate polyol, (B) a crosslinked product of a denatured polyvinyl alcohol, and (C) an acrylic copolymer having at least one kind of group selected from the group consisting of a UV-stable group, a UV-absorbing group, and a cycloalkyl group.

22. A solar cell module obtained by providing the sheet for a solar cell according to claim 4.

23. The solar cell module according to claim 22, wherein the module is obtained by bonding a junction box to one surface of the sheet for a solar cell.

24. The laminated sheet for a solar cell according to claim 5, wherein the layer (IV) comprises a layer formed of a resin composition using a polyolefin-based resin or a denatured polyolefin-based resin as a main component.

25. The laminated sheet for a solar cell according to claim 5, wherein the laminated sheet is obtained by incorporating a radical generator or a silane coupling agent into the layer (IV).

26. The laminated sheet for a solar cell according to claim 5, wherein an interlayer peel strength between the layer (IV) and the layer (V) is 10 N/15 mm or more.

27. The laminated sheet for a solar cell according to claim 5, wherein the layer (V) shows a storage modulus (E') at a temperature of 20°C of 1, 000 MPa or more when subjected to dynamic viscoelasticity measurement under conditions of an oscillation frequency of 10 Hz, a strain of 0.1%, and a rate of temperature increase of 3°C/min.

28. The laminated sheet for a solar cell according to claim 5, wherein the layer (V) comprises a base material layer having the polyphenylene ether-based resin layer also on a surface opposite to the surface contacting the layer (IV).

29. The laminated sheet for a solar cell according to claim 5, wherein a ratio of a thickness of the polyphenylene ether-based resin layer in the layer (V) to an entire thickness of the layer (V) exceeds 50%.

30. A solar cell module obtained by using the laminated sheet for a solar cell according to claim 5.

31. The solar cell module according to claim 30, wherein the module is obtained by bonding a junction box to a surface opposite to the surface in the layer (V) contacting the layer (IV) in the laminated sheet for a solar cell.
